# EUROPÄISCHE PATENTSCHRIFT

(11) **EP 0 993 490 B1**
(45) Veröffentlichungstag und Bekanntmachung des Hinweises auf die Patenterteilung: **26.02.2003**
(21) Anmeldenummer: 98938669.3
(22) Anmeldetag: 29.06.1998
(51) Int. Cl.: C09B 67/20, C09D 11/00, G02F 1/1335, G03G 9/09

(54) **VERFAHREN ZUR HERSTELLUNG FEINER PIGMENTDISPERSIONEN**
METHOD FOR PRODUCING FINE PIGMENT DISPERSIONS
PROCEDE DE PREPARATION DE DISPERSIONS PIGMENTAIRES FINES

(30) Priorität: 30.06.1997 CH 157397; 16.12.1997 CH 289697
(43) Veröffentlichungstag der Anmeldung: 19.04.2000
(73) Patentinhaber: Ciba Specialty Chemicals Holding Inc., 4057 Basel (CH)
(72) Erfinder: SIEBER, Werner, CH-4125 Riehen (CH); HALL-GOULLE, Véronique, CH-4153 Reinach (CH)
(86) Internationale Anmeldenummer: EP9803948
(87) Internationale Veröffentlichungsnummer: WO99001511

(56) Entgegenhaltungen:
- EP-A- 0 648 770
- EP-A- 0 648 817
- EP-A- 0 654 711
- EP-A- 0 742 255
- US-A- 3 394 123

## Beschreibung

Die vorliegende Erfindung betrifft Pigmentdispersionen, ein Verfahren zu ihrer Herstellung sowie die nach diesem Verfahren erhältlichen Pigmentdispersionen und deren Verwendung zum Pigmentieren von hochmolekularem Material,

Neuere Pigmentanwendungen stellen hohe Anforderungen an koloristische und verarbeitungstechnische Eigenschaften der Pigmente. Die Pigmente sollten reine, farbstarke und brillante Farbtöne besitzen, die es ermöglichen einen grossen Farbraum zu eröffnen. Des weiteren sollten sie nicht nur als Einzelpigment, sondern auch als Kombinationselement in beispielsweise Trichromiepigmentierungen verwendet werden können. Anwendungstechnisch vorteilhaft erweist es sich, das Pigment als Dispersion zu applizieren, da aufwendige Misch- und Mahloperationen, die eine zusätzliche hygienische Belastung darstellen, vermieden werden können. Zudem ist mit Dispersionen eine bessere Reproduzierbarkeit des Pigmentierungsprozesses gegeben, da eine homogenere Verteilung der Pigmentpartikel als in der Pulverform vorliegt. Aus ökonomischen Gründen ist es besonders erwünscht, konzentrierte, stabile Dispersionen einzusetzen, die einen geringen Platzbedarf beim Transport oder der Lagerung benötigen und gleichzeitig eine gute Stabilität besitzen.

Es ist aus den US 4,597,794 und 5,085,698 bekannt, feine Pigmentdispersionen mit einer durchschnittlichen Partikelgrössenverteilung von 0,015-0,5 Mikrometer, die durch mechanische Zerkleinerungs- und anschliessende Selektionstechniken, wie Filtration oder Zentrifugierung, zur Entfernung von Grobpartikeln erhalten werden, unter Zusatz von stabilisierenden Copolymeren, herzustellen. Nachteilig bei diesen Verfahren ist der äusserst zeit- und energieaufwendige Mahlprozess, der bis zu mehreren Tagen dauern kann und hohe Reibungsenergie erfordert. Erhalten wird ein Mahlgut mit breiter Partikelgrössenverteilung, welches aufgrund der mechanischen Beanspruchung rauhe Oberflächen besitzt. Zu grosse Pigmentpartikel oder solche mit angerauhter Oberfläche führen zu einem Verlust an Transparenz. Andererseits neigen kleinere Partikel zur Bildung von Aggregaten, die beim Dispergierprozess nach bekannten Techniken, durch hohen Energieeintrag, zum Beispiel in Form von Ultraschall, gebrochen werden. Eine Folge der Aggregationsneigung kleinerer Partikel ist deren Ausflockungstendenz und damit eine inhärente Instabilität dieser Dispersionen.

Diese beschriebenen Nachteile können durch andere Techniken, wie Verdampfungsmethoden (siehe US 5,030,669 und 5,106,533) oder durch die Herstellung von feinen Dispersionen unter hohem Druck (WO 96/14925) nur teilweise behoben werden. Zudem müssen bei der Anwendung dieser Techniken spezielle Apparaturen verwendet werden. Das Problem, Pigmente mit sehr hoher Transparenz bereitzustellen, die insbesondere für die Herstellung von Tinten aus Pigmentdispersionen erfordertich sind, um die, den genauen Normen entsprechende, richtige Koloristik zu erreichen, ist immer noch nicht befriedigend gelöst.

Es sind Zusammensetzungen aus Polymeren und Latentpigmenten aus EP-A 654 711 bekannt sowie chemische, thermische oder photolytische Methoden, mit denen Pigmentteilchen nach bekannten Verfahren, in vorher strukturierten Schichten bestehend aus Polymeren und löslichen Pigmentvorläufern, generiert werden können. Im folgenden ist die Verwendung von Polymer gleichbedeutend mit Polymer und/oder Copolymer.

Die Aufgabe der vorliegenden Erfindung bestand deshalb darin, Pigmentdispersionen, die eine hohe Stabilität besitzen und eine gute Transparenz aufweisen sowie ein Verfahren zu deren Herstellung bereitzustellen.

Die vorliegende Erfindung betrifft demnach ein Verfahren zur Herstellung von Pigmentdispersionen aus einem Pigment, einem Polymer und einem Lösungsmittel, indem man
a1) eine Mischung A, enthaltend ein Latentpigment und ein Polymer, thermisch, chemisch oder photolytisch behandelt und
b) danach mit einem Lösungsmittel versetzt,
   oder
a2) eine Mischung B, enthaltend ein Latentpigment, ein Polymer und ein Lösungsmittel, thermisch, chemisch oder photolytisch behandelt.

In der Regel wählt man das Gewichtsverhältnis von Latentpigment zu Polymer der Mischungen A und B im Bereich 1:1 bis 1:20, vorzugsweise im Bereich von 1:1,5 bis 1:10 und besonders bevorzugt im Bereich von 1:1,5 bis 1:5.

Durch die thermische, chemische oder photolytische Behandlung, die in Analogie zu EP-A 654 711 oder EP-A-742255 durchgeführt werden kann, stellt man aus den löslichen Pigmentvorläufern, den Latentpigmenten, die Pigmente her.

Üblicherweise behandelt man die Mischung A oder B thermisch. In der Regel wird die Mischung im Temperaturbereich von 100 bis 200°C während einer Minute bis 36 Stunden, besonders bevorzugt im Temperaturbereich von 120 bis150°C während 10 Minuten bis 24 Stunden erhitzt.

In einer bevorzugten Ausführungsform des erfindungsgemässen Verfahrens führt man die thermische Behandlung unter Druck durch. In der Regel wählt man diesen im Bereich von 70 kPa bis 10 MPa, bevorzugt von 90 kPa bis 5 MPa, besonders bevorzugt ist Atmosphärendruck.

Die Mischungen A und B kann man in der Regel während einer Minute bis 36 Stunden, bevorzugt während 10 Minuten bis 24 Stunden nach allgemein bekannten Methoden des Vermischens herstellen wie durch Rühren, Kneten oder Verwirbeln.

In einer besonderen Ausführungsform des erfindungsgemässen Verfahrens wird das Mischen und die thermische Behandlung der Mischung A im Extruder durchgeführt. In Abhängigkeit vom eingesetzten Reaktanden, Latentpigment oder Polymer, kann es angebracht sein eine Vormischung, nach allgemein bekannten Methoden des Vermischens, vorzunehmen. Die Verfahrensschritte im Extruder können kontinuierlich oder batchweise durchgeführt werden. Im allgemeinen kann jede Art von Extruder verwendet werden wie zum Beispiel Zweischrauben-Extruder oder Knet-Extruder, besonders bevorzugt sind miteinander rotierende Zweischrauben-Extruder. Generell ist die Arbeitsweise mit einem Extruder bekannt und beispielsweise in "The Canadian Journal of Chemical Engineering", 71, June 1993 und US 3,637,545 beschrieben.

Deshalb betrifft eine weitere Ausführungsform des erfindungsgemässen Verfahrens die Herstellung im Extruder, indem man die Mischung A in einem Extruder thermisch behandelt.

Vorzugsweise sind die Mischungen A oder B homogene Mischungen. Besonders bevorzugt ist die Mischung B eine Lösung, und ganz besonders bevorzugt eine homogene Lösung, in der die Komponenten gleichmässig verteilt sind. Das Wort homogen schränkt hier auf "makroskopisch einheitlich" ein und ist in diesem Sinne der Bezeichnung heterogen entgegengesetzt ist; da homogen nicht gleichbedeutend ist mit "rein, unvermischt", können auch Gemische homogen sein wie beispielsweise Puder. Salzlösung, Wein, Milchschokolade (Römpp, 1997, S. 1795).

Gewünschtenfalls kann man die Mischung A herstellen, indem man das Latsntpigment und das Polymer mit einem Lösungsmittel mischt und anschliessend das Lösungsmittel nach allgemein bekannten Methoden entfernt. Insbesondere verwendet man Lösungsmittel, in denen das Latentpigment und/oder das Polymer, besonders bevorzugt Latentpigment und Polymer gelöst sind.

In der Regel werden die Lösungsmittel enthaltenden Mischungen A oder B aus Latentpigment und Polymer durch Rühren, bevorzugt intensives Rühren hergestellt.

In der Regel stellt man die Mischungen enthaltend Latentpigment, Polymer und Lösungsmittel her, indem man separat zwei Mischungen, je eine aus Latentpigment und Lösungsmittel und eine aus Polymer und Lösungsmittel herstellt, die man in der Regel miteinander während einer Minute bis zu 24 Stunden, bevorzugt während 10 Minuten bis 12 Stunden, mischt. Gewünschtenfalls kann man auch zuerst ein Latentpigment und Polymer mischen und diese Mischung anschliessend mit einem Lösungsmittel versehen.

In der vorliegenden Erfindung steht Lösungsmittel für nicht-wasserhaltige organische und/oder wasserhaltige Lösungsmittel, die organische Lösungsmittel enthalten können. und/oder Lösungsmittelgemische davon.

Üblicherweise wählt man als organische Lösungsmittel oder -gemische polare, aprotische Lösungsmittel wie beispielsweise Ether wie Dioxan, Dimethoxyethan oder Tetrahydrofuran sowie Ketone wie zum Beispiel Aceton, Methylethylketon, 2-Butanon, Cyclohexanon, Cyclopentanon, Methyl-Isobutylketon oder Diacetonalkohol, oder chlorierte Kohlenwasserstoffe wie zum Beispiel Chloroform, Trichlorethan, Chlorbenzol, des weiteren N,N'- Dimethylformamid oder Dimethylsulfoxid oder N-Methyl-2-pyrroiidon, 2-Pyrrolidon oder N,N'-Dimethylacetamid, ferner eignen sich als organische Lösungsmittel oder -gemische beispielsweise aliphatische C₁-C₄-Alkohole wie Methanol, Ethanol, 1- oder 2-Propanol, 1-oder 2-Isopropanol, n-Butanol, sek.-Butanol, tert.-Butanol, ferner Polycle, Cellosolve und Carbitole wie Ethylenglykol, Diethylenglykol, Triethylenglykol, Glycerin, Propylenglykol, Diacetonalkohole wie 4-Hydroxy-4-methyl-2-pentanon oder Etheralkoholen wie Bis-(2-hydroxyethyl)-ether, Bis-(2-hydroxyproplyl)-ether oder Bis-(2-hydroxybutyl)-ether. Ethylenglykolmonomethyl- oder monoethylether, Propylenglykolmethylether, Dipropylenglykolmethylether, Tripropylenglykolmethylether, Ethylenglykolphenylether, Ethylenglykolmethylether, Propylenglykotphenytether, Diethylenglykolmonomethyl- oder monoethylether, Diethylenglykolmonobutylether, Triethylenglykolmonomethyl- oder monoethylether, des weiteren besonders bevorzugt sind Dioxan oder Tetrahydrofuran sowie Lösungsmittelgemische von diesen.

Üblicherweise setzt man das Lösungsmittel in 50 bis 99,99 Gew.-%, bevorzugt 80 bis 99,99 Gew.-% bezogen auf das Gesamtgewicht an Latentpigment und Polymer ein.

Nach dem erfindungsgemässen Verfahren kann man die thermische Behandlung von Latentpigment und Polymer mit oder ohne Lösungsmittel durchführen. Gewünschtenfalls kann man die Mischung B aber auch aufkonzentrieren, bevorzugt bis zu 20 Gew.% der Gesamtmasse an Latentpigment und Polymer. Das Lösungsmittel wird üblicherweise durch allgemein bekannte Methoden wie Abdestillation entfernt, bevorzugt bei vermindertem Druck. Gewünschtenfalls kann man die Mischung A, die kein Lösungsmittel enthält, vor der thermischen Behandlung trocknen, bevorzugt im Temperaturbereich von 40 bis150°C während 1 Stunde bis 24 Stunden und besonders bevorzugt im Temperaturbereich von 40 bis 80°C während 1 Stunde bis 12 Stunden.

Die thermisch, chemisch oder photolytisch behandelte Mischung A wird nach der Behandlung mit einem nicht-wasserhaltigen organischen und/oder wasserhaltigem Lösungsmittel versehen.

Gewünschtenfalls kann man auch die thermisch, chemisch oder photolytisch behandelte Mischung B mit einem Lösungsmittel versetzen, oder einen Lösungsmittelwechsel vornehmen. Der Lösungsmittelwechsel kann nach allgemein bekannten Methoden wie durch Abdestillation des Lösungsmittels, Abdekantieren oder Filtrieren und anschliessender Zugabe des gewünschten Lösungsmittels erfolgen.

In der Regel mischt man das Lösungsmittel nach der thermischen, chemischen oder photolytischen Behandlung nach den üblichen Methoden des Vermischens, insbesondere durch Rühren der Komponenten.

In einer weiteren Ausgestaltung des erfindungsgemässen Verfahrens kann man auch direkt während der thermischen Behandlung aus der Mischung B, bevorzugt einer homogenen Mischung B und besonders bevorzugt einer Lösung, enthaltend Latentpigment, Polymer und Lösungsmittel eine Dispersion, enthaltend Pigment, Polymer und Lösungsmittel, herstellen.

In einer bevorzugten Ausführungsform des erfindungsgemässen Verfahrens stellt man feine Pigmentdispersion her, indem man eine Lösung von Latentpigment mit einer Lösung von Polymer mischt, das erhaltene Reaktionsgemisch durch Abdestillation der Lösungsmittel aufkonzentriert, besonders bevorzugt zur Trockene einengt, und aus dem erhaltenen Konzentrat durch thermische Behandlung eine Mischung enthaltend Pigment und Polymer herstellt, die man in wasserhaltigen und/oder nicht-wasserhaltigen organischen Lösungsmitteln dispergiert.

Die vorliegende Erfindung betrifft deshalb auch ein Verfahren zur Herstellung von Pigmentdispersionen aus einem Pigment, einem Polymer und einem Lösungsmittel, indem man
c1) eine Mischung, enthaltend ein Latentpigment, ein Polymer und einem Lösungsmittel herstellt,
c2) anschliessend aus der so erhaltenen Mischung das Lösungsmittel entfernt, und
c3) danach die lösungsmittelfreie Mischung A thermisch, chemisch oder photolytisch behandelt, und
c4) dann die behandelte Mischung mit einem Lösungsmittel versetzt.

Die vorliegende Erfindung betrifft in einer weiteren bevorzugten Ausführungsform ein Verfahren zur Herstellung von Pigmentdispersionen aus einem Pigment und einem Polymer, indem man
eine Lösung C, enthaltend ein Latentpigment, ein Polymer und ein Lösungsmittel, thermisch, chemisch oder photolytisch behandelt.

Zudem betrifft eine weitere bevorzugten Ausführungsform der vorliegenden Erfindung ein Verfahren zur Herstellung von Pigmentdispersionen aus einem Pigment, einem Polymer und einem Lösungsmittel, indem man
g1) eine Lösung C, enthaltend ein Latentpigment, ein Polymer und ein Lösungsmittel, und
g2) anschliessend aus der so erhaltenen Lösung das Lösungsmittel entfernt, und g3) danach die lösungsmittelfreie Mischung thermisch, chemisch oder photolytisch behandelt, und
g4) dann die behandelte Mischung mit einem Lösungsmittel versetzt.

In einer weiteren Ausgestaltung des erfindungsgemässen Verfahres stellt man Pigmentdispersionen aus einem Pigment, einem Polymer und einem Lösungsmittel her, indem man
d1) eine Mischung B, enthaltend ein Latentpigment, ein Polymer und ein Lösungsmittel herstellt, und
d2) anschliessend aus der so erhaltenen Mischung das Lösungsmittel teilweise entfernt, und
d3) danach die so erhaltene Mischung thermisch, chemisch oder photolytisch behandelt.

Mit dem erfindungsgemässen Verfahren kann man nicht-wasserhaltige und wasserhaltige Pigmentdispersionen herstellen.

Deshalb betrifft die vorliegende Erfindung in einer weiteren bevorzugten Ausführungsform des erfindungsgemässen Verfahrens die Herstellung von nicht-wasserhaltigen Dispersionen, indem man
e1) eine Mischung A, enthaltend ein Latentpigment und ein Polymer, thermisch, chemisch oder photolytisch behandelt und
e2) danach mit einem nicht-wasserhaltigen Lösungsmittel versetzt, oder
e3) eine Mischung B, enthaltend ein Latentpigment, ein Polymer und ein nicht-wasserhaltiges Lösungsmittel, thermisch, chemisch oder photolytisch behandelt.

Nicht-wasserhaltige Lösungsmittel stehen für organische Lösungsmittel.

Ferner betrifft die vorliegende Erfindung in einer weiteren bevorzugten Ausführungsform des erfindungsgemässen Verfahrens auch die Herstellung von wasserhaltigen Pigmentdispersionen, indem man
f1) eine Mischung A, enthaltend ein Latentpigment und ein Polymer, thermisch, chemisch oder photolytisch behandelt und
f2) danach mit einem wasserhaltigen Lösungsmittel versetzt,
   oder
f3) eine Mischung B, enthaltend ein Latentpigment, ein Polymer und ein wasserhaltiges Lösungsmittel, thermisch, chemisch oder photolytisch behandelt.

Wasserhaltige Lösungsmittel stehen für Wasser, das zusätzlich organische Lösungsmittel und/oder Basen enthalten kann.

Zur Herstellung wasserhaltiger Pigmentdispersionen mischt man die thermisch, chemisch oder photolytisch behandelte Mischung mit einer wasserhaltigen Lösung, bevorzugt einer wasserhaltigen Lösung enthaltend eine Base.

Gewünschtenfalls kann man die thermisch, chemisch oder photolytisch behandelte Mischung, vor dem Mischen mit einer wasserhaltigen Lösung, mit einem mit Wasser mischbarem organischen Lösungsmittel wie beispielsweise Dioxan oder Tetrahydrofuran vermischen, welches vorzugsweise das Polymer löst.

Im allgemeinen stellt man die wasserhaltigen Pigmentdispersionen auf einen pH ≥7, besonders bevorzugt auf einen pH ≥8 ein. Die Einstellung des pH-Wertes kann man durch Mischen der wasserhaltigen Mischung, enthaltend Pigment, Polymer und Wasser mit einer Base, oder durch Mischen der thermisch, chemisch oder photolytisch behandelten Mischung mit einer wasserhaltigen Lösung, enthaltend eine Base durchführen.

Die in den wasserhaltigen Lösungen enthaltenden Basen sind organische oder anorganische Basen.

Als organische Basen setzt man bevorzugt Hydroxide von organischen Kationen wie Trimethyl- oder Triethylammonium oder Amine wie Mono-, Di- oder Tri-Methylamin, Mono-, Di- oder Tri-Ethylamin oder um
Mono-, Di- oder Tri-Ethanolamin, Mono-, Di- oder Tri-Propanolamin, N,N'-Dimethylaminoethanol, N,N'-Methylethanolamin sowie Morpholin, N-Methylmorpholin, Piperidin oder Pyrrolidin ein. Als anorganischen Basen setzt man bevorzugt Lithium-, Kalium- oder Natriumhydroxid ein. Besonders bevorzugt sind Dimethylaminoethanol oder Morpholin.

In einer weiteren bevorzugten Ausführungsform des erfindungsgemässen Verfahrens stellt man eine wasserhaltige Pigmentdispersion her, indem man
a) die thermisch, chemisch oder photolytisch behandelte Mischung mit einem organischen Lösungsmittel, insbesondere mit einem mit Wasser mischbaren organischen Lösungsmittel, mischt und
b) anschliessend durch Zusatz einer wasserhaltigen Lösung, enthaltend eine Base, insbesondere eine organische Base, den pH-Wert auf ≥ 7 einstellt.

In einer bevorzugten Ausführungsform des erfindungsgemässen Verfahrens zur Herstellung von wasserhaltigen Pigmentdispersionen wird das organische Lösungsmittel entfernt. Im allgemeinen erfolgt die Lösungsmittelentfernung durch Abdestillation, die bevorzugt unter reduziertem Druck vorgenommen wird.

Gegebenenfalls können die erfindungsgemässen Pigmentdispersionen einen Restanteil von Latentpigment bezogen auf Pigment von maximal 10 Gew.-% besitzen, bevorzugt allerdings von weniger als 5 Gew.-% und ganz besonders bevorzugt von weniger als 1 Gew.-% besitzen.

Die erfindungsgemässen Pigmentdispersionen besitzen eine Pigmentkonzentration im Bereich von 0,01 bis 10 Gew.-%, bevorzugt von 0,1 bis 5 Gew.-% bezogen auf das Gesamtgewicht der Pigmentdispersion.

Die nach dem erfindungsgemässen Verfahren hergestellten feinen Pigmentdispersionen besitzen vorzugsweise eine durchschnittliche Partikelgrössenverteilung von 0,015-0,5 Mikrometer, besonders bevorzugt von 0,03-0,3 Mikrometer und ganz besonders bevorzugt von 0,05-0,2 Mikrometer. Die Partikelgrössenverteilung wurde mit der Methode der Scheibenzentrifugierung nach Joyce-Loebl bestimmt.

Gewünschtenfalls kann die erfindungsgemässe Dispersion zusätzlich noch Additive, wie oberflächenaktive Verbindungen, die eine bevorzugte räumliche Orientierung in Lösungsmitteln besitzen, enthalten. Beispielsweise handelt es sich bei den wasserhaltigen Pigmentdispersionen um grosse Moleküle, die aus einem hydrophilen Kopf und einem hydrophoben Schwanz bestehen, wie zum Beispiel Fluorad FC-170, einem nicht-ionischen Fluor-haltigen Tensid, von 3 M Inc. (oder wie OLOA™ 1200 von Chevron Corp., Richfield, CA, Amoco™ 9250, von Amoco Chemical Co., Naperville, IL). Die erhaltenen Dispersionen besitzen vorzugsweise ≤20 Gew.-%, besonders bevorzugt aus ≤10 Gew.-% und ganz besonders bevorzugt ≤5 Gew.-% Additive und können gewünschtenfalls noch weitere Cosolventien enthalten, wie zum Beispiel Cyclohexanon, Cyclopentanon, N.N'-Dimethylformamid oder Dimethylsulfoxid.

Als Polymere für wasserhaltige Pigmentdispersionen werden vorzugsweise Polymere bestehend aus einem hydrophilen und hydrophoben Teil verwendet. Ersterer Teil kann ionisierbar sein und Salze bilden oder nicht-ionisierbar sein.

Vorzugsweise handelt es sich bei den Polymeren um Random-, Block-, oder Pfropl-Polymere.

Der hydrophile Teil der Polymere setzt sich bevorzugt beispielsweise aus Monomeren zusammen, die neben funktionellen Gruppen wie zum Beispiel, Alkohol-, Carbonsäure-, Carbonsäureamid-, Carbonsäureester- oder Sulfonsäuregruppen, Sulfat-, Cyanat- oder Carbonsäureanhydrid-, oder Ethergruppen wie Ethylen- oder Propylenoxidgruppen und zusätzlich einen polymerisierbaren vinyl- oder Vinylenrest wie einen Acryl-, oder Methylacryl-, Crotyl-, Sulfoethylmethylacryl-, Sulfopropylmethylacryl-, Vinylnaphthyl-, Vinylphenyl-, Vinyltolylrest sowie einen Itaconylrest wie zum Beispiel Itaconylmonoester, Maleinsäure oder einen Maleinylrest wie zum Beispiel Maleinsäuremonoester, einen Fumarylrest wie zum Beispiel, Fumarylmonoester und insbesondere Vinylbenzoesäure enthalten. Bei den Monoestern handelt es sich vorzugsweise um Monoester von itaconyl-, Malein- oder Fumarsäure.

Bevorzugt sind Monomere, die als funktionelle Gruppen Carboxyl-, Carbonsäureanhydrid-, Sulfonat-, oder Sulfatgruppen besitzen. Besonders bevorzugt sind Carboxyl-, oder Carbonsäureanhydridgruppen wie Vinylbenzoesäure oder Maleinsäureanhydrid.

Monomere, die den hydrophoben Teil der Polymere bilden, werden vorzugsweise ausgewählt aus der Gruppe der unpolaren Monomere bestehend aus Styrol, Styrolderivaten, wie C₁-C₄ Alkyl substituiertes Styrol, und Vinylchlorid, Vinylnaphthalin, Vinylnaphthalinderivaten wie C₁-C₄ Alkyl substituiertes Vinylnaphthalin, Vinyltoluol, α, m, p oder m, p Vinyltoluol und aliphatischen, C₁₂-C₁₈Alkenen.

Bevorzugt verwendet man als hydrophobe unpolare Monomere beispielsweise Styrol, Vinyltoluol und Octadecen.

Bevorzugt wählt man Copolymere mit einer engen Molmassenverteilung im bereich von 1-2 Mw/Mn (,worin Mw Massenmittelwert und Mn Zahlmittelwert bedeutet).

Die Molmasse (Zahlmittelwert) der Copolymere ist vorzugsweise < 100000 g/mol.

Copolymere, die beispielsweise aus Styrol-, Vinyltoluol- und Vinylbenzoesäure-Monomeren bestehen, besitzen vorzugsweise eine Molmasse von 10000-30000 g/mol, besonders bevorzugt von 15000-20000 g/mol und ganz besonders bevorzugt von 10000-15000 g/mol.

Eine weitere bevorzugte Ausführungsform der Erfindung betrifft Copolymere, die beispielsweise aus Styrol-, und Maleinsäureanhydrid-Monomeren hergestellt sind, besitzen vorzugsweise eine Molmasse von 500-5000 g/mol, besonders bevorzugt von 1000-3000 g/mol und ganz besonders bevorzugt von 500-1500 g/mol.

Für nicht-wasserhaltige Pigmentdispersionen werden üblicherweise Acrylat-, Methacrylat-, Styrol- und Vinylpolymere verwendet.

Besonders bevorzugte Ausführungsform der verwendet man für ethanolische Pigmentdispersionen Polyvinylbutyrat und für Dispersionen mit Methylethylketon als Lösungsmittel Methylmethacrylat oder für Pigmentdispersion mit Chloroform als Lösungsmittel Copolymere aus Methylmethacrylat und Butylacrylat.

Bevorzugte Polymere für wasserhaltige Pigmentdispersion setzen sich beispielsweise aus Carooxylgruppen-haltigen Polymeren zusammen wie beispielsweise Styrol, Vinyltoluol und Vinylbenzoesäure oder Vinylbenzoesäure und unpolaren Monomeren sowie aus Styrol und Maleinsäureanhydrid oder aus Copolymeren von langkettigen Alkenen (C₁₂-C₁₈) mit Maleinsäureanhydrid wie zum Beispiel Styrol-Maleinsäureanhydrid, Styrol-vinyltoluclvinylbenzoesäure oder Octadecen-Maleinsäureanhydrid zusammen.

Eine bevorzugte Ausführungsform des erfindungsgemässen Verfahrens betrifft die Herstellung wasserhaltiger basischer Pigmentdispersionen aus einem Latentpigment mit einer Lösung aus einem Copolymeren enthaltend Vinylbenzoesäure und einem nicht-polaren Monomer oder mit einer Lösung enthaltend ein Carboxylgruppen-haltiges Polymer.

Die Polymere für wasserhaltige oder nicht-wasserhaltige Pigmentdispersionen sind käuflich, wie beispielsweise bei der Firma, Scientific Polymer Products Inc., oder können nach bekannten Methoden, wie zum Beispiel in US 4,597,794 oder 4,508,880 beschrieben, oder wie beispielsweise für die Herstellung von Carboxylgruppen-haltigen Copolymeren in Beispiel 1 angegeben, durch radikalische Polymerisation der Monomeren, in Gegenwart eines Radikalstarters wie zum Beispiel 4,4'-Azobis(4-cyanpentansäure) und einem Radikalüberträger wie beispielsweise Dodecylmercaptan, hergestellt werden.
Die Monomeren und Polymerisations- oder Copolymerisationshilfsmittel, wie Radikalstarter oder Radikalüberträger sowie Lösungsmittel sind käufliche Produkte und zum Beispiel bei der Firma Fluka erhältlich.

Unter Latentpigmenten versteht man lösliche Pigmentvoriäufe wie sie beispielsweise in den US 5,616,725 und 5,561,232 beschrieben sind.

Bevorzugt sind Latentpigmente der Formel I

A(B)ₓ, (I),

worin
x eine Zahl von 1 bis 8 bedeutet, und
A für den Rest eines Chromophors der Anthrachinon-, Azo-, Benzimidazolon-,
Chinacridon-, Chinophthalon-, Diketopyrrolopyrrol-, Dioxazin-, Indanthron-, Indigo-, Isoindolin-, Isoindolinon-, Perylen-, und Phthalocyaninreihe steht, der über ein Heteroatom oder mehrere Heteroatome mit x Gruppen 8 verbunden ist, wobei diese Heteroatome aus der Gruppe bestehend aus N, O oder S ausgewählt sind und einem Teil des Restes A bilden.
und
B für einen Rest, ausgewählt aus der Gruppe bestehend aus den Formeln II-V 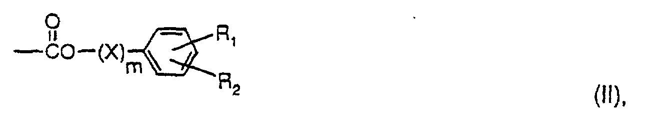 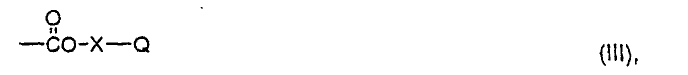 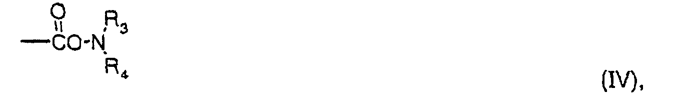 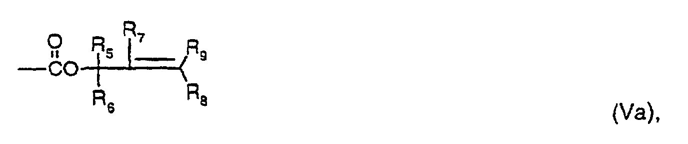 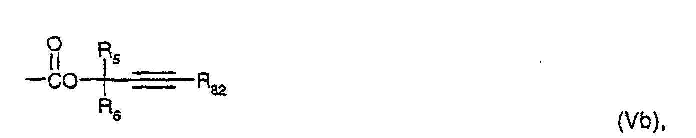 und Wasserstoff, wobei mindestens ein Rest B nicht für Wasserstoff steht,
wobei in den Formeln II, III, IV oder Va oder Vb
- m: Null oder 1 bedeutet,
- X: unsubstituiertes oder einfach oder mehrfach durch C₁-C₆-Alkyl oder R₅ und R₆ substituiertes C₁-C₆-Alkylen oder C₂-C₅-Alkenylen ist,
oder
- R₁ und R₂: unabhängig voneinander Wasserstoff, C₁-C₆-Alkyl, C₁-C₆-Alkoxy, Halogen, Cyano, Nitro, N(C₁-C₆-Alkyl)₂, unsubstituiertes oder durch Halogen, Cyano, Nitro, C₁-C₆-Alkyl oder C₁-C₆- Alkoxy substituiertes Phenyl bedeuten, und
- Q: Wasserstoff, C₁-C₆-Alkyl, CN, CCl₃, eine Gruppe 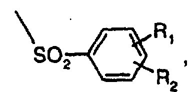 SO₂CH₃ oder SCH₃, und
- R₃ und R₄: unabhängig voneinander Wasserstoff, C₁-C₄-Alkyl oder eine Gruppe 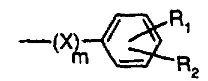 bedeuten,
oder R₃ und R₄ zusammen einen Piperidinylrest bilden, und
- R₅ und R₆: unabhängig voneinander Wasserstoff, C₁-C₂₄-Alkyl, durch O, S oder, mit C₁-C₆-Alkyl disubstituiertes, N unterbrochenes C₁-C₂₄-Alkyl, C₃-C₂₄-Alkenyl, C₃-C₂₄-Alkinyl, C₄-C₁₂-Cycloalkyl, C₄-C₁₂-Cycloalkenyl, unsubstituiertes oder durch C₁-C₆-Alkyl, C₁-C₆-Alkoxy, Halogen, Cyano oder Nitro substituiertes Phenyl oder Biphenyl bedeuten,
- R₇, R₈ und R₉: unabhängig voneinander Wasserstoff, C₁-C₂₄-Alkyl oder C₃-C₂₄Alkenyl sind,
- R₈₂: Wasserstoff, C₁-C₆-Alkyl oder eine Gruppe der Formel 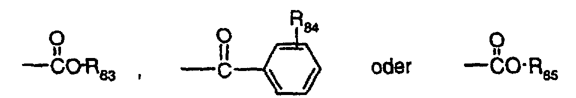 bedeutet,
- R₈₃: C₁-C₆-Alkyl,
- R₈₄: Wasserstoff oder C₁-C₆-Alkyl und
- R₈₅: Wasserstoff, C₁-C₆-Alkyl, unsubstituiertes oder durch C₁-C₆-Alkyl substituiertes Phenyl bedeuten, oder
B eine Gruppe der Formel 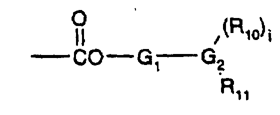 ist,
worin
- G₁: unsubstituiertes oder einfach oder mehrfach mit C₁-C₁₂Alkyl, C₁-C₁₂Alkoxy, C₁-C₁₂Alkylthio oder C₂-C₂₄Dialkylamino substituiertes p, q-C₂-C₁₂Alkylen ist, wobei p und q unterschiedliche Positionszahlen sind,
- G₂: für ein Heteroatom ausgewählt aus der Gruppe bestehend aus N, O oder S, steht, und
worin,
i, wenn G₂ gleich O oder S ist, die Zahl 0 und, wenn G₂ gleich N ist, die Zahl 1 bedeutet, und
- R₁₀ und R₁₁: unabhängig voneinander unsubstituiertes oder einfach oder mehrfach mit C₁-C₁₂Alkoxy, C₁-C₁₂Alkylthio, C₂-C₂₄Dialkylamino, C₆-C₁₂Aryloxy, C₆-C₁₂Arylthio, C₇-C₂₄ Alkylarylamino oder C₁₂-C₂₄ Diarylamino substituiertes C₁-C₁₂Alkyl oder [-(p',q'-C₂-C₁₂Alkylen)-R₁₂-]ᵢᵢ-C₁-C₁₂Alkyl sind,
worin
- ii: eine Zahl von 1 bis 1000 ist, p' und q' unterschiedliche Positionszahlen sind,
- R₁₂: unabhängig von den anderen ein Heteroatom O, S oder C₁-C₁₂Alkyl substituiertes N bedeutet, und C₂-C₁₂Alkylen in den sich wiederholenden Einheiten [C₂-C₁₂Alkylen-R₁₂] gleich oder verschieden sein kann, und
- R₁₀ und R₁₁: gesättigt oder 1-bis 10-mal ungesättigt sind, ununterbrochen oder an beliebigen Stellen durch 1 bis 10 Gruppen, ausgewählt aus der Gruppe bestehend aus -(C=O)- und -C₆H₄-, unterbrochen sind, und keine oder 1 bis 10 weitere Substituenten wie Halogen, Cyano oder Nitro tragen können, mit der Massgabe, dass, wenn -G₁-gleich -(CH₂)ᵢᵥ- ist, worin
- iv: eine Zahl von 2 bis 12 bedeutet, und G₂ gleich S ist, R₁₁ nicht unsubstituiertes, gesättigtes und ununterbrochenes C₁-C₄Alkyl ist.
Alkyl oder Alkylen kann geradkettig, verzweigt, monozyklisch oder polyzyklisch sein.

Bedeuten etwaige Substituenten C₁-C₄-Alkylen, so handelt es sich um ein geradkettiges oder verzweigtes Alkylen wie zum Beispiel Methylen, Dimethylen, Trimethylen, 1-Methyl-methylen, 1,1-Dimethyl-methylen, 1,1-Dimethyl-dimethylen, 1-Ethyl-dimethylen, 1-Ethyl-1-methyl-dimethylen oder Tetramethylen.

Bedeutet X C₁-C₆-Alkylen so handelt es sich um ein geradkettiges oder verzweigtes Alkylen wie zum Beispiel um Methylen, Dimethylen, Trimethylen, 1-Methyl-methylen, 1,1-Dimethyl-methylen, 1-Ethyl-dimethylen, 1-Ethyl-1-methyldimethylen, Tetramethylen, 1,1-Dimethyl-ethylen, 1,1-Dimethyl-propylen, 2,2-Dimethyl-propylen, 1-Ethyl-propylen, 2-Ethyl-propylen, 2-Methylbutylen, Pentamethylen, Hexamethylen, 2,2-Dimethyl-butylen, 3,3-Dimethyl-butylen, 2,2-Dimethyl-butylen, oder 1-Ethyl-butylen, 2-Ethyl-butylen.

X als C₂-C₅-Alkenylen bedeutet geradkettiges oder verzweigtes Alkenylen wie zum Beispiel Vinyl, Allyl, Methallyl, 1-Methyl-2-butenyl oder 2-Butenyl.

Bedeuten etwaige Substituenten p,q-C₂-C₄-Alkylen, so handelt es sich zum Beispiel um 1,2-Ethylen, 1,2-Propylen, 1,3-Propylen, 1,2-Butylen, 1.3-Butylen. 2,3-Butylen, 1,4-Butylen oder 2-Methyl-1,2-propylen.

Bedeuten etwaige Substituenten p,q-C₅-C₁₂-Alkenylen, so handelt es sich zum Beispiel um ein Isomer von Pentylen, Hexylen, Octylen, Decylen oder Dodecylen.

Bedeuten etwaige Substituenten C₁-C₄-Alkyl, so handelt es sich z.B. um Methyl, Ethyl, n-Propyl, Isopropyl, n-Butyl, sec.-Butyl oder tert.-Butyl, Cyclobutyl. C₁-C₆-Alkyl kann zusätzlich n-Pentyl, 2-Pentyl, 3-Pentyl, 2,2-Dimethylpropyl, Cyclopentyl, Cyclohexyl, n-Hexyl oder Dimethylbutyl, und darüber hinaus bedeutet C₁-C₁₂-Alkyl beispielsweise n-Octyl, 1,1,3,3-Tetramethylbutyl, 2-Ethylhexyl, Nonyl, Trimethylcyclohexyl, Decyl, Menthyl, Thujyl, Bornyl, 1-Adamantyl, 2-Adamantyl oder Dodecyl, und C₁-C₂₄-Alkyl, des weiteren Tetradecyl, Hexadecyl, Octadecyl, Eicosyl, Heneicosyl, Docosyl oder Tetracosyl bedeuten.

Falls C₂-C₁₂-Alkyl ein- oder mehrfach ungesättigt ist, handelt es sich um C₂-C₁₂-Alkenyl, C₂-C₁₂-Alkinyl, C₂-C₁₂-Alkapolyenyl oder C₂-C₁₂-Alkapolyvinyl, worin zwei oder mehr Doppelbindungen gegebenenfalls isoliert oder konjugiert sein können wie zum Beispiel Vinyl, Allyl, 2-Propen-2-yl, 2-Buten-1-yl, 3-Buten-1-yl, 1,3-Butadien-2-yl, 2-Cyclobuten-1-yl, 2-Penten-1-yl, 3-Penten-1-yl, 2-Methyl-1-buten-3-yl, 2-Methyl-3-buten-2-yl, 3-Methyl-2-buten-1-yl, 1,4-Pentadien-3-yl, 2-Cyclopenten-1-yl, 2-Cyclohexen-1-yl, 3-Cyclohexen-1-yl, 2,4-Cyclohexadienen-1-yl, 1-p-Menthen-8-yl, 4(10)-Thujen-10-yl, 2-Norbornen-1-yl, 2,5-Norbornadien-1-yl, 7,7-Dimethyl-2,4-norcaradien-3-yl oder die verschiedenen Isomeren von Hexenyl, Octenyl, Nonenly, Decenyl oder Dodecenyl.

C₃-C₂₄-Alkenyl ist C₃-C₂₄-Alkyl, welches ein- oder mehrfach ungesättigt ist, wobei zwei oder mehr Doppelbindungen gegebenenfalls isoliert oder konjugiert sein können, zum Beispiel Allyl, 2-Propen-2-yl, 2-Buten-1-yl, 3-Buten-1-yl, 1,3-Butadien-2-yl, 2-Penten-1-yl, 3-Penten-2-yl, 2-Methyl-1-buten-3-yl, 2-Methyl-3-buten-2-yl, 3-Methyl-2-buten-1-yl, 1,4-Pentadien-3-yl, oder die verschiedenen Isomeren von Hexenyl, Octenyl, Nonenyl, Decenyl, Dodecenyl, Tetradecenyl, Hexadecenyl, Octadecenyl, Eicosenyl, Heneicosenyl, Docosenyl, Tetracosenyl, Hexadienyl, Octadienyl, Nonadienyl, Decadienyl, Dodecadienyl, Tetradecadienyl, Hexadecadienyl, Octadecadienyl, Eicosadienyl, Heneicosadienyl, Docosadienyl oder Tetracosadienyl.

C₁₂-C₁₈Alkenen bedeutet beispielsweise Do-, Tri-, Tetra-, Penta-, Hexa-, Hepta- oder Octadecen.

C₄-C₁₂-Cycloalkyl ist zum Beispiel ein monozyklisches Cycloalkyl wie beispielsweise Cyclobutyl, Cyclopentyl, Cyclohexyl, Trimethylcyclohexyl oder Menthyl, oder ein polyzyklisches Cycloalkyl, wie beispielsweise Thujyl, Bornyl, 1-Adamantyl oder 2-Adamantyl.

C₄-C₁₂-Cycloalkenyl ist C₄-C₁₂-Cycloalkyl, welches ein- oder mehrfach ungesättigt ist, wobei zwei oder mehr Doppelbindungen gegebenenfalls isoliert oder konjugiert sein können, zum Beispiel 2-Cyclobuten-1-yl, 2-Cyclopenten-1-yl, 2-Cyclohexen-1-yl, 3-Cyclohexen-1-yl, 2,4-Cyclohexadien-1-yl, 1-*p*-Menthen-8-yl, 4(10)-Thujen-10-yl, 2-Norbornen-1-yl, 2,5-Norbornadien-1-yl oder 7,7-Dimethyl-2,4-norcaradien-3-yl.

C₃-C₂₄-Alkinyl ist C₃-C₂₄-Alkyl oder C₃-C₂₄-Alkenyl, welches ein- oder mehrfach doppelt ungesättigt ist, wobei die Dreifachbindungen gegebenenfalls isoliert oder unter sich oder mit Doppelbindungen konjugiert sein können, zum Beispiel 1-Propin-3-yl, 1-Butin-4-yl, 1-Pentin-5-yl, 2-Methyl-3-butin-2-yl, 1,4-Pentadiin-3-yl, 1,3-Pentadiin-5-yl, 1-Hexin-6-yl, cis-3-Methyl-2-penten-4-in-1-yl, trans-3-Methyl-2-penten-4-in-1-yl, 1,3-Hexadiin-5-yl, 1-Octin-8-yl, 1-Nonin-9-yl, 1-Decin-10-yl oder 1-Tetracosin-24-yl.

C₁-C₆-Alkoxy bedeutet zum Beispiel Methoxy, Ethoxy, n-Propoxy, Isopropoxy, n-Butoxy, tert.-Butoxy, n-Amyloxy, tert.-Amyloxy oder n-Hexyloxy.

C₁-C₁₂-Alkoxy ist -O-C₁-C₁₂-Alkyl, bevorzugt -O-C₁-C₄-Alkyl,

C₆-C₁₂-Aryloxy ist -O-C₆-C₁₂-Aryl, beispielsweise Phenoxy oder Naphthoxy, bevorzugt Phenoxy.

C₁-C₁₂-Alkylthio ist -S-₁-C₁₂-Alkyl, insbesondere -S-₁-C₄-Alkyl.

C₆-C₁₂-Arylthio ist -O-C₆-C₁₂-Aryl, beispielsweise Phenylthio oder Naphthylthio, bevorzugt Phenylthio.

C₂-C₂₄-Dialkylamino ist N(Alkyl₁)(Alkyl₂), wobei die Summe der Kohlenstoffatome in den beiden Gruppen Alkyl₁ und Alkyl₂ von 2 bis 24 beträgt, bevorzugt N(C₁-C₄Alkyl)-C₁-C₄Alkyl.

C₇-C₂₄-Alkylarylamino ist N(Alkyl₁)(Aryl₂), wobei die Summe der Kohlenstoffatome in den beiden Gruppen Alkyl₁ und Aryl₂ von 7 bis 24 beträgt, beispielsweise Methylphenylamino, Ethylnaphthylamino oder Butylphenanthrylamino, bevorzugt Methylphenylamino oder Ethylphenylamino.

C₁₂-C₂₄-Diarylamino ist N(Aryl₁)(Aryl₂), wobei die Summe der Kohlenstoffatome in den beiden Gruppen Aryl₁ und Aryl₂ von 12 bis 24 beträgt, beispielsweise Diphenylamino oder Phenylnaphthylamino, bevorzugt Diphenylamino.

Halogen bedeutet zum Beispiel Fluor, Chlor, Brom, Jod. Bevorzugt bedeutet Halogen Chlor.

Von besonderem Interesse sind Latentpigmente der Formel (I), worin x eine Zahl von 1 bis 8 bedeutet, und B eine Gruppe der Formeln 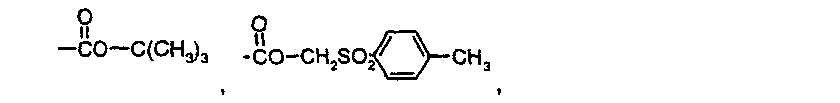 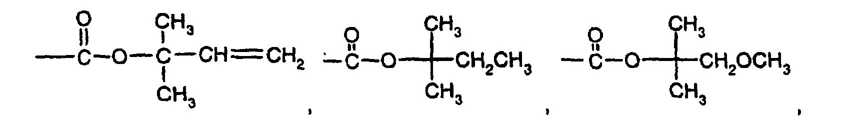 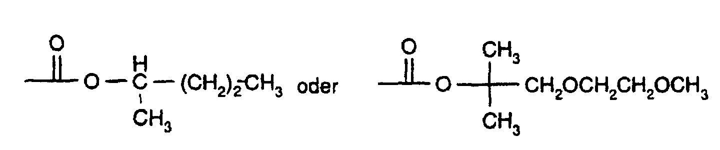 ist.

Bevorzugte Latentpigmente sind Verbindungen der Formel (I), wie Perylencarbonsäureimide der Formeln Vla oder Vlb 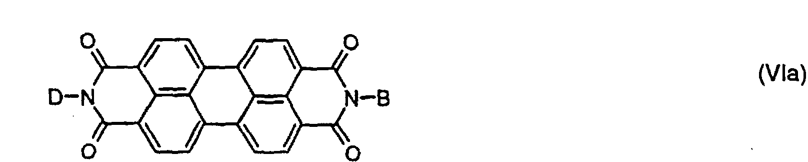 oder 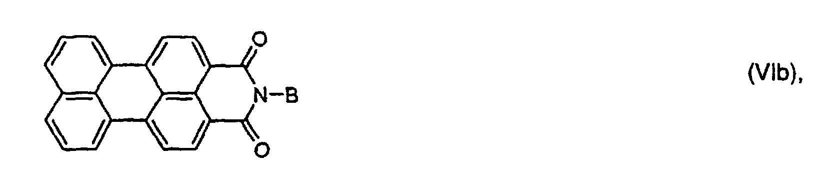 worin D Wasserstoff, C₁-C₆-Alkyl, unsubstituiertes oder durch Halogen oder C₁-C₆-Alkyl substituiertes Phenyl, Benzyl oder Phenethyl oder B bedeutet,

Chinacridone der Formeln VII oder Vlla 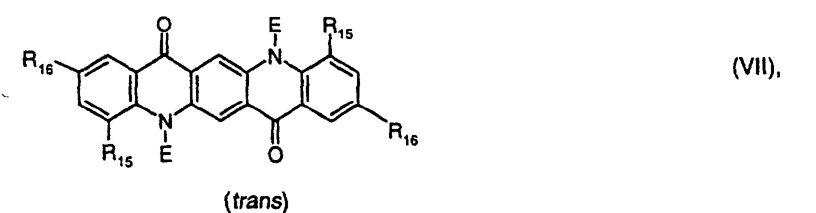 worin R₁₅ und R₁₆ unabhängig voneinander Wasserstoff, Halogen, C₁-C₂₄-Alkyl, C₁-C₆-Alkoxy oder Phenyl ist, oder 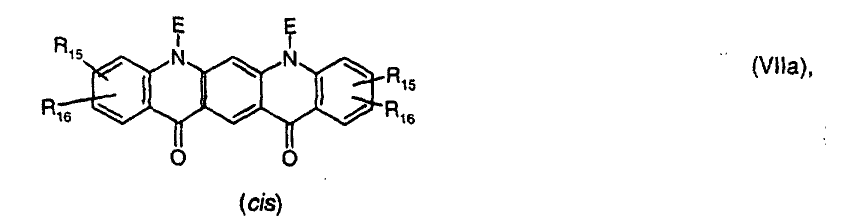 Dihydrochinacridon der Formel VIIb 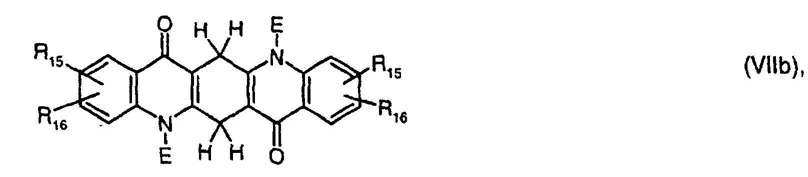 oder
Chinacridonchinon der Formel VIIc 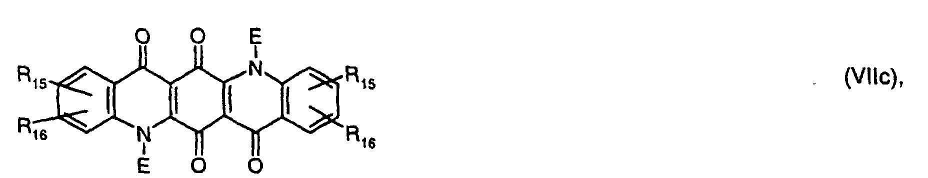 oder Latentpigmente polycyclischer Chromophore bekannter Grundstruktur der Formeln VIId, Vlle oder VIIf 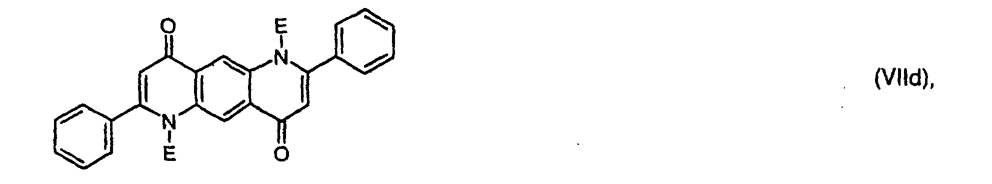 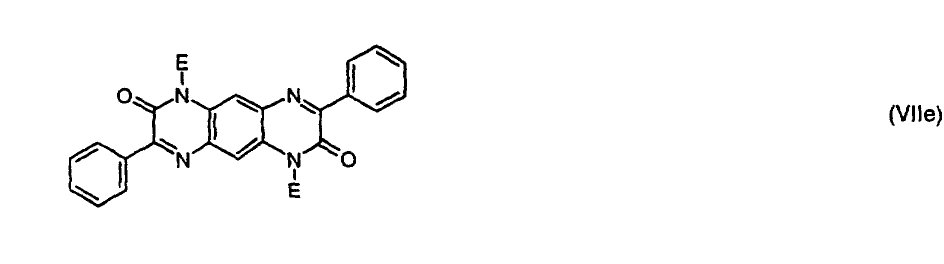 oder 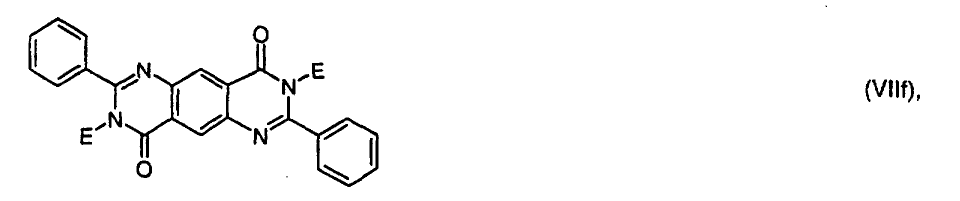 Chinophthalone der Formeln XL oder XLI 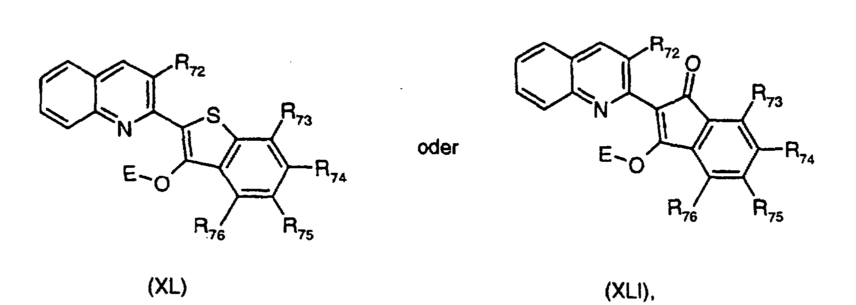 worin R₇₂ für Wasserstoff oder O-E steht,
R₇₃ bis R₇₆ unabhängig voneinander Wasserstoff, Halogen, -COO-C₁-C₅- Alkyl oder -CONE-C₁-C₆- Alkyl bedeuten,

Dioxazine der Formeln VIII oder IX 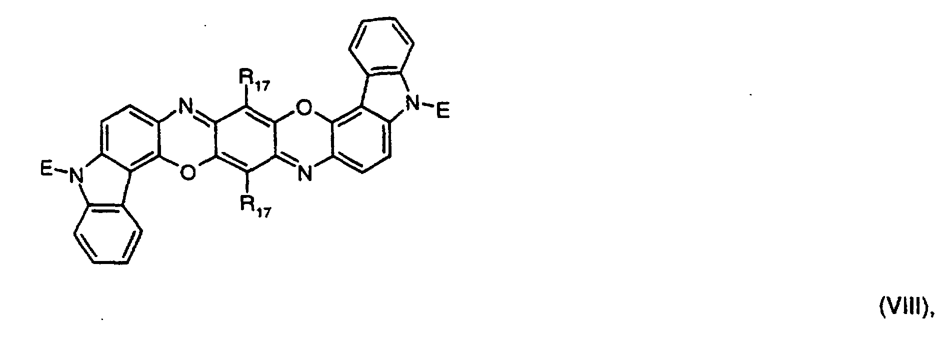 worin R₁₇ Wasserstoff, Halogen oder C₁-C₂₄-Alkyl ist, oder 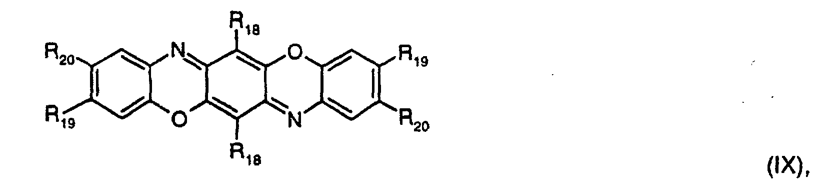 worin R₁₈, R₁₉ und R₂₀ unabhängig voneinander Wasserstoff, Halogen, C₁-C₄-Alkyl, C₁-C₄-Alkoxy, NECOC₁-C₄-Alkyl, NECOPhenyl oder NH-E sind, wobei mindestens einer der Reste R₁₈, R₁₉ oder
R₂₀ NECOC₁-C₄-Alkyl, NECOPhenyl oder NH-E sind,

Isoindoline der Formeln X, XI oder XII 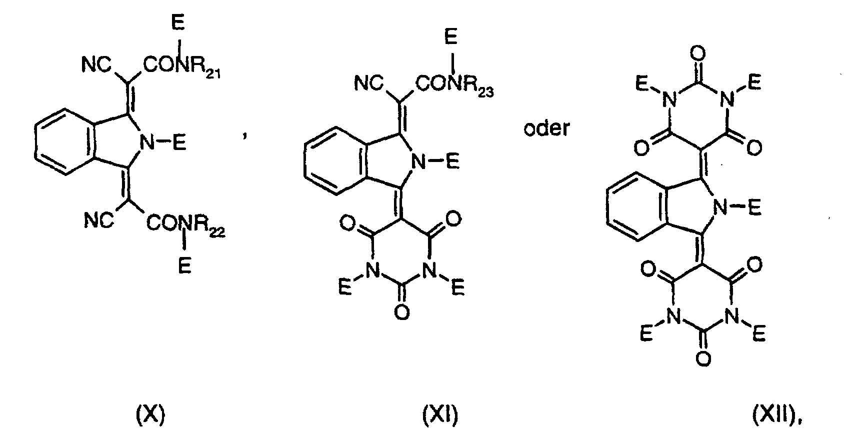 worin R₂₁ eine Gruppe 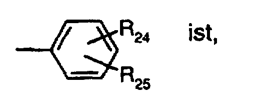 R₂₂ Wasserstoff, C₁-C₂₄-Alkyl, Benzyl oder eine Gruppe 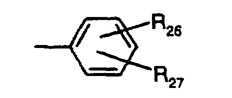 bedeutet und R₂₃ für Wasserstoff, E oder R₂₁ steht,
R₂₄, R₂₅, R₂₆ und R₂₇ unabhängig voneinander Wasserstoff, C₁-C₂₄-Alkyl, C₁-C₆-Alkoxy, Halogen oder Trifluormethyl bedeuten,

Isoindolinone der Formeln XIIIa, Xlllb oder XIIIc 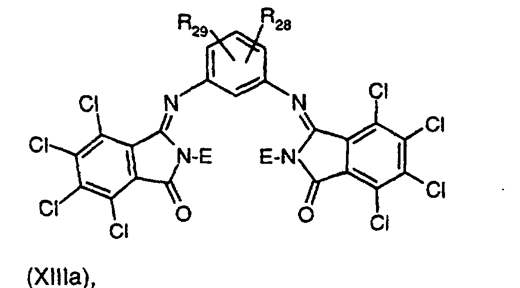 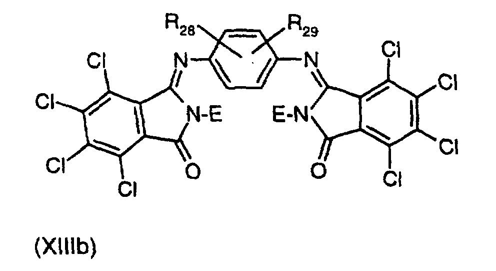 oder 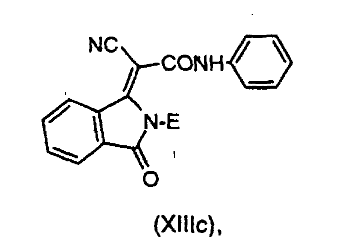 worin
R₂₈ und R₂₉. unabhängig voneinander Wasserstoff, Halogen oder C₁-C₆-Alkyl sind, oder

Benzimidazolon-Azoverbindungen der Formeln XIVa, XIVb oder XIVc 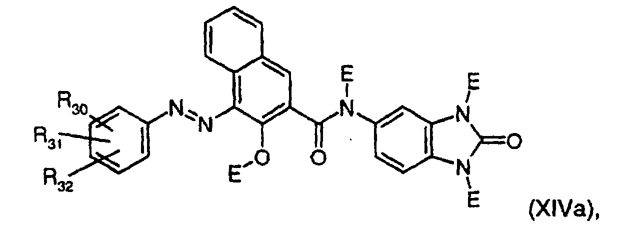 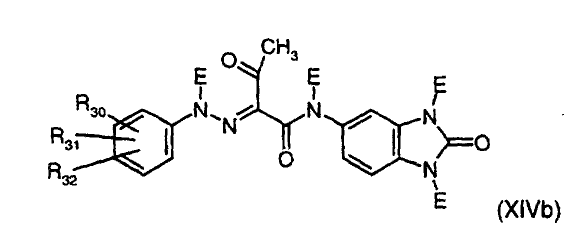 oder 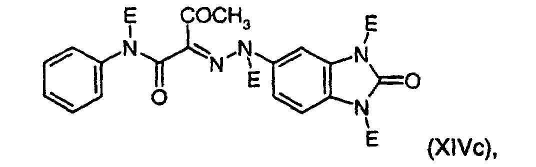 worin
R₃₀, R₃₁ und R₃₂ unabhängig voneinander Wasserstoff, Halogen, C₁-C₆-Alkoxy, C₁-C₆-Alkyl, Trifluormethyl, Nitro, Acetyl, CONR₇R₃₃ oder SO₂NR₇R₃₃ sind, und
R₃₃ für Wasserstoff, Halogen, C₁-C₆-Alkyl oder unsubstituiertes oder mit Wasserstoff oder ein-, zwei- oder dreifach durch Halogen, Nitro, E, CONER₈₅, NECO-R₈₅, Trifluormethyl, C₁-C₆-Alkoxy oder C₁-C₆-Alkyl substituiertes Phenyl steht,

Indigoderivate der Formel XV 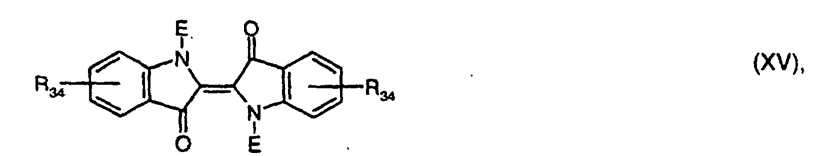 worin
R₃₄ Wasserstoff, CN, C₁-C₆-Alkyl, C₁-C₆-Alkoxy oder Halogen bedeutet,
Mono-Azoverbindungen der Formeln XVIa, XVlb oder XVlc 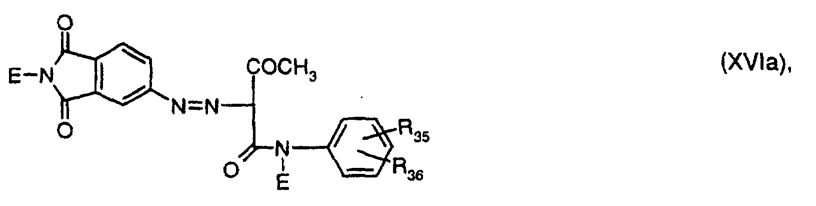 worin
R₃₅ und R₃₆ unabhängig voneinander Wasserstoff, Halogen, C₁-C₆-Alkyl, C₁-C₆-Alkoxy, Nitro, Acetyl oder SO₂NE-C₁-C₆-Alkyl sind, 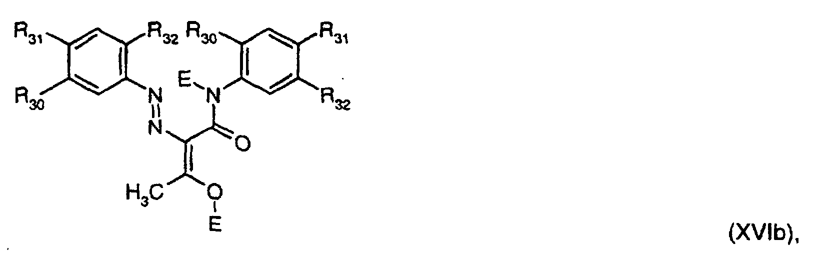 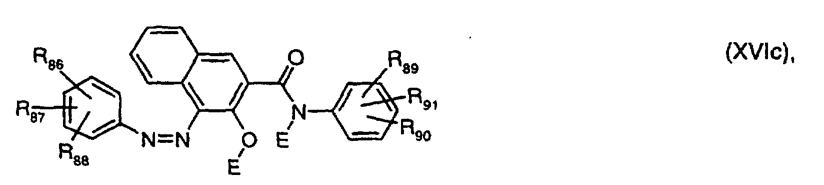 worin
- R₈₆: das gleiche wie R₃₀ bedeutet oder für einen Rest, Phenoxy oder einen Ester, COO(C₁-C₆-Alkyl) steht,
- R₈₇: das gleiche wie R₃₁ bedeutet oder für einen Rest, NECO-Phenyl, NECO-C₁-C₆-Alkyl oder CONH₂ steht,
- R₈₈: das gleiche wie R₃₂ oder R₃₃ bedeutet oder für einen Rest, der Formel, SO₂O-Aryl, SO₂O-Aryl-NO₂, SO₂O-Aryl-CO₂CH₃, SO₂CH₂-Aryl, worin,
- Aryl: beispielsweise Heteroaryl oder zum Beispiel Phenyl, Phenanthryl oder Naphthyl bedeutet, oder
- R₈₈: eine Gruppe 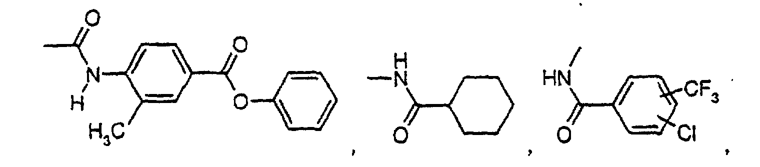 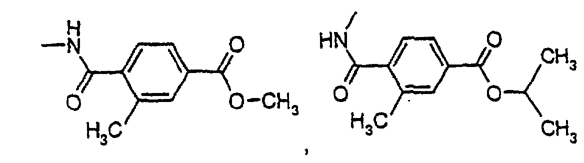 oder 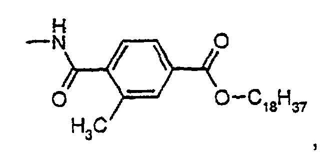 und
- R₈₉: Wasserstoff, C₁-C₆-Alkoxy, C₁-C₆-Alkyl oder 1-Naphthyl,
- R₉₀: Wasserstoff, C₁-C₆-Alkoxy, C₁-C₆-Alkyl, Halogen, NECO-C₁-C₆-Alkyl bedeutet, oder unsubstituiertes, oder mit C₁-C₆-Alkyl, C₁-C₆-Alkoxy, ein-, zwei-, oder dreifach durch Halogen substituiertes Phenacyl, wobei besonders bevorzugt die ein- oder zweifache Substitution durch Cl ist sowie 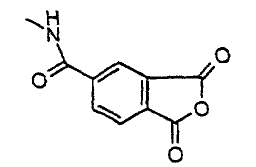
- R₉₁: Wasserstoff, Halogen, C₁-C₆-Alkoxy, C₁-C₆-Alkyl, NO₂, oder unabhängig voneinander die gleiche Bedeutung wie R₈₇ und R₈₈, oder Mono-Azoverbindungen der Formeln XVld oder XVIe 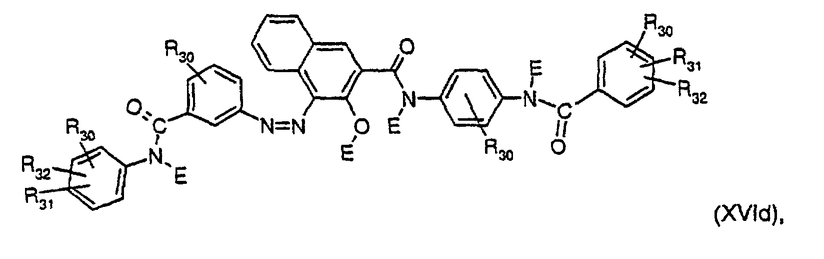 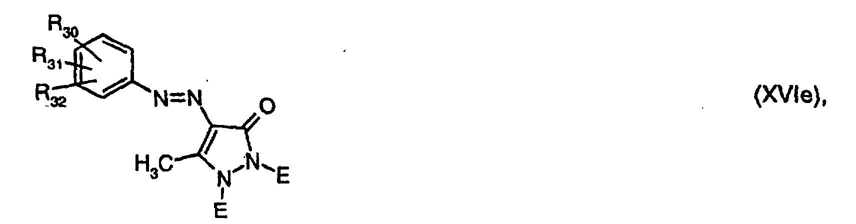
Bis-Azoverbindungen der Formeln XVII, XVIII, XVIIIa, XVIIIb oder XVIIIc 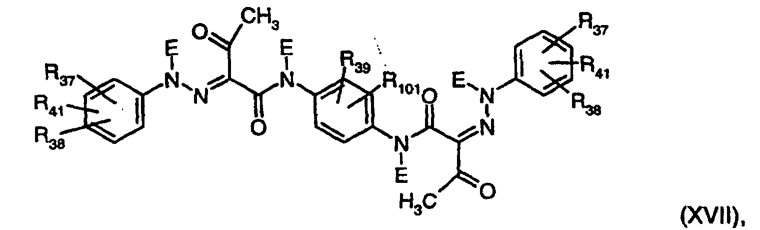 wobei, wenn E Wasserstoff bedeutet, XVII für ein Pigment des Colour Index, P.Y. 93, P.Y. 94, P.Y.95, P.Y. 128 oder P.Y. 166 steht,
oder 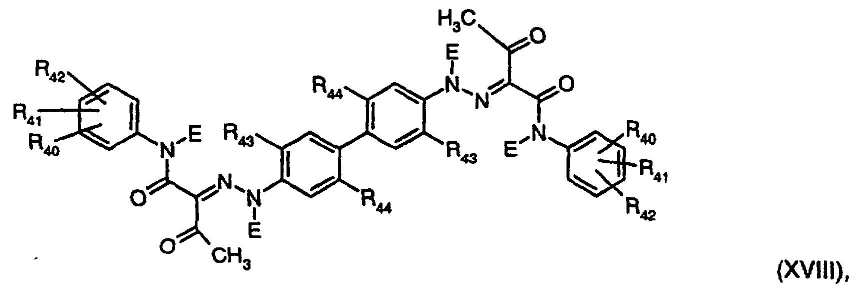 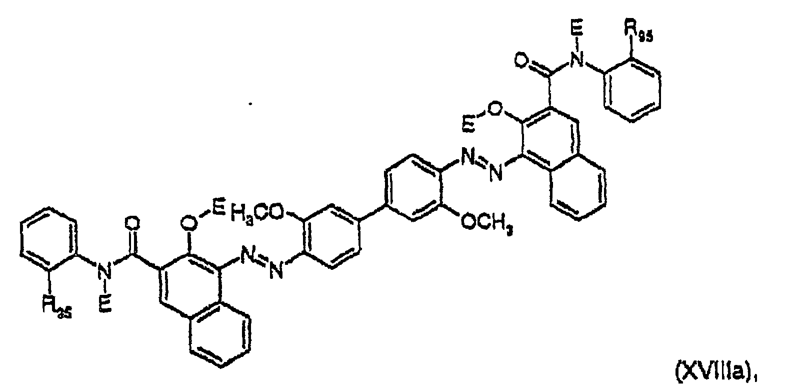 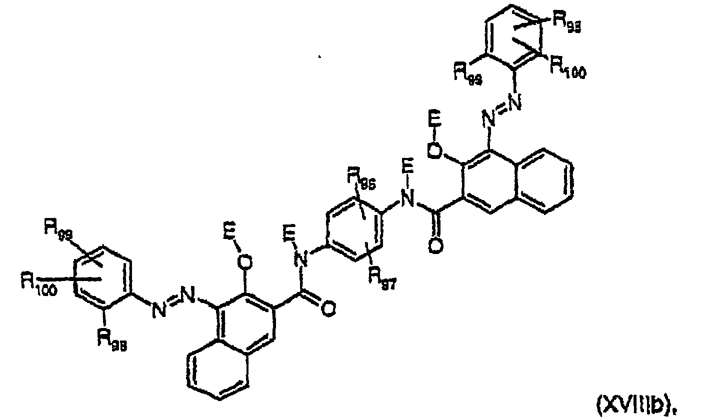 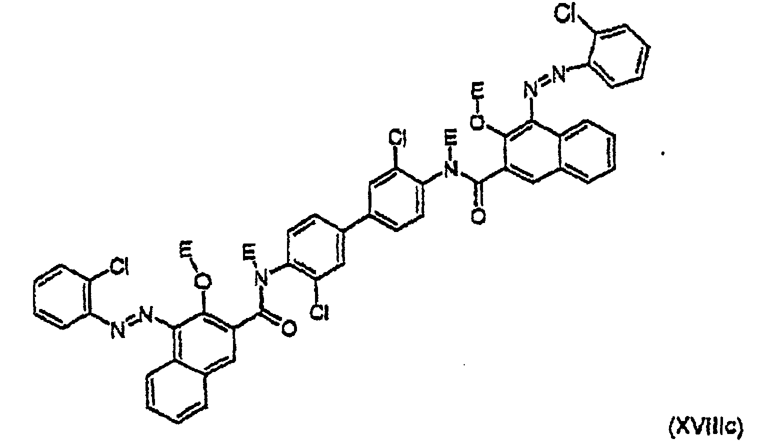 wobei in XVIIIb, wenn E Wasserstoff bedeutet, XVIIIb die Bedeutung von Pigment Colour Index P.R. 144, P.R. 186, P.R. 214, P.R. 220, P.R. 221 oder P.R. 242 hat, und XVIIIc, wenn E Wasserstoff bedeutet, XVIIIc die Bedeutung von Pigment Colour Index P.O. 31, R₃₇ und R₃₈ unabhängig voneinander Wasserstoff, Halogen, Nitro, C₁-C₆-Alkoxy, C₁-C₆-Alkyl, Trifluormethyl, CONER₄₅ oder SO₂NER₄₅, mindestens jedoch einmal CONER₄₅ oder SO₂NER₄₅ sind, und
R₃₉ und R₁₀₁ unabhängig voneinander für Wasserstoff, Halogen, Nitro, C₁-C₆-Alkoxy oder C₁-C₆-Alkyl stehen,
R₄₀, R₄₁ und R₄₂ unabhängig voneinander Wasserstoff, Halogen, Nitro, Acetyl, C₁-C₆-Alkoxy, C₁-C₆-Alkyl, Trifluormethyl, CONER₄₅ oder SO₂NER₄₅, mindestens jedoch einmal CONER₄₅ oder SO₂NER₄₅ sind, und
R₄₃ und R₄₄ unabhängig voneinander Wasserstoff, Halogen, C₁-C₆-Alkoxy oder C₁-C₆-Alkyl sind, und
R₄₅ für Wasserstoff, Halogen, C₁-C₄-Alkyl oder unsubstituiertes oder mit 1 bis 3, bevorzugt 2 Substituenten wie beispielsweise Halogen, Nitro, Trifluormethyl, C₁-C₄-Alkoxy oder C₁-C₄-Alkyl, E, bevorzugt Chlor oder Methyl, substituiertes Phenyl, Naphthyl, Biphenyl oder Oxybisphenyl steht,
R₉₅ Wasserstoff oder OCH₃ bedeutet,
R₉₆ und R₉₇ unabhängig voneinander Chlor oder Methyl,und
R₉₈, R₉₉ oder R₁₀₀ unabhängig voneinander Chlor, Methyl oder COOCH₂CH₂Cl, COOCH(CH₃)₂ bedeuten sowie
anthrachinoide Verbindungen der Formeln XIX, XIXa, XIXb, XIXc, XIXd oder XX 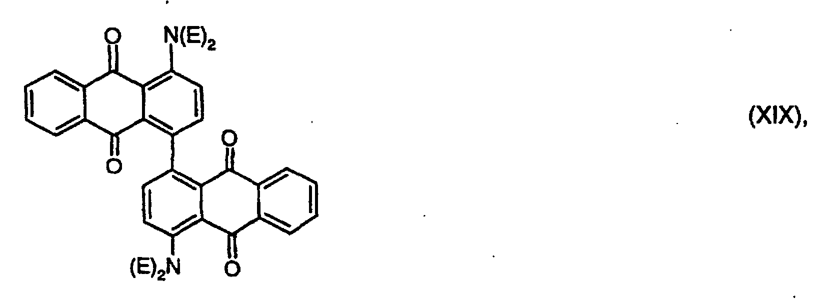 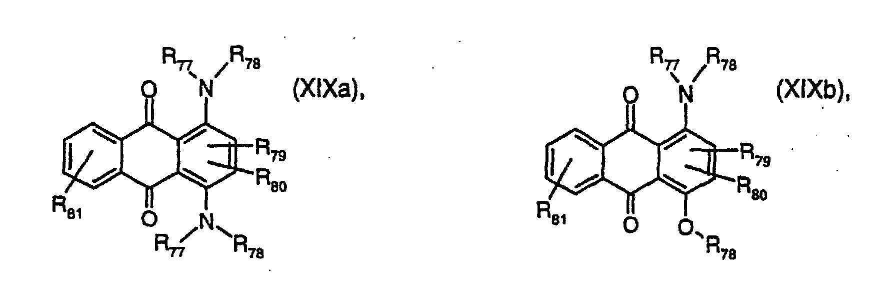 worin
R₇₇ und R₇₈ unabhängig voneinander E, Wasserstoff, C₁-C₁₂-Alkyl oder unsubstituiertes oder mit Halogen, C₁-C₆-Alkyl, C₁-C₆-Alkoxy, Nitro, Acetyl, SO₂NEC₁-C₆-Alkyl oder SO₂NH₂ substituiertes C₆-C₁₂-Aryl,
R₇₉ und R₈₀ unabhängig voneinander Wasserstoff, Halogen, C₁-C₆-Alkyl, C₁-C₆-Alkoxy, Nitro, Cyano, CONH₂, SO₂NEC₁-C₆-Alkyl, SO₂NH₂, SO₃H, SO₃Na oder unsubstituiertes oder mit Halogen, C₁-C₆-Alkyl, C₁-C₆-Alkoxy, Nitro, Acetyl, SO₂NEC₁-C₈-Alkyl oder SO₂NH₂ substituiertes C₆-C₁₂-Aryl, und
R₈₁ Wasserstoff, Halogen, Nitro, Cyan, Hydroxy oder C₁-C₆-Alkoxy bedeuten oder 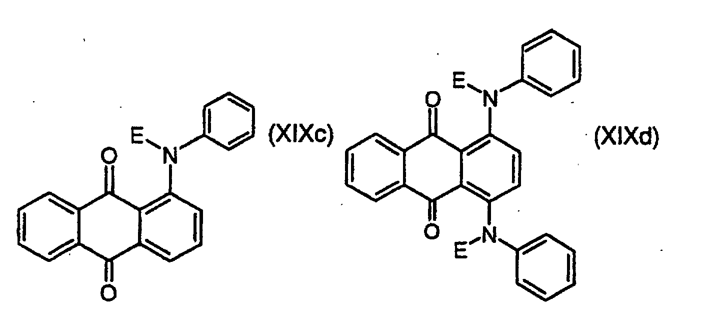 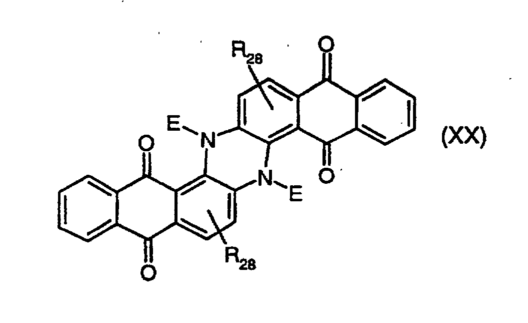 Phthalocyanine der Formel XXI 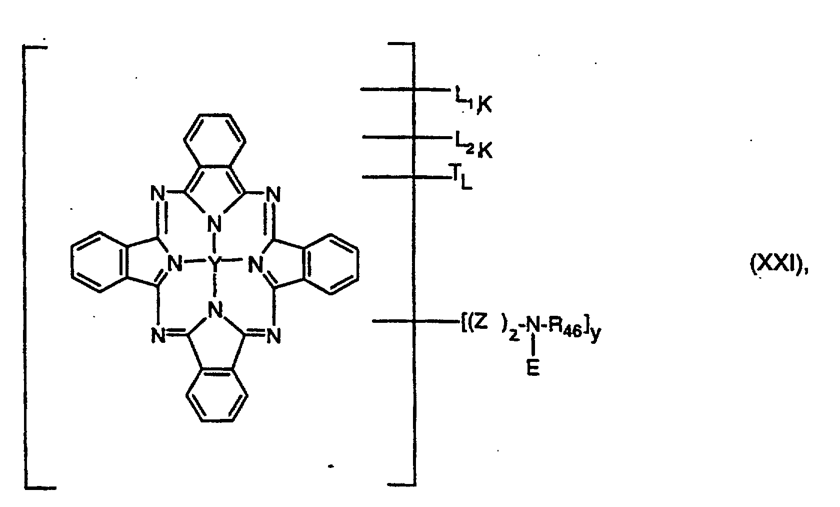 worin Y H₂, ein zweiwertiges Metall ausgewählt aus der Gruppe Cu(II), Zn(II), Fe(II), Ni(II), Ru(II), Rh(II), Pd(II), Pt(II), Mn(II), Mg(II), Be(II), Ca(II), Ba(II), Cd(II), Hg(II), Sn(II), Co(II) oder Pb(II) bevorzugt Cu(II), Zn(II), Fe(II) Ni(II) oder Pd(II) oder ein- oder zweiwertiges Oxometall ausgewählt aus der Gruppe V(O), Mn(O) oder TiO,
- Z: -CH(R₄₇)-, -CO- oder -SO₂-,
R₄₆ Wasserstoff, C₁-C₆-Alkyl, -N(E)R₄₇, -NECOR₄₈, -SO₂(NH)₂CO₂C(CH₃)₃, -COR₄₈ oder 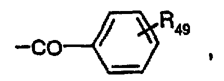 R₄₇ Wasserstoff oder C₁-C₆-Alkyl, R₄₈ C₁-C₆-Alkyl und R₄₉ Wasserstoff, Halogen, C₁-C₆-Alkyl oder C₁-C₆-Alkoxy bedeuten,
z für Null oder 1, y für Null oder für eine Zahl von 1 bis 8, K für Null oder 1, L für Null oder eine Zahl von 1 bis 16 steht, worin,
wenn y eine Zahl von 1 bis 4 bedeutet, K und L Null sind, oder
wenn K und L eine Zahl von 1 bis 16 bedeuten, y Null ist, und
L₁ und L₂, jeweils gebunden an eines der 8, den Phthalocyaninkomplex bildenden Stickstoffatome und/oder an eines der 8 den Phthalocyaninkomplex bildenden Kohlenstoffatome, bedeuten unabhängig voneinander Wasserstoff, Halogen, C₁-C₁₈-Alkoxy, C₁-C₁₈-Alkylthio, C₁-C₁₈-Alkylamino, C₂-C₁₈-Dialkylamino, Morpholin oder für unsubstituiertes oder mit C₁-C₁₂-Alkyl substituiertes Piperidin, sowie
T, für jedes T unabhängig voneinander Halogen, C₁-C₁₈-Alkyl, C₁-C₁₈-Alkoxy, C₁-C₁₈-Alkylthio oder C₂-C₁₈Dialkylamino bedeutet, und
Pyrrolo[3,4-c]pyrrole der Formeln XXIIa oder XXIIb 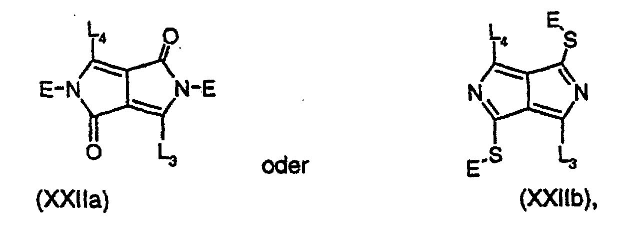 worin L₄ und L₃ unabhängig voneinander für eine Gruppe der Formeln 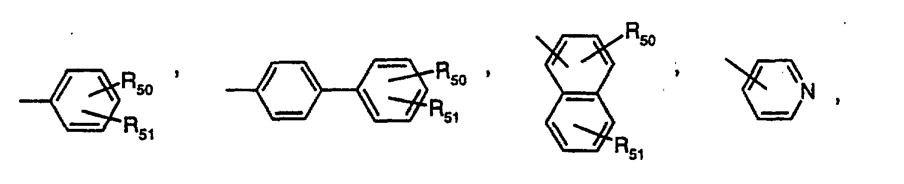 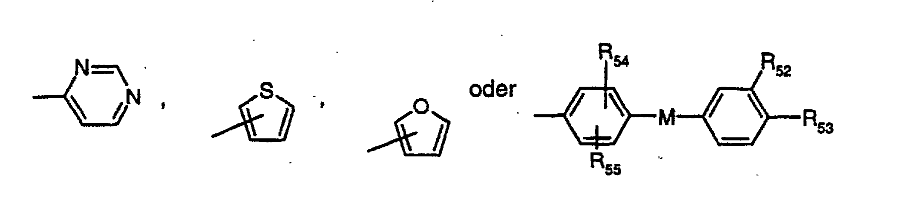 stehen, worin
R₅₀ und R₅₁ unabhängig voneinander Wasserstoff, Halogen, C₁-C₂₄-Alkyl, C₁-C₆-Alkoxy, C₁-C₁₈-Alkylmercapto, C₁-C₁₈-Alkylamino, Carbamoyl, -CN, -NO₂, -Phenyl, Trifluormethyl, C₅-C₆-Cycloalkyl, -C=N-(C₁-C₂₄-Alkyl), 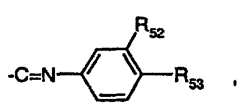 Imidazolyl, Pyrazolyl, Triazolyl, Piperazinyl, Pyrrolyl, Oxazolyl, Benzoxazolyl, Benzthiazolyl, Benzimidazolyl, Morpholinyl, Piperidinyl oder Pyrrolidinyl bedeuten,
M -CH₂-, -CH(CH₃)-, -C(CH₃)₂-, -CH=N-, -N=N-, -O-, -S-, -SO-, -SO₂- oder -NR₅₆- ist, R₅₂ und R₅₃ unabhängig voneinander Wasserstoff, Halogen, C₁-C₆-Alkyl, C₁-C₆-Alkoxy oder -CN sind, R₅₄ und R₅₅ unabhängig voneinander Wasserstoff, Halogen oder C₁-C₆-Alkyl und R₅₆ Wasserstoff oder C₁-C₆-Alkyl bedeuten,
wobei in den oben erwähnten Formeln E jeweils Wasserstoff oder B bedeutet, mit der Massgabe, dass E in jeder Formel mindestens einmal B ist, und für B die oben erwähnten Bevorzugungen gelten.

Besonders bevorzugt sind
Dioxazine der Formel IX, worin
R₁₈, R₁₉ und R₂₀ unabhängig voneinander C₁-C₄-Alkoxy,
NECOC₁-C₄-Alkyl, NECOPhenyl oder NH-E sind, wobei mindestens einer der Reste R₁₈, R₁₉ oder R₂₀ NH-E ist, oder mindestens einer der Reste R₁₈, R₁₉ oder R₂₀NECOPhenyl und/oder NECOC₁-C₄-Alkyl und/oder C₁-C₄-Alkoxy, und
Isoindoline der Formel XII, und

Isoindolinone der Formel XIII, und
worin
R₂₈ und R₂₉. unabhängig voneinander Wasserstoff, Halogen oder C₁-C₄-Alkyl sind, und Benzimidazolon-Azoverbindungen der Formeln XXIIIa oder XXIIIb 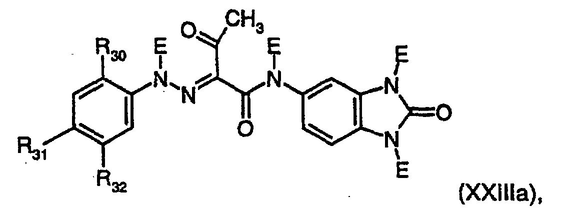 worin
R₃₀, R₃₁ und R₃₂ unabhängig voneinander Wasserstoff, Halogen, C₁-C₆-Alkoxy, C₁-C₆-Alkyl, Trifluormethyl, CONER₃₃ oder SO₂NER₃₃ sind, und
R₃₃ für Wasserstoff, Halogen, C₁-C₆-Alkyl oder unsubstituiertes oder mit Wasserstoff, Halogen, Nitro, E, C₁-C₆-Alkoxy oder C₁-C₆-Alkyl substituiertes Phenyl steht, oder 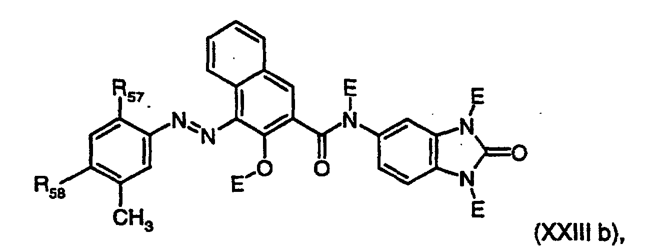 worin
R₅₇ und R₅₈ unabhängig voneinander Wasserstoff, Halogen, C₁-C₆-Alkoxy, C₁-C₆-Alkyl, Trifluormethyl, CONER₆₀ oder SO₂NER₆₀ sind, und
R₆₀ für Wasserstoff, Halogen, C₁-C₆-Alkyl oder unsubstituiertes oder mit Wasserstoff, Halogen, Nitro, E, C₁-C₆-Alkoxy oder C₁-C₆-Alkyl substituiertes Phenyl steht, und
Mono-Azoverbindungen der Formel XVIf

XVIfXVIfXVIf

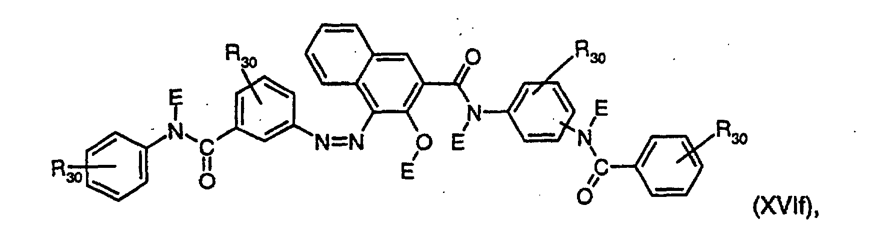

Bis-Azoverbindungen der Formeln XXIV oder XXV 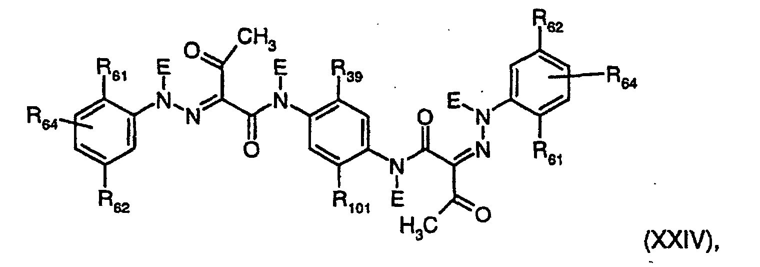 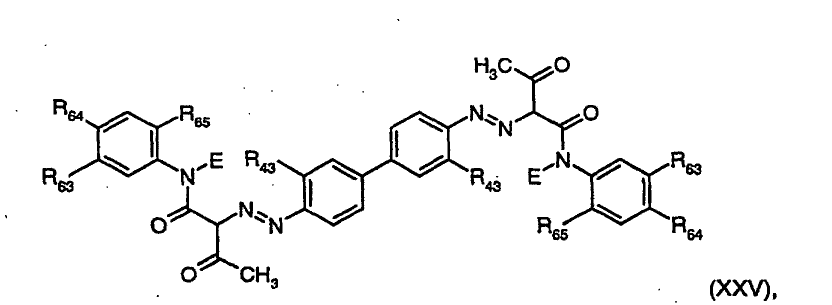 worin
R₆₁ und R₆₂ unabhängig voneinander Wasserstoff, Chlor, CONER₆₆ oder SO₂NER₆₆, mindestens einmal CONER₆₆ oder SO₂NER₆₆ bedeuten,
R₃₉ für Wasserstoff, Chlor oder Methyl,
R₆₃, R₆₄ und R₆₅ unabhängig voneinander Wasserstoff, Chlor, Methoxy, Methyl, oder mindestens einmal CONER₆₆ oder SO₂NER₆₆ bedeuten, und
R₆₆ für unsubstituiertes oder mit 1 bis 3 Substituenten, ausgewählt aus der Gruppe bestehend aus Chlor, Trifluormethyl, Methoxy, Methyl oder E substituiertes Phenyl oder Oxybisphenyl steht, und
anthrachinoide Verbindungen der Formel XIX (a bis d), und Phthalocyanine der Formel XXI,
worin M für H₂, ein zweiwertiges Metall ausgewählt aus der Gruppe bestehend aus Cu(II), Zn(II), Fe(II) und Ni(II),
Z für -CO-oder -SO₂-, und
z für Null oder 1 und y für eine Zahl von 1 bis 4 stehen,
L₁ und L₂, jeweils gebunden an eines der 8, den Phthalocyaninkomplex bildenden Stickstoffatome und/oder an eines der 8 den Phthalocyaninkomplex bildenden Kohlenstoffatome, bedeuten unabhängig voneinander Wasserstoff, C₂-C₁₈-Dialkylamino, Morpholin oder unsubstituiertes oder mit C₁-C₁₂-Alkyl substituiertes Piperidin, insbesondere mit C₁-C₁₂-Alkyl substituiertes Piperidin, und ganz besonders 4-n-Propytpiperidin, und
Pyrrolo[3,4-c]pyrrole der Formel XXII, worin L₄ und L₃ gleich sind und eine Gruppe der Formeln 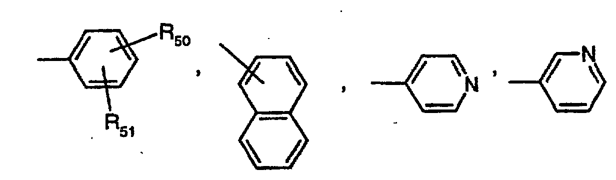 oder 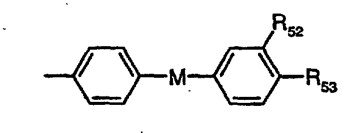 sind,
worin R₅₀ und R₅₁ unabhängig voneinander Wasserstoff, Halogen, C₁-C₄-Alkyl, C₁-C₆-Alkoxy, C₁-C₆-Alkylamino, Carbamoyl, Cyan, Nitro, Trifluormethyl oder Phenyl bedeuten,
M -O-, -NR₅₆-, -N=N- oder -SO₂- ist,
R₅₂ und R₅₃ Wasserstoff und R₅₆ Wasserstoff, Methyl oder Ethyl bedeuten, und
wobei E in den Formeln jeweils Wasserstoff oder B bedeutet, mit der Massgabe, dass E in jeder Formel mindestens einmal B ist, und B die oben erwähnten Bevorzugungen gelten.

Ganz besonders bevorzugt sind Pyrrolopyrrole der Formel XXVIII 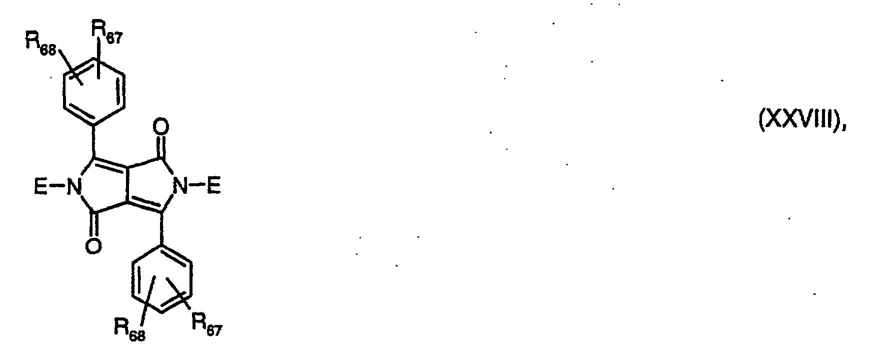 worin R₆₆ und R₆₇ unabhängig voneinander Wasserstoff, Methyl, tert.-Butyl, Chlor, Brom, Cyan oder Phenyl bedeuten, und
E Wasserstoff oder B bedeutet, mit der Massgabe, dass E mindestens einmal B ist, und B die Bedeutung der zuletzt angegebenen Bevorzugung hat, und
Dioxazine der Formel IX, worin R₁₈, R₁₉ und R₂₀ die Bedeutung der zuletzt genannten Bevorzugung besitzen, und bevorzugt R₁₈ C₁-C₄Alkoxy R₁₉ NECOPhenyl oder R₂₀ NECOC₁-C₄Alkyl und
Isoindoline der Formeln XXIX, XXX oder XXXI 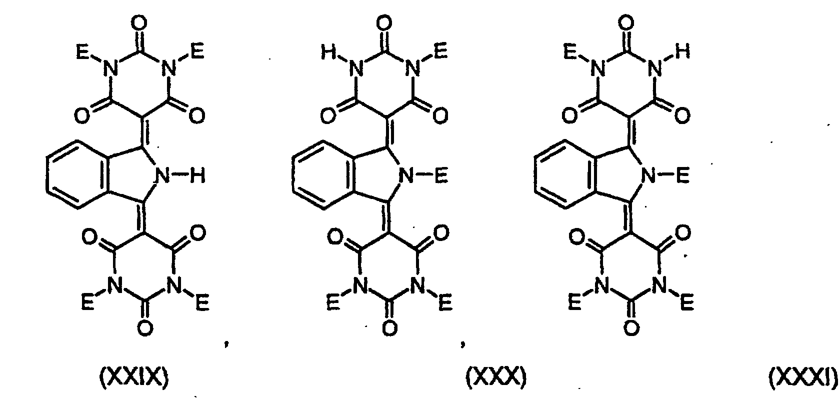 oder
Isoindolinon der Formel XXXII 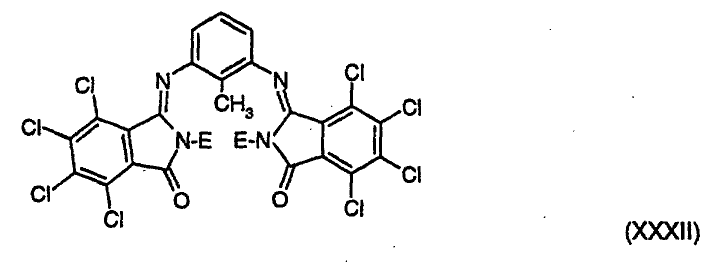 oder
Benzimidazolone der Formeln XXXIVa, XXXIVb, XXXIVc, XXXIVd, XXXVIII oder XXXIVe 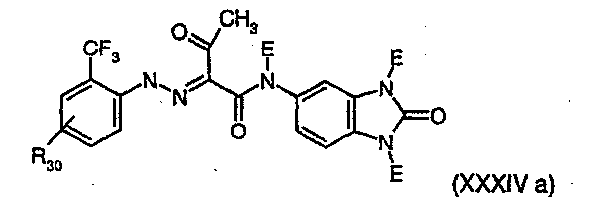 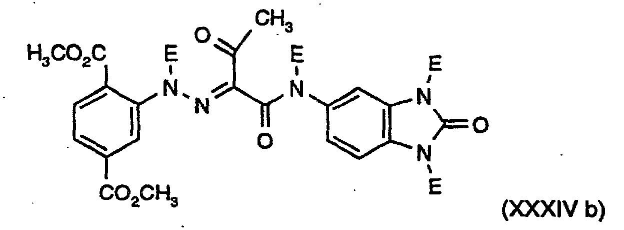 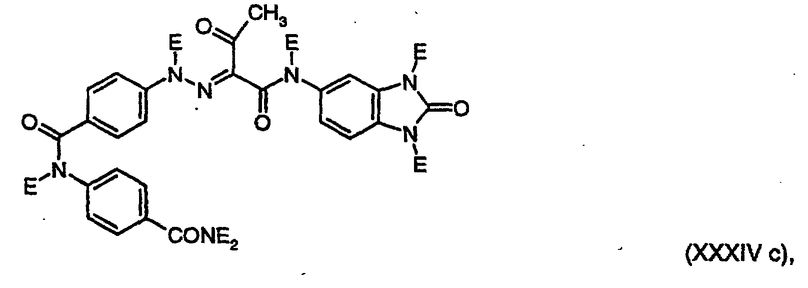 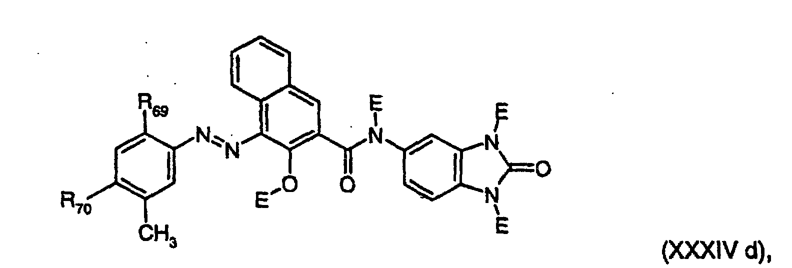 insbesondere 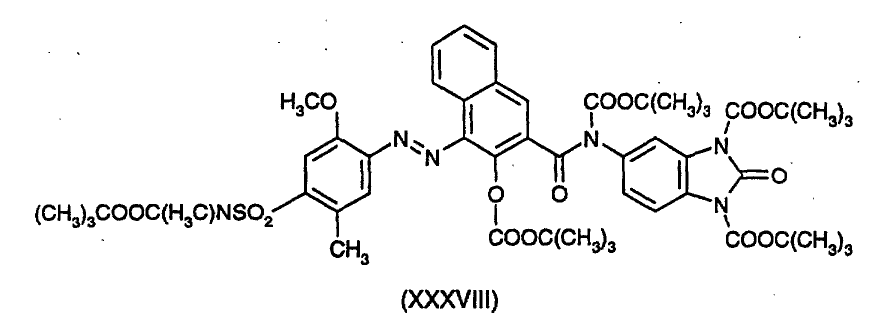 sowie des weiteren 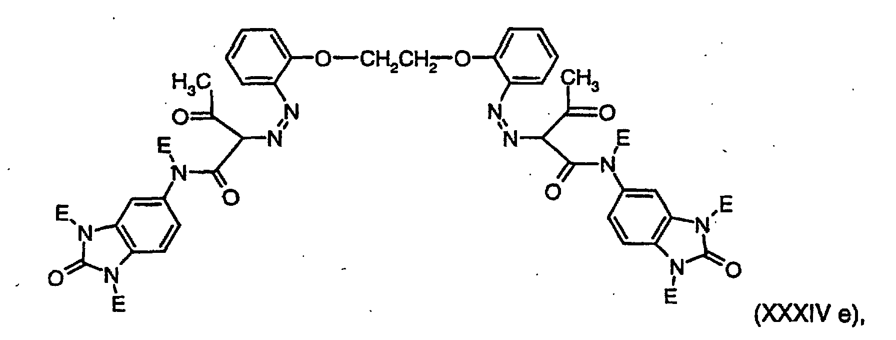 worin
- R₃₀: Wasserstoff, Halogen, C₁-C₆Alkoxy, C₁-C₆Alkyl,
- R₆₉: C₁-C₆Alkoxy, insbesondere Methoxy ist, und
- R₇₀: CONHE, SO₂NMeE oder SO₂NHE, insbesondere SO₂NHE oder SO₂NMeE ist, und
Azoverbindungen, wie Mono- und Bis-Azoverbindungen der Formeln LX, LXI, XXXV, XXXVa, XXXVIa oder XXXVIb 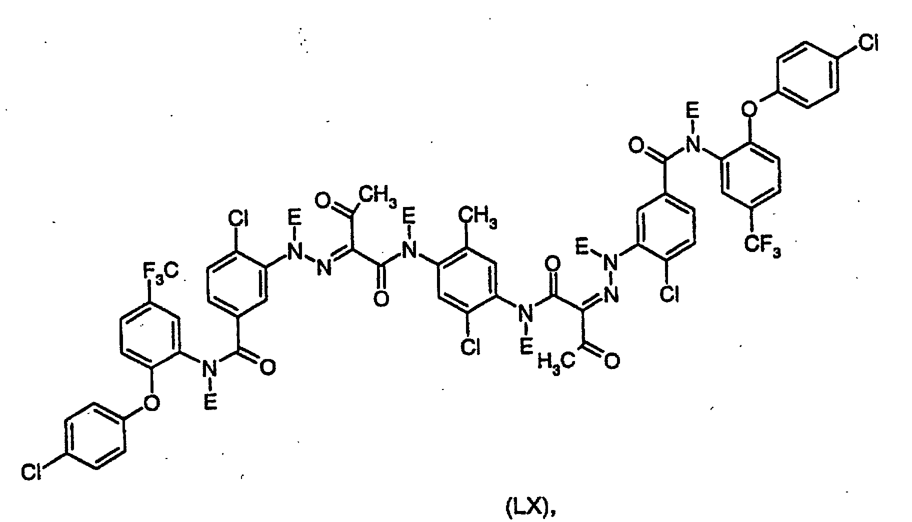 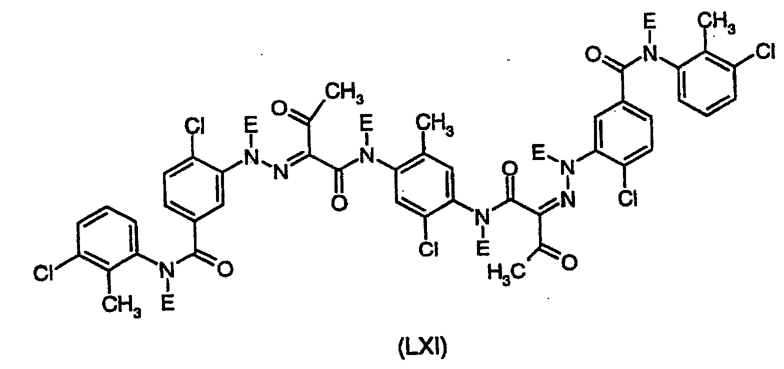 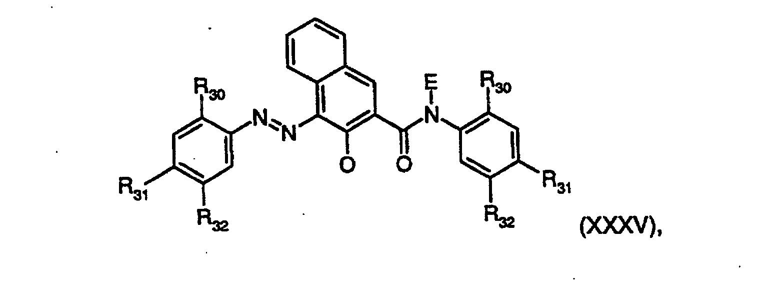 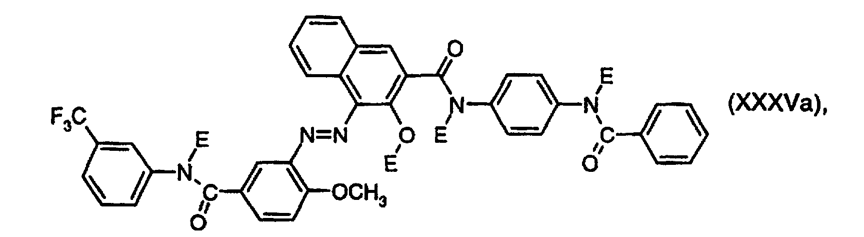 worin bevorzugt, E für -COO-C(CH₃)₂-CH₂CH₃ oder -COO-C(CH₃)₃ steht und 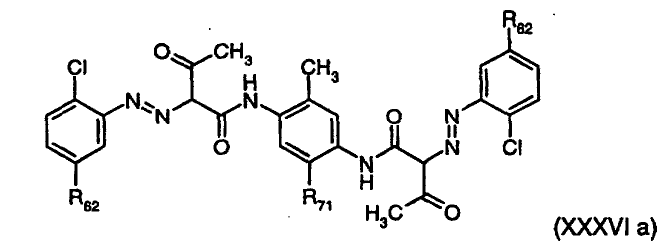 oder 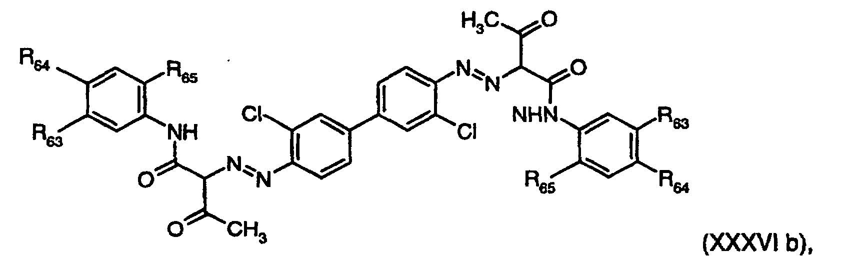 worin
R₇₁ Chlor oder Methyl, und R₆₂, R₆₃, R₆₄ und R₆₅ die oben angegebenen Bedeutungen besitzen, und
anthrachinoide Verbindungen der Formel XIX, und
Phthalocyanine der Formel XXI, mit den zuletzt genannten Bevorzugungen,
worin E Wasserstoff oder B bedeutet, mit der Massgabe, dass E mindestens einmal B ist, und B die Bedeutung der zuletzt angegebenen Bevorzugung hat

Die Verbindungen XXXIVc, XXXIVd und XXXVa sind noch neu und ebenfalls ein Gegenstand dieser Erfindung sowie Verfahren zu ihrer Herstellung durch Umsetzung eines Pigments der Formeln XXXIVc1, XXXIVd1 oder XXXVa1 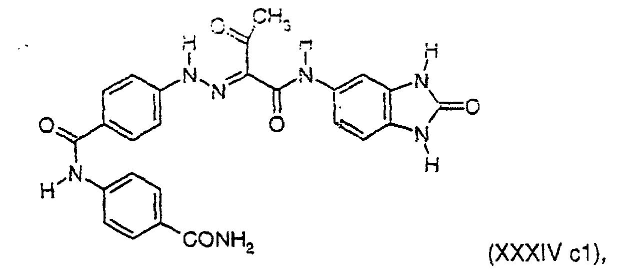 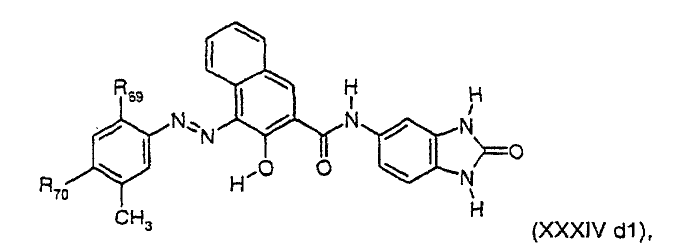 worin R₆₉ und R₇₀ den zuletzt genannten Bevorzugungen entspricht, unter der Massgabe, dass E Wasserstoff bedeutet sowie 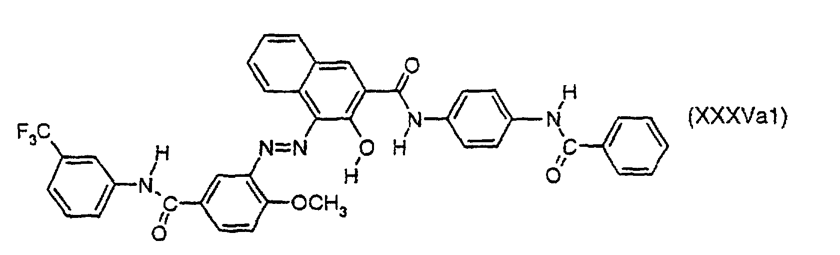 mit einer Verbindung der Formel Cl-B oder S-O-B, worin B die Bedeutung der zuletzt angegebenen Bevorzugung hat.

Beispielsweise werden Verbindungen der Formeln XXXIV c, XXXIVd oder XXXVa nach allgemeinem Verfahren zur Herstellung von Latentpigmenten, wie in US 5,484,943 und 5,616,725 beschrieben, hergestellt, indem man
Pigment der Formeln XXXIV c1, XXXIVd1 oder XXXVa1 mit einer Reaktiwerbindung von B, der Formeln CI-B oder B-O-B zur Reaktion bringt.
Besonders bevorzugt steht B hier für Di-tert.-Alkylcarbonats wie zum Beispiel Di-tert.-Butyl- oder Di-tert.-Amylcarbonat.

In der Regel kann man die Reaktion in Gegenwart eines organischen Lösungsmittels durchführen, vorzugsweise in aprotischen wie beispielsweise Tetrahydrofuran,

Üblicherweise führt man die Reaktion unter Zusatz einer organischen Base wie beispielsweise Stickstoff-haltigen Basen wie Triethylamin, Dimethylaminopyridin, bevorzugt mit Dimethylaminopyridin durch.

Die Aufarbeitung und/oder Reinigung sowie Isolation wird im allgemeinen nach den üblichen Methoden für die Herstellung von Latentpigmenten wie in US 5,484,943 und 5,616,725 beschrieben ist durchgeführt, indem man das Reaktionsgemisch abfiltriert, und das verbleibende Filtrat aufkonzentriert, bevorzugt zur Trockene einengt, und gewünschten das Rohproduktes durch Filtration oder Chromatographie reinigt. Für letztere Reinigungsmethode wird vorzugsweise Kieselgel (zum Beispiel käuflich bei FLUKA) und ein organisches Lösungsmittel wie beispielsweise ein Methylenchlorid/Essigsäureethylester-Lösungsmittelgemisch verwendet, Die Isolation des Reaktionsproduktes erfolgt üblicherweise durch Aufkonzentration der Lösung, die das gereinigte Produkt enthält, bevorzugt durch Einengung zur Trockene.

In einer weiteren Ausführungsform des erfindungsgemässen Verfahrens verwendet man die Verbindungen der Formeln XXXIV c, XXXIVd oder XXXVa zum herstellen der erfindungsgemässen Pigmentdispersionen.

Die vorliegende Erfindung betrifft des weiteren Pigmentdispersionen, enthaltend
(a) ein Polymer,
(b) ein organisches Pigment in kolloidaler Form und
(c) ein nicht-wasserhaltiges Lösungsmittel
   oder
(d) ein wasserhaltiges Lösungsmittel.

Nicht-wasserhaltiges oder wasserhaltiges Lösungsmittel sowie Polymer entsprechen den oben gegebenen Definitionen des erfindungsgemässen Verfahrens. Die erfindungsgemässen Pigmentdispersionen können entsprechend dem erfindungsgemässen Verfahren hergestellt werden, oder lassen sich nach allgemein bekannten Verfahren des Standes der Technik wie in US 4,597,794, 5,085,698, 5,030,669 oder WO 96/14925 beschrieben, direkt aus den Pigmenten durch mechanische Zerkleinerungs- und anschliessende Selektionstechniken, wie Filtration oder Zentrifugierung, zur Entfernung von Grobpartikeln, unter Zusatz von stabilisierenden Copolymeren, herstellen.

Als organische Pigmente der erfindungsgemässen Pigmentdispersionen bedeuten Verbindungen der Formel (LXII)

A(K)ₓ (LXII)

worin A und x der in Formel (I) gegebenen Bedeutung entsprechen, und (K) für Wasserstoff oder ein Kation eines Alkalimetalls wie Li⁺, Na⁺, K⁺, eines Erdalkalimetalls wie Mg⁺⁺_{½}, Ca⁺⁺_{½}, Sr⁺⁺_{½}, Ba⁺⁺_{½}, oder Cu⁺, Cu⁺⁺_{½}, Zn⁺⁺_{½}, Al⁺⁺⁺_{½} oder eine organische Stickstoffbase wie [NR₈₅R_{85'}R_{85"}R_{85'''}]⁺ steht, worin
R₈₅R_{85'}R_{85''}R_{85'''} unabhängig voneinander Wasserstoff, C₁-C₆-Alkyl, unsubstituiertes oder durch C₁-C₆-Alkyl substituiertes Phenyl bedeuten.

Die erfindungsgemässen Pigmentdispersionen können die organischen Pigmente auch kolioidal im Polymer und/oder Lösungsmittel eingebettet und/oder gelöst enthalten.
Die vorliegende Erfindung betrifft deshalb weiterhin die erfindungsgemässen Pigmentdispersionen, die ein Pigment in kolloidaler Form enthalten.

Bevorzugt betrifft die vorliegende Erfindung eine Pigmentdispersion, enthaltend
(a) ein Polymer,
(b) ein organisches Pigment in kolloidaler Form und
(c) ein wasserhaltiges Lösungsmittel.

Gegenstand vorliegender Erfindung sind auch die nach den erfindungsgemässen Verfahren erhalten Pigmentdispersionen.

Die erfindungsgemässen Pigmentdispersionen können gewünschtenfalls in weiterer Formulierung oder Konditionierung für spezielle Anwendungen verwendet werden.

Deshalb betrifft die vorliegende Erfindung auch die Verwendung der erfindungsgemässen Pigmentdispersionen sowie der Verbindungen XXXIVc, XXXIVd oder XXXVa, oder der aus diesen Verbindungen erhältlichen Pigmentform, zum Färben/Pigmentieren von hochmolekularem Material, das organischer oder anorganischer Natur sein kann und Kunststoffe und/oder Naturstoffe bedeuten kann. Die Verbindungen XXXIV c, XXXIVd oder XXXVa können gewünschtenfalls durch allgemein bekannte Methoden wie durch thermische, chemische oder photolytische Behandlung, wie beispielsweise in EP-A 654 711 oder EP-A-742255 beschrieben, in die Pigmentform überführt werden. Bei den hochmolekularen Materialien kann es sich zum Beispiel um Naturharze oder trockene Oele, Kautschuk oder Casein oder um abgewandelte Naturstoffe wie Chlorkautschuk, ölmodifizierte Alkydharze, Viscose, um Celluloseether oder -ester wie Ethylcellulose, Celluloseacetat, -propionat, oder -butyrat, Celuloseactobutyrat sowie Nitrocellulose, handeln, insbesondere aber um vollsynthetische organische Polymere (Duro- und Thermoplaste), wie sie durch Polymerisation, zum Beispiel durch Polykondensation oder Polyaddition erhalten werden können. Zur Klasse der Polymeren gehören beispielsweise Polyolefinen wie Polyethylen, Polypropylen, Polyisobutylen, ferner substituierte Polyolefine, wie Polymerisate von Monomeren wie Vinylchlorid, Vinylacetat, Styrol, Acrylnitril, Acrylsäureester, Methacrylsäureester, Fluorpolymerisate wie zum Beispiel Polyfluorethylen, Polytrifluorchlorethylen oder Tetrafluorethylen/Hexafluoropropylen-Mischpolymerisat sowie Copolymerisate der erwähnten Monomeren, insbesondere ABS (Acrylnitril/Butadien/Styrol) oder EVA (EthylenNinylacetat). Aus der Reihe der Polyadditions- und Polykondensationsharze handelt es sich beispielsweise um Kondensationsprodukte von Formaldehyd mit Phenolen, die sogenannten Phenoplase, und um Kondensationsprodukte von Formaldehyd mit Harnstoff, Thioharnstoff, des weiteren um Melamin, die sogenannten Aminoplaste, ferner um die als Lackharze verwendeten Polyester, und zwar sowohl gesättigte wie zum Beispiel Alkydharze, als auch ungesättigte wie beispielsweise Maleinharze, ferner um die linearen Polyester, Polyamide, Polyurethane, Polycarbonate, Polyphenylenoxide oder Silikone, Silikonharze.

Die erwähnten hochmolekularen Verbindungen können einzeln oder in Gemischen als plastische Massen, Schmelzen oder in Form von Spinnlösungen, Lacken oder Druckfarben vorliegen. Je nach Verwendungszweck erweist es sich als vorteilhaft, die erfindungsgemässen dispersen Pigmentkonzentrate als Toner oder in Form von Präparaten einzusetzen.

Die vorliegende Erfindung betrifft deshalb bevorzugt die Verwendung der erfindungsgemässen Pigmentdispersionen sowie einer Verbindungen XXXIVc, XXXIVd oder XXXVa oder der aus diesen Verbindungen erhältlichen Pigmentform oder der erfindungsgemässen Zusammensetzungen enthaltend hochmolekulares Material, insbesondere hochmolekulares organisches Material, und eine färberisch wirksame Menge der Verbindungen der Formeln XXXIVc, XXXIVd oder XXXVa, oder der aus diesen Verbindungen erhältlichen Pigmentform, oder der erfindungsgemässen Pigmentdispersionen für die Herstellung von Tinten oder Drucktinten in Druckverfahren für den Flexodruck, Siebdruck, Verpackungsdruck, Sicherheitsfarbdruck, Tiefdruck oder Offsetdruck, für Druckvorstufen sowie für Textildruck, für Büro-, Heimanwendungen oder graphische Anwendungen, für Papierwaren, für Kugelschreiber, Filzstifte, Faserstifte, Pappe, Holz, (Holz-)Beizen, Metall, Stempelkissen oder Tinten für impact-printing Verfahren (mit Stossdruckfarbbänder), oder für die Herstellung von
Farbmitteln für Lacke, für den Industrie- oder Gewerbegebrauch, für die Textildekoration und die industrielle Markierung, für Walzlacke oder Pulverlacke oder für Automobillacke für high-solids (lösungsmittelarme), wasserhaltige oder metallische Lacke oder für wasserhaltige Formulierungen, wasserhaltige Anstrichfarben, oder für die Herstellung von pigmentieren von Kunststoffen für Beschichtungen, Fasern, Platten oder Formträger, oder für non-impact-printing Material (Nicht-Stossdruckmaterial), für digital-printing (Digitale Druckverfahren), für das thermische Wachs-Transfer-Druck, das Tintenstrahldruck- oder für das thermische Transferdruck-Verfahren, oder für die Herstellung von
Farbfiltern, insbesondere für sichtbares Licht im Bereich von 400 bis 700 nm, die für die Herstellung von Flüssigkristallbildschirmen (Liquid Crystal Display, LCD) oder Charge Combined Device (CCD) verwendet werden können, oder für die Herstellung von Kosmetik, oder zur Herstellung für
Toner oder von polymeren Farbpartikel für die Herstellung von Tonern für dry copy toners (Trockenkopier-Farblacke) sowie liquid copy toners (Flüssigkopier-Farblacke) oder elektrophotgraphische Toner.

Die Toner können in Master-Batches hergestellt werden und ihrerseits in Master-Batches für die Herstellung von gefärbten Kunststoffen verwendet werden.

Des weiteren betrifft die Erfindung Zusammensetzungen enthaltend hochmolekulares Material, insbesondere hochmolekulares organisches Material, und eine färberisch wirksame Menge der Verbindungen der Formeln XXXIVc, XXXIVd oder XXXVa, oder der aus diesen Verbindungen erhältlichen Pigmentform, oder der erfindungsgemässen Pigmentdispersionen.

Zum Pigmentieren der hochmolekularen, organischen Substanzen mit den erfindungsgemäss erhaltenen Verbindungen erfolgt beispielsweise derart, dass man eine solche Verbindung gegebenenfalls in Form von Masterbatches diesen Substraten unter Verwendung von Walzwerken, Misch- oder Mahlapparaten zumischt. Das pigmentierte Material wird hierauf nach an sich bekannten Verfahren wie Kalandrieren, Pressen, Strangpressen, Streichen, Giessen oder Spritzgiessen in die gewünschte endgültige Form gebracht. Oft ist es erwünscht, zur Herstellung von nicht starren Formlingen oder zur Verringerung ihrer Sprödigkeit den hochmolekularen organischen Verbindungen vor der Verformung sogenannte Weichmacher einzuverleiben. Als solche können zum Beispiel Ester der Phosphorsäure, Phthalsäure oder Sebacinsäure dienen. Die Weichmacher können vor oder nach der Einverleibung der erfindungsgemäss erhaltenen Verbindungen in die Polymeren eingearbeitet werden. Es ist ferner möglich, zwecks Erzielung verschiedener Farbtöne den hochmolekularen, organischen Substanzen neben den erfindungsgemäss erhaltenen Verbindungen noch Füllstoffe oder andere farbgebende Bestandteile wie Weiss-, Bunt- oder Schwarzpigmente, in beliebigen Mengen zuzufügen.

Zum Pigmentieren von Lacken, Anstrichstoffen und Druckfarben werden die hochmolekularen organischen Materialien und die erfindungsgemäss erhaltenen Pigmentdispersionen gegebenenfalls zusammen mit Zusatzstoffen, wie Füllmitteln, anderen Pigmenten, Siccativen oder Weichmachern, in einem gemeinsamen organischen Lösungsmittel oder Lösungsmittelgemisch fein dispergiert oder gelöst. Man kann dabei so verfahren, dass man die einzelnen Komponenten für sich oder auch mehrere gemeinsam dispergiert oder löst, und erst hierauf alle Komponenten zusammenbringt.

Die vorliegende Erfindung betrifft deshalb weiterhin ein Verfahren zur Herstellung der erfindungsgemässen Zusammensetzungen, indem man hochmolekulares organisches Material mit einer färberisch wirksamen Menge der erfindungsgemässen Pigmentdispersion oder Verbindungen der Formeln XXXIVc, XXXIVd oder XXXVa oder der aus diesen Verbindungen erhältlichen Pigmentform, umsetzt.

Zweckmässig liegt das Gewichtsverhältnis der erfindungsgemässen Pigmentdispersionen oder der Verbindungen der Formeln XXXIVc, XXXIVd oder XXXVa, oder der aus diesen Verbindungen erhältlichen Pigmentform, zur erfindungsgemässen Zusammensetzungen im Bereich von 0,001 bis 75 Gew.-%, bevorzugt von 0,01 bis 50 Gew.-%, bezogen auf das Gesamtgewicht der Zusammensetzung.

Des weiteren betrifft die vorliegende Erfindung Tinten, die aus den erfindungsgemässen Zusammensetzungen bestehen.

Verfahren zur Herstellung von Tinten für den Tintenstrahldruck sind allgemein bekannt und in mehreren Druckschriften wie zum Beispiel in US 5,106,417 beschrieben.

Man kann beispielsweise die Tinten herstellen, indem man die erfindungsgemässen Pigmentdispersionen oder die Verbindungen der Formeln XXXIVc, XXXIVd oder XXXVa, oder die aus diesen Verbindungen erhältliche Pigmentform, mit polymeren Dispergierungsmitteln vermischt.

Das Vermischen der Pigmentdispersion mit dem polymere Dispergierungsmittel erfolgt nach den allgemien bekannten Methoden des Vermischens wie Rühren oder Mixen, vorzugsweise empfiehlt es sich Intensivmixer wie Ultraturax zu verwenden.

Beim Vermischen der erfindungsgemässen Pigmentdispersionen oder der Verbindungen der Formeln XXXIVc, XXXIVd oder XXXVa, oder der aus diesen Verbindungen erhältlichen Pigmentform, mit polymeren Dispergierungsmitteln setzt man zweckmässig ein wasserverdünnbares organisches Lösungsmittel zu.

Die Verbindungen der Formeln XXXIVc, XXXIVd oder XXXVa werden in der Regel vor, während oder nach dem Vermischen mit einem polymeren Dispergierungsmittel durch allgemein bekannte Methoden, wie beispielsweise durch thermische, chemische oder photolytische Methoden, zum entsprechenden Pigment überführt.

Zweckmässig liegt die Pigmentkonzentration der Tinte im allgemeinen im Bereich von 0,001 bis 75 Gew.-%, bevorzugt von 0,01 bis 50 Gew.-%, bezogen auf das Gesamtgewicht der Tinte.

Beispiele für polymere Dispergierungsmittel sind carbonsäuregruppenhaltige Polyacrylharze wie polymere Methacryl- oder Crotonsäuren, insbesondere solche, die durch Polymerisation von Acrylsäure oder Acrylsäure und anderen Acrylmonomeren wie Acrylsäureestern erhalten werden.

Je nach Anwendungsgebiet kann man gewünschtenfalls noch einen geringen Anteil eines wasserverdünnbaren organischen Lösungsmittels in 0,01 bis 30 Gew.-% bezogen auf das Gesamtgewicht der Tinte und/oder Wasser und und/oder Basen zumischen, so dass ein pH-Wert im Bereich von 7 bis 11 erreicht wird. Ebenfalls vorteilhaft kann es sein, der erfindungsgemässen Drucktinte je nach Anwendungsgebiet zum Beispiel noch Konservierungsmittel, Antischaummitel, Tenside, Uchtschutzmittel und pH -Regler zuzusetzen. Als pH Regler eignen sich beispielsweise anorganische Salze wie Lithiumhydroxid oder -carbonat, quartämeres Ammoniumhydroxid oder -carbonat. Beispiele für Konservierungs- und Antischaummittel sind zum Beispiel Natriumdehydroacetat, 2,2-Dimethyl-6-acetoxydioxan oder Ammoniumthioglykolat. Femer können bekannte, in US 5,106,417 beschriebene, die Viskosität oder die Oberfächenspannung regulierende Mittel, eingesetzt werden.

Wasserverdünnbare organische Lösungsmittel sind beispielsweise aliphatische C₁-C₄-Alkohole wie Methanol, Ethanol, n-Propanol, Isopropanol, n-Butanol, tert.-Butanol, Ketone wie Aceton Methyl-Ethylketon, Methyl-lsobutyiketon oder Diacetonalkohol, ferner Polyole, Cellosolve und Carbitole wie Ethylenglykol, Diethylenglykol, Triethylenglykol, Glycerin, Propylengylkol, Ethylenglykolmonomethyl- oder monoethylether, Propylenglykolmethylether, Dipropylenglykolmethylether, Tripropylenglykolmethylether, Ethylenglykolphenylether, Propylenglykolphenylether, Diethylenglykolmonomethyl- oder monoethylether, Diethylenglykolmonobutylether,Triethylenglykolmonomethyl- oder monoethylether, ferner N-Methyl-2-pyrrolidon, 2-Pyrrolidon, N,N'-Dimethylformaid oder N,N'-Dimethylacetamid.

Die Aufarbeitung wird nach den üblichen Methoden zur Aufarbeitung von Dispersionen durch Abtrennungsverfahren wie Sieben oder Zentrifugieren der Grobpartikel von der erhaltenen Dispersion, durchgeführt. Es hat sich als vorteilhaft erwiesen, in zwei Stufen unterschiedlicher Intensität zu zentrifugieren. Zuerst bei 10 Minuten bis 1 Stunde bei 2000 bis 4000 U/min und anschliessend bei 10 Minuten bis 1 Stunde bei 6000 bis 10000 U/min.

Nach der Zentrifugierung oder dem Sieben kann die Dispersion direkt als Tinte für beispielsweise den Tintenstrahldruck verwendet werden.

Die vorliegende Erfindung betrifft deshalb auch ein Verfahren zur Herstellung von Tinten, indem man hochmolekulares organisches Material und eine färberisch wirksame Menge der erfindungsgemässen dispersen Pigmentdispersion oder der Verbindungen der Formeln XXXIVc, XXXIVd oder XXXVa, oder der aus diesen Verbindungen erhältlichen Pigmentform, miteinander vermischt.

Ferner betrifft die vorliegende Erfindung die Verwendung eines erfindungsgemäss pigmentierten hochmolekularen Materials enthaltend die erfindungsgemässe Pigmentdispersion, insbesondere die Pigmentdispersionen enthaltend organische Lösungsmittel, zur Herstellung von Farbfiltem.

Ferner betrifft die vorliegende Erfindung ein Verfahren zur Herstellung von Farbfiltem enthaltend ein transparentes Substrat sowie darauf aufgebracht eine rote, blaue und grüne Schicht in beliebiger Reihenfolge, indem man zur Herstellung der roten, blauen und grünen Schichten je eine entsprechend gefärbte erfindungsgemässe Pigmentdispersion verwendet, oder diese Schichten eine entsprechende gefärbte Verbindung XXXIVc, XXXIVd oder XXXVa oder aus einer Verbindung XXXIVc, XXXIVd oder XXXVa erhältliche Pigmentform oder eine erfindungsgemässe Zusammensetzung enthält.

Bevorzugt weisen die verschiedenfarbigen Schichten derartige Muster auf, dass sie auf mindestens 5% ihrer Fläche nicht überlappen und ganz besonders bevorzugt nicht überlappen.

Die Herstellung sowie Verwendung von Farbfilter oder bunt pigmentierten hochmolekularen organischen Materialien werden in Displays 14/2,1151 (1993), oder Journal of the SID 1/3, 341-346 (1993) oder an der IDW'95 (Beitrag CF-3, Seiten 57-60 der gedruckten Fassung) oder Journal of Photopolymer Science and Technology 9/1, 109-120 (1196) sowie in Nippon Steel Corp., Application JP 09176511-A, Primary Accession No. 97-399776/37, Pigment dispersion compositions for colour resist inks, Asahi Glass Co. Ltd., Application JP 09132740-A, Primary Accession No. 97-328594/30., Ink for ink jetting and substrate with colour filter, and Fuji Pigment Co. Ltd., EP 784085-A2, Primary Accession No. 97-352867/33, An ink composition for inkjet application and production of coloured filters, sowie in Canon KK, Application JP 08327811-A, Primary Accession No. 97-090690/09, wo die Herstellung von Farbfiltern und Flüssigkristall-Displays beschrieben ist, beschrieben.

Die Farbfilter lassen sich beispielsweise unter Verwendung von Tinten, insbesondere Drucktinten, die die erfindungsgemässen Pigmentdispersionen enthalten, oder beispielsweise durch Vermischung einer erfindungsgemässen Pigmentdispersion mit chemisch, thermisch oder photolytisch strukturierbarem hochmolekularem Material (resist) herstellen. Die weitere Herstellung kann man beispielsweise analog EP-A 654 711 durch Aufbringen auf ein Substrat, wie beispielsweise ein LCD, anschliessende Photostrukturierung und Entwickeln durchführen.

Besonders bevorzugt für die Herstellung von Farbfiltern sind die erfindungsgemässen Pigmentdispersionen, die nicht-wasserhaltige Lösungsmittel oder Dispersionsmedien für Polymere besitzen.

Des weiteren umfasst die Erfindung transparentes Substrat, das mit je einer roten, blauen und grünen Schicht je einer entsprechend gefärbten erfindungsgemässen Pigmentdispersion oder einer Verbindung XXXIVc, XXXIVd oder XXXVa oder der aus einer Verbindung XXXIVc, XXXIVd oder XXXVa erhältlichen Pigmentform oder einer erfindungsgemässen Zusammensetzung, enthaltend pigmentiertes hochmolekulares organisches Material, beschichtet ist. Die Reihenfolge der Beschichtung spielt in der Regel keine Rolle. Bevorzugt weisen die verschiedenfarbigen Schichten derartige Muster auf, dass sie auf mindestens 5% ihrer Fläche nicht überlappen, besonders bevorzugt nicht überlappen.

Ferner umfasst die vorliegende Erfindung auch Farbfilter, enthaltend ein transparentes Substrat sowie darauf aufgebracht eine rote, blaue und grüne Schicht je erhältlich aus einer entsprechend gefärbten erfindungsgemässen Pigmentdispersion oder einer Verbindung XXXIVc, XXXIVd oder XXXVa oder enthaltend die aus einer Verbindung XXXIVc, XXXIVd oder XXXVa erhältliche Pigmentform oder eine erfindungsgemässe Zusammensetzung.

Zudem betrifft die vorliegende Erfindung Toner enthaltend eine erfindungsgemässe Pigmentdispersion oder eine Verbindung XXXIVc, XXXIVd oder XXXVa oder die aus einer Verbindung XXXIVc, XXXIVd oder XXXVa erhältliche Pigmentform oder eine erfindungsgemässe Zusammensetzung, enthaltend pigmentiertes hochmolekulares organisches Material in einer färberisch wirksamen Menge.

Ausserdem betrifft die vorliegende Erfindung Verfahren zur Herstellung von Toner, indem man ein hochmolekulares organisches Material und eine färberisch wirksame Menge der erfindungsgemässen dispersen Pigmentdispersion oder der Verbindung der Formeln XXXIVc, XXXIVd oder XXXVa, oder der aus diesen Verbindungen erhältlichen Pigmentform Pigmentform oder eine erfindungsgemässe Zusammensetzung, enthaltend pigmentiertes hochmolekulares Material, miteinander vermischt.

In einer besonderen Ausführungsform des erfindungsgemässen Verfahrens werden Toner, Lacke, Tinten oder gefärbte Kunststoffe hergestellt, indem man in Masterbatches unter Verwendung von Walzwerken, Misch- oder Mahlapparaten vermischt.

Ferner betrifft die vorliegende Erfindung Farbmittel enthaltend eine erfindungsgemässe Pigmentdispersion oder eine Verbindung XXXIVc, XXXIVd oder XXXVa oder die aus einer Verbindung XXXIVc, XXXIVd oder XXXVa erhältliche Pigmentform oder eine erfindungsgemässe Zusammensetzung, enthaltend pigmentiertes hochmolekulares organisches Material in einer färberisch wirksamen Menge.

Des weiteren betrifft die vorliegende Erfindung gefärbte Kunstoffe oder polymere Farbpartikel enthaltend eine erfindungsgemässe Pigmentdispersion oder eine Verbindung XXXIVc, XXXIVd oder XXXVa oder die aus einer Verbindung XXXIVc, XXXIVd oder XXXVa erhältliche Pigmentform oder eine erfindungsgemässe Zusammensetzung, enthaltend pigmentiertes hochmolekulares organisches Material in einer färberisch wirksamen Menge.

Ausserdem betrifft die vorliegende Erfindung non-impact-printing Material, enthaltend eine erfindungsgemässe Pigmentdispersion oder eine Verbindung XXXIVc, XXXIVd oder XXXVa oder die aus einer Verbindung XXXIVc, XXXIVd oder XXXVa erhältliche Pigmentform oder eine erfindungsgemässe Zusammensetzung, enthaltend pigmentiertes hochmolekulares organisches Material in einer färberisch wirksamen Menge.

Zudem betrifft die vorliegende Erfindung ein Verfahren zur Herstellung von non-impact-printing Material, indem man ein hochmolekulares organisches Material und eine färberisch wirksame Menge der erfindungsgemässen dispersen Pigmentdispersion oder der Verbindung der Formeln XXXIVc, XXXIVd oder XXXVa, oder der aus diesen Verbindungen erhältlichen Pigmentform Pigmentform oder eine erfindungsgemässe Zusammensetzung, enthaltend pigmentiertes hochmolekulares Material, miteinander vermischt.

Eine färberisch wirksame Menge der erfindungsgemässen dispersen Pigmentdispersion oder der Verbindung der Formeln XXXIVc, XXXIVd oder XXXVa, oder der aus diesen Verbindungen erhältlichen Pigmentform Pigmentform oder eine erfindungsgemässe Zusammensetzung, enthaltend pigmentiertes hochmolekulares Material, bedeutet in der Regel 0.0001 bis 99,99 Gew.-%, bevorzugt 0,001 bis 50 Gew.-% und besonders bevorzugt 0,01 bis 50 Gew.-% bezogen auf das Gesamtgewicht des damit pigmentierten Materials.

Es wurde nun gefunden, dass mit dem erfindungsgemässen Verfahren sehr feine Pigmentdispersionen ohne hohen Energie-, Zeit- und Apparatebedarf, wie sie bei Mahl- und Verdampfungstechniken benötigt werden, hergestellt werden. Die Pigmentdispersionen, zeichnen sich durch hohe Stabilität und Transparenz aus und besitzen hervorragende koloristische und anwendungstechnische Eigenschaften. Sie eignen sich insbesondere für die Herstellung von Tinten sowie Farbfilter, die hohe Farbstärken, Brillanz und Transparenz aufweisen.

Die nachfolgenden Beispiele erläutern die Erfindung.

### Beispiel 1:

### Herstellung von carboxylgruppenhaltigen Copolymeren:

In einem Kolben mit hermetisch versiegeltem Rührwerk wird 8,5 g Vinylbenzoesäure in 50 g Dioxan gelöst. Eine Mischung von 20 g Vinyltoluol und 40 g Styrol wird beigefügt. In dieser Mischung wird 0,75 g des Initiators 4,4'-Azobis(4-cyanpentansäure) gelöst. Dazu werden 500 mg Dodecylmercaptan gegeben. Die Mischung wird durch Einleiten von Stickstoff von Sauerstoff befreit und anschliessend 6 Stunden bei 70°C gehalten. Die viskose Lösung wird zur Ausfällung des Produktes in 1 Liter kaltes Methanol gegossen. Nach Dekantieren des Methanols wird das Polymere mit einer weiteren Portion Methanol gewaschen. Schliesslich wird das Polymere in einem Exikator über Kaliumhydroxid getrocknet. Das Polymere hat eine Molmasse (Zahlmittelwert) von 16000, bestimmt durch Gel-Permeationschromatographie. Das Verhältnis Mw/Mn (Massenmittelwert/Zahlmittelwert) beträgt 1,94.

### Beispiel 2:

### Herstellung einer erfindungsgemässen Dispersion:

200 mg des Latentpigments N,N'-Bis-tert.-butoxycarbonyl-1,4-diketo-3-phenyl-6-(4-tert.butylphenyl)-pyrrolo[3,4-c]pyrrol, erhältlich nach dem Verfahren, dass im Beispiel 1 des US-5,484,943 beschrieben ist, wird in 10 ml 1,4-Dioxan gelöst, und 1 g Octadecen-Maleinsäureanhydrid Copolymer (MW 50000, von Scientific Polymer Products Inc.) in 20 ml Dioxan gelöst. Die Latentpigmentlösung wird zu der Polymerlösung gegeben und die entstandene gelbe Mischlösung am Rotationsverdampfer unter vermindertem Druck und einer maximalen Temperatur von 60°C zur Trockene eingedampft. Das resultierende Feststoffgemisch wird im Vakuum während 14 Stunden bei 60 °C getrocknet und anschliessend für 2 Stunden in einem vorgeheizten Ofen einer Temperatur von 140°C ausgesetzt. Nach dieser Hitzebehandlung ändert die Farbe des Feststoffgemisches von gelb nach rot. Das Feststoffgemisch wird auf Raumtemperatur abgekühlt und mit 20 ml Dioxan versehen. Durch Ultraschallbehandlung wird das Polymer gelöst, während das generierte Pigment dispergiert wird. Zur entstandenen Dispersion werden nacheinander 700 Mikroliter Morpholin und 20 ml Wasser zugefügt. Nach Vermischung wird Dioxan am Rotationsverdampfer bei vermindertem Druck abdestilliert, und die rote Dispersion auf 20,7 g aufkonzentriert. Die resultierende Dispersion ist homogen und transparent. Sie besitzt eine Viskosität von 2,16 mPas bei 25°C. Nach mehreren Tagen ist keine Fällungstendenz zu beobachten.

### Beispiel 3:

### Herstellung einer erfindungsgemässen Dispersion:

700 mg des Latentpigments N,N'-Bis-tert.-butoxycarbonyl-1,4-diketo-3,6-bis-p-chlorophenylpyrrolo[3,4-c]pyrrol, hergestellt analog US-5,484,943, wird in 15 ml 1,4-Dioxan gelöst, und 1,5 g Styrol-Vinyltoluol-Vinylbenzoesäure Copolymer (hergestellt analog Beispiel1) in 20 ml Dioxan gelöst. Die Latentpigmentlösung wird zu der Polymerlösung gegeben und die entstandene gelbe Mischlösung am Rotationsverdampfer unter vermindertem Druck (<1mPa) und einer maximalen Temperatur von 60°C während einer Stunde zur Trockene eingedampft. Das Feststoffgemisch wird in einem vorgeheizten Ofen eine Stunde lang einer Temperatur von 140°C ausgesetzt. Nach dieser Hitzebehandlung ändert die Farbe des Feststoffgemisches von gelb nach rot. Das Feststoffgemisch wird auf Raumtemperatur abgekühlt und mit 20 ml Dioxan versehen. Durch Ultraschallbehandlung wird das Polymer gelöst, während das generierte Pigment dispergiert wird. Zur entstandenen Dispersion werden nacheinander 2 ml Morpholin und 30 ml Wasser zugefügt. Nach Vermischung wird Dioxan am Rotationsverdampfer bei vermindertem Druck abdestilliert, und die rote Dispersion auf 20 g aufkonzentriert. Die resultierende Dispersion ist homogen und transparent. Sie besitzt eine Viskosität von 6 mPas bei 25°C. Nach mehreren Tagen ist keine Fällungstendenz zu beobachten.

### Beispiel 4:

### Herstellung einer erfindungsgemässen Dispersion:

Das Latentpigment der Formel

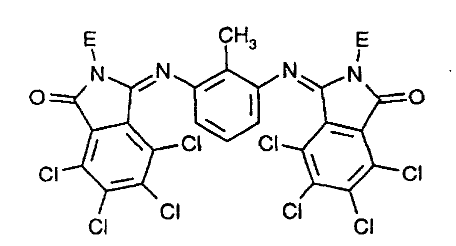

E = H oder CO₂C(CH₃)₂CH₂O(CH₂)₂OCH₃ XXXVII,

wird analog bekannten Verfahren hergestellt. Die Vorläuferverbindung der Formel 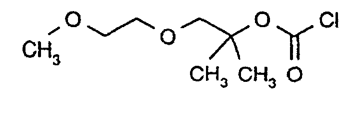 ist analog US Patent 2 886 600 erhältlich. Nach bekannten Verfahren (Houben Weyl Band 8, S 101 ff) wird dieses Produkt mit Phosgen zum Produkt der Formel 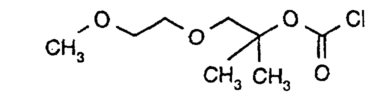 umgesetzt, welches dann weiter mit einem Pigment der Formel XXXVII, worin E die Bedeutung von H besitzt, in Gegenwart eines Deprotonierungskatalysators umgesetzt wird. Man erhält die Verbindung der Formel XXXVII, worin E die Bedeutung von CO₂C(CH₃)₂CH₂O(CH₂)₂OCH₃ besitzt.

500 mg des Latentpigments der Formel XXXVII wird in 15 ml 1,4-Dioxan gelöst und mit einer Lösung von 1,5 g des in Beispiel 1 beschriebenen Copolymers in 20 ml Dioxan vermischt. Die klare gelbe Lösung wird am Vakuum-Rotationsverdampfer zur Trockene eingedampft und anschliessend in einem Trockenschrank bei ca. 200 Torr und 60°C 15 Stunden weitergetrocknet. Das resultierende Produkt wird dann in einem Umlufttrockenschrank 2 Stunden auf 140°C erhitzt. Nach Abkühlung wird 20 ml Dioxan beigegeben und durch Ultraschall-Behandlung das Polymer aufgelöst und gleichzeitig das regenerierte Pigment dispergiert. Zu der Dispersion werden 2 ml Morpholin und 30 ml Wasser gegeben. Anschliessend wird das Dioxan abgedampft und die Dispersion auf 20 g aufkonzentriert, entsprechend einer Pigmentkonzentration von 1,63 Gewichtsprozent. Die resultierende leuchtend gelbe Dispersion weist bei 25°C eine Viskosität von 3,1 mPas auf. Eine Probe wird mit Wasser 25fach verdünnt und das Transmissions-Spektrum in einer 1 mm-Küvette vermessen. Beim Maximum (Lichtwellenlänge 420 nm) beträgt die Absorption 2,09, während sie bei 600 nm nur 0,1 beträgt, was auf feine Partikel mit guter Transparenz hinweist. Elektronenmikroskop-Aufnahmen zeigen zusätzlich, dass alle Teilchenabmessungen unter 0,5 Mikrometer liegen.

### Beispiel 5:

### Herstellung des Latentpigmentes der Formel

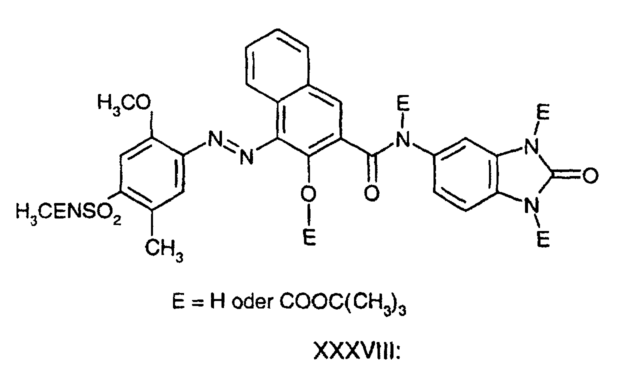

Zu einer Suspension von 10 g (17,8 mmol) XXXVIII, worin E die Bedeutung von H besitzt, C.I. Pigment Rot 185, in 250 ml Tetrahydrofuran werden 1,53 g (12,5 mmol) Dimethylaminopyridin und 27,25 g (125 mmol) Di-tert-butyldicarbonat gegeben. Nach Rühren über Nacht bei Raumtemperatur wird die Reaktionsmischung über MgSO₄ filtriert, und das Filtrat aufkonzentriert. Das Konzentrat wird mit Hexan verdünnt, intensiv vermischt und das ausgefallene Rohprodukt filtriert, mit Hexan gewaschen und anschliessend getrocknet. Durch Filtration über 500 g Silicagel und Eluierung des Produktes mit Methylenchlorid/Essigsäureethylester (29:1) werden 12,6 g (Ausbeute von 67% der Theorie) reines Produkt, XXXVIII, worin E die Bedeutung von COOC(CH₃)₃ besitzt, als bordeauxrotes Pulver isoliert.

| Mikroanalyse: | | | | |
|---|---|---|---|---|
| erwartet | %C 58,46, | %H 6,00, | %N 8,36, | %S 3,12 |
| gefunden | %C 58,39, | %H 6,15, | %N 8,01, | %S 3,06 |

Die thermogravimetrische Analyse des Zerfalls zeigt eine mittlere Zerfallstemperatur von 164,0°C;
ΔM_{theoretisch}= 46,6%, ΔMₑₓₚₑᵣᵢₘₑₙₜᵢₑₗₗ= 43,5%,

### Beispiel 6:

### Herstellung einer erfindungsgemässen Dispersion:

500 mg des Latentpigments der Formel XXXVIII, dass, wie in Beispiel 5 beschrieben, hergestellt wird, wird in 15 ml 1,4-Dioxan gelöst und mit einer Lösung von 1,5 g eines Copolymeren von 75% Styrol und 25% Maleinsäureanhydrid (Säurezahl 275, von Scientific Polymer Products Inc.) in 20 ml Dioxan vermischt. Die klare Lösung wird am Vakuum-Rotationsverdampfer zur Trockene eingedampft und anschliessend in einem Trockenschrank bei 200 Torr und 60°C 15 Stunden weitergetrocknet. Das resultierende Produkt wird dann in einem Umlufttrockenschrank 2 Stunden auf 140°C erhitzt. Nach Abkühlung wird 20 ml Dioxan beigegeben und durch Ultraschallbad-Behandlung das Polymer aufgelöst, und gleichzeitig das regenerierte Pigment dispergiert. Zu der Dispersion werden 1,5 ml Morpholin und 30 ml Wasser gegeben. Anschliessend wird das Dioxan abgedampft, und die Dispersion auf 20 g aufkonzentriert, entsprechend einer Pigmentkonzentration von 1,33 Gewichtsprozent bezogen auf das Gesamtgewicht der Dispersion. Die resultierende blaurote Dispersion weist bei 25°C eine Viskosität von 4,5 mPas auf. Eine Probe wird mit Wasser 40fach verdünnt und das Transmissions-Spektrum in einer 1 mm-Küvette vermessen. Beim Maximum (520 nm) beträgt die Absorption 1,42, während sie bei 660 nm nur 0,1 beträgt, was auf feine Partikel mit guter Transparenz hinweist. Elektronenmikroskop-Aufnahmen zeigen zusätzlich, dass alle Teilchenabmessungen unter 0,5 Mikrometer liegen.

### Beispiel 7:

### Herstellung des Latentpigmentes der Formel

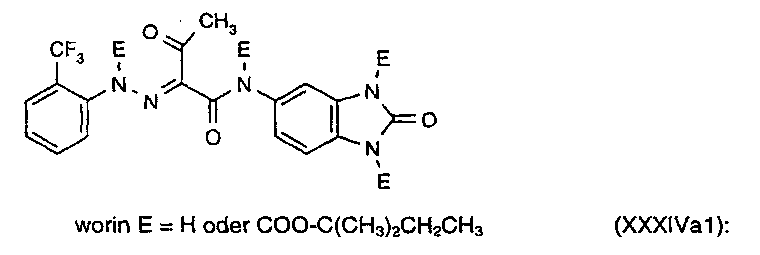

Zu einer Suspension von 10 g (24,7 mmol), des obigen Pigments, worin E die Bedeutung von H besitzt, C.I. Pigment Gelb 154, in 80 ml Tetrahydrofuran werden 1,75 g (14,4 mmol) Dimethylaminopyridin und 35,4 g (143 mmol) Di-tert-amyldicarbonat gegeben. Nach Rühren über Nacht bei Raumtemperatur wird die Reaktionsmischung über Kieselgel filtriert, und das Filtrat aufkonzentriert. Das Konzentrat wird mit Methanol/Wasser verdünnt, über Kieselguhr filtriert, und das ausgefallene Rohprodukt filtriert, und dann über Silicagel mit Methylenchlorid/Essigsäureethylester gewaschen und anschliessend getrocknet. Es werden (Ausbeute von 49% der Theorie) reines Produkt, worin E die Bedeutung von COOC(CH₃)₂CH₂CH₃ besitzt, als rotes Pulver isoliert.

| Mikroanalyse: | | | |
|---|---|---|---|
| erwartet | %C 58,53 | %6,31, | %N 8,13, |
| gefunden | %C 58,8, | %H 6,3, | %N 8,63, |

Die thermogravimetrische Analyse des Zerfalls zeigt eine mittlereTemperatur von 152,9°C;
ΔM_{theoretisch}= 49,9%, ΔMₑₓₚₑᵣᵢₘₑₙₜᵢₑₗₗ= 49,5%.

### Beispiel 8:

### Herstellung einer erfindungsgemässen Dispersion:

800 mg des Latentpigments der Formel XXXIVa1, dass, wie in Beispiel 7 beschrieben, hergestellt wird, wird in 15 ml 1,4-Dioxan gelöst und mit einer Lösung bestehend aus 1,5 g des, in Beispiel 1 beschriebenen, Copolymers und 15 ml Dioxan vermischt. Die klare Lösung wird am Vakuum-Rotationsverdampfer zur Trockene eingedampft und anschliessend in einem Trockenschrank bei ca. 200 Torr und 60°C 15 Stunden weitergetrocknet. Das resultierende Produkt wird dann in einem Umlufttrockenschrank 2 Stunden auf 140°C erhitzt. Nach Abkühlung wird 20 ml Dioxan beigegeben, und durch Ultraschall-Behandlung das Polymer aufgelöst und gleichzeitig das regenerierte Pigment dispergiert. Zu der Dispersion werden 1,5 ml Morpholin und 25 ml Wasser gegeben. Anschliessend wird das Dioxan abgedampft und die Dispersion auf 20 g aufkonzentriert, entsprechend einer Pigmentkonzentration von 1,88 Gewichtsprozent bezogen auf das Gesamtgewicht der Dispersion. Die resultierende leuchtend gelbe Dispersion weist bei 25°C eine Viskosität von 3,8 mPas auf. Eine Probe wird mit Wasser 40fach verdünnt und das Transmissions-Spektrum in einer 1 mm-Küvette vermessen. Beim Maximum (Lichtwellenlänge 346 nm) beträgt die Absorption 1,86, während sie bei 600 nm nur 0,05 beträgt, was auf feine Partikel mit guter Transparenz hinweist. Transmissions-Elektronenmikroskop-Aufnahmen zeigen zusätzlich, dass alle Teilchenabmessungen unter 0,1 Mikrometer liegen.
Die Dispersion ist stabil gegen Flockierung und Sedimentation.

### Beispiel 9:

### Herstellung des Latentpigmentes der Formel

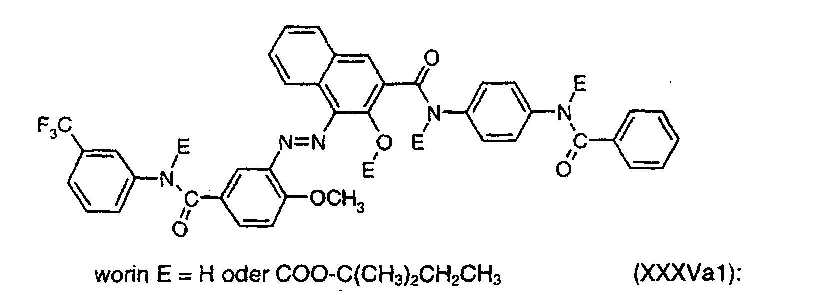

Zu einer Suspension von 50 g (71,1 mmol), des obigen Pigments, worin E die Bedeutung von H besitzt, C.I. Pigment Rot 222, dessen Herstellung in US 3,394,123 beschrieben ist, in 1 L Tetrahydrofuran werden 4,4 g (36 mmol) Dimethylaminopyridin und 88,7 g (0,36 mol) Di-tert-amyldicarbonat gegeben. Nach Rühren über Nacht bei Raumtemperatur wird die Reaktionsmischung über Kieselgel filtriert, und das Filtrat aufkonzentriert. Das Konzentrat wird mit Hexan verdünnt, intensiv vermischt und das ausgefallene Rohprodukt filtriert, mit Hexan gewaschen und anschliessend getrocknet. Es werden (Ausbeute von 31,9% der Theorie) reines Produkt, XXXVa1, worin E die Bedeutung von COOC(CH₃)₂CH₂CH₃ besitzt, als rotes Pulver isoliert.

| Mikroanalyse: | | | |
|---|---|---|---|
| erwartet | %C 65,48, | %H 5,70, | %N 6,68, |
| gefunden | %C 65,45, | %H 5,59, | %N 6,69, |

Die thermogravimetrische Analyse des Zerfalls zeigt eine mittlere Zerfallstemperatur von 160,0°C;
ΔM_{theoretisch}= 32,7%, ΔMₑₓₚₑᵣᵢₘₑₙₜᵢₑₗₗ= 31,9%.

### Beispiel 10:

1,33 g des nach Beispiel 9 hergestellten Latentpigments XXXVa1, gelöst in 40 ml Dioxan, werden mit 10 g einer Lösung vermischt, welche 40 Gew.-% eines Copolymeren von Benzylmethacrylat und Acrylsäure, gelöst in Methoxypropylacetat, enthält. Dieses Copolymere ist unter der Bezeichnung FFI87 bei Fuji Photo Film (Japan) erhältlich. Die Mischung wird bei 60° C unter reduziertem Druck zur Trockene eingedampft und anschliessend 2 Stunden auf 150°C erhitzt. Nach Abkühlung wird der Festkörper in 30 ml Dioxan redispergiert, und anschliessend 6,5 g N,N'-Dimethylaminoethanol und 40 ml Wasser beigefügt, und die homogene Dispersion wird am Vakuum-Rotationsverdampfer auf 33 g eingeengt. Man erhält einen flockulationsstabile Dispersion mit einem Pigmentgehalt von 2,7 Gew.-% bezogen auf die Gesamtmasse. Eine Probe der Dispersion wird mit Wasser 100fach verdünnt und das Transmission-Spektrum in einer 1mm-Küvette vermessen. Beim Maximum (Lichtwelle 572 nm) beträgt die Absorption 1,21, während sie bei 650 nm unter 0,1 liegt, was auf feine Partikel mit guter Transparenz hinweist

Die nachfolgenden Beispiele erläutern die Verwendungen der erfindungsgemässen Dispersionen zur Herstellung von Tinten für Tintenstrahldrucker.

### Beispiel 11:

2,8 g der Pigmentdispersion des Beispiels 2 werden mit 0,7 g einer 2%igen(Gewichtsprozent) Lösung eines oberflächenaktiven Stoffes (Fluorad FC-171 von 3M Inc.) gelöst in Diethylenglycol vermischt. Getestet wird die resultierende Tinte in einem thermischen Tintenstrahldrucker "QuietJet" (Hewlett-Packard), der mit einer zur Aufnahme der Tinte vorgesehenen Plastikvorrichtung ausgestattet ist. Es wird eine klare deutliche Druckqualität sowie eine Oberflächendeckung mit einer maximalen optischen Dichte von 0,5 erhalten (gemessen wird dieser Wert mit einem Spektrophotometer im Reflektionsmode, der von der Reflektion des Papiers subtrahiert wird. Die Tinte zeigt keine Tendenz zum "Ausbluten" oder Durchdringung durch handelsübliches Kopierpapier.

### Beispiel 12:

10 g der Pigmentdispersion des Beispiels 3 werden mit 0,8 g einer 2%igen (Gewichtsprozent) Lösung aus einem oberflächenaktiven Stoff (Fluorad FC-171 von 3M Inc.) und Diethylenglycol sowie mit 1,2 g Diethylenglycol, 0,5 g 2-Propanol, 0,2 g Morpholin un d 0,2 g Butylsulfoxid vermischt. Getestet wird die resultierende Tinte in einem thermischen Tintenstrahldruckler "QuietJet" (Hewlett-Packard), der mit einer zur Aufnahme der Tinte vorgesehenen Plastikvorrichtung versehen ist. Es wird eine klare deutliche Druckqualität sowie eine Oberflächendeckung mit einer maximalen optischen Dichte von 1,09 erhalten (gemessen wird dieser Wert mit einem Spektrophotometer im Reflektionsmode, der von der Reflektion des Papiers subtrahiert wird.
Die Tinte zeigt keine Tendenz zum "Ausbluten" oder Durchdringung durch handelsübliches Kopierpapier.

### Beispiel 13:

10 g der Dispersion nach Beispiel 4, 1 g einer 2% igen Lösung von Fluorad FC-171 (3M Inc.), 1 g Diethylenglycol, 0,3 g 2-Propanol und 80 mg Butylsulfoxid werden gemischt ohne Anwendung hoher Scherkräfte oder Trennverfahren. Unter Verwendung dieser Tinte werden mit einem thermischen Tintenstrahldrucker "QuietJet' von Hewlett-Packard Probestreifen ausgedruckt. Die densitometrisch (Macbeth Model 924) gemessene optische Reflexionsdichte der Farbfläche beträgt 0,69 für den Blau-Kanal. Es wird auch bei längerem Drucken kein Verstopfen der Tintenstrahl-Düsen beobachtet. Drei Monate nach Herstellung der Tinte nach Beispiel 13, ist diese noch frei von Flockung.

## Patentansprüche

1. Verfahren zur Herstellung von Pigmentdispersionen aus einem Pigment, einem Polymer und einem Lösungsmittel, **dadurch gekennzeichnet, dass** man
a1) eine Mischung A, enthaltend ein Latentpigment und ein Polymer, thermisch, chemisch oder photolytisch behandelt und
b) danach mit einem Lösungsmittel versetzt,
oder
a2) eine Mischung B, enthaltend ein Latentpigment, ein Polymer und ein Lösungsmittel, thermisch, chemisch oder photolytisch behandelt.

2. Verfahren gemäss Anspruch 1, **dadurch gekennzeichnet, dass** man die Mischung A in einem Extruder thermisch behandelt.

3. Verfahren zur Herstellung von Pigmentdispersionen aus einem Pigment und einem Polymer, **dadurch gekennzeichnet, dass** man
c1) eine Mischung, enthaltend ein Latentpigment, ein Polymer und einem Lösungsmittel herstellt,
c2) anschliessend aus der so erhaltenen Mischung das Lösungsmittel entfernt, und
c3) danach die lösungsmittelfreie Mischung A thermisch, chemisch oder photolytisch behandelt, und
c4) dann die behandelte Mischung mit einem Lösungsmittel versetzt.

4. Verfahren zur Herstellung von Pigmentdispersionen aus einem Pigment und einem Polymer, **dadurch gekennzeichnet, dass** man
d1) eine Mischung B, enthaltend ein Latentpigment, ein Polymer und ein Lösungsmittel herstellt, und
d2) anschliessend aus der so erhaltenen Mischung das Lösungsmittel teilweise entfernt, und
d3) danach die so erhaltene Mischung thermisch, chemisch oder photolytisch behandelt.

5. Verfahren gemäss einem der Ansprüche 1 bis 4, **dadurch gekennzeichnet, dass** man die Mischungen A oder B in einem Temperaturbereich von 100 bis 200°C während einer Stunde bis 36 Stunden thermisch behandelt.

6. Verfahren gemäss einem der Ansprüche 1 bis 5, **dadurch gekennzeichnet, dass** man
a) die thermisch, chemisch oder photolytisch behandelte Mischung mit einem organischen Lösungsmittel, insbesondere mit einem mit Wasser mischbaren organischen Lösungsmittel, mischt und
b) anschliessend durch Zusatz einer wasserhaltigen Lösung, enthaltend eine Base, den pH-Wert auf ≥ 7 einstellt.

7. Verfahren gemäss einem der Ansprüche 1 bis 6, **dadurch gekennzeichnet, dass** Latentpigmente der Formel I
A(B)ₓ, (I),
worin
x eine Zahl von 1 bis 8 bedeutet, und
A für den Rest eines Chromophors der Anthrachinon-, Azo-, Benzimidazolon-, Chinacridon-, Chinophthalon-, Diketopyrrotopyrrol-, Dioxazin-, Indanthron-, Indigo-, Isoindolin-, Isoindolinon-, Perylen-, und Phthalocyaninreihe steht, der über ein Heteroatom oder mehrere Heteroatome mit x Gruppen B verbunden ist, wobei diese Heteroatome aus der Gruppe bestehend aus N, O oder S ausgewählt sind und einem Teil des Restes A bilden,
und
B für einen Rest, ausgewählt aus der Gruppe bestehend aus den Formeln II-V 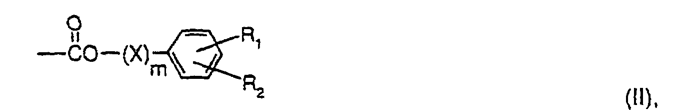 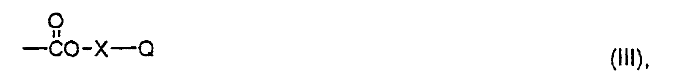 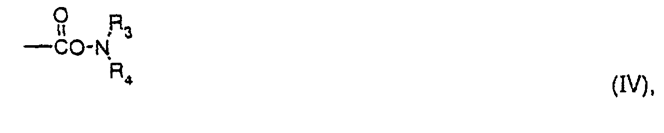 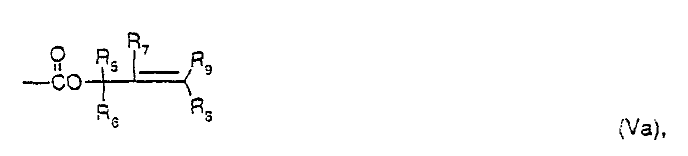 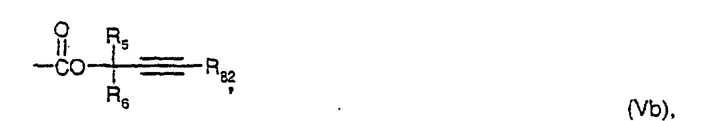 und Wasserstoff, wobei mindestens ein Rest B nicht für Wasserstoff steht,
wobei in den Formeln II, III, IV oder Va oder Vb
m Null oder 1 bedeutet,
X unsubstituiertes oder einfach oder mehrfach durch C₁-C₆-Alkyl oder R₅ und R₆ substituiertes C₁-C₆-Alkylen oder C₂-C₅-Alkenylen ist,
oder
R₁ und R₂ unabhängig voneinander Wasserstoff, C₁-C₆-Alkyl, Alkoxy, Halogen, Cyano, Nitro, N(C₁-C₆-Alkyl)₂, unsubstituiertes oder durch Halogen. Cyano, Nitro, C₁-C₆-Alkyl oder C₁-C₆- Alkoxy substituiertes Phenyl bedeuten, und
Q Wasserstoff, C₁-C₆-Alkyl, CN, CCl₃, eine Gruppe 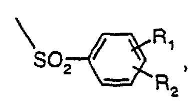 SO₂CH₃ oder SCH₃, und
R₃ und R₄ unabhängig voneinander Wasserstoff, C₁-C₄-Alkyl oder eine Gruppe 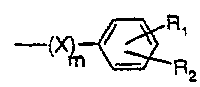 bedeuten,
oder R₃ und R₄ zusammen einen Piperidinylrest bilden, und
R₅ und R₆ unabhängig voneinander Wasserstoff, C₁-C₂₄- Alkyl, durch O, S oder, mit C₁-C₆-Alkyl disubstituiertes, N unterbrochenes C₁-C₂₄-Alkyl, C₃-C₂₄-Alkenyl, C₃-C₂₄-Alkinyl, C₄-C₁₂-Cycloalkyl, C₄-C₁₂-Cycloalkenyl, unsubstituiertes oder durch C₁-C₆-Alkyl, C₁-C₆-Alkoxy, Halogen, Cyano oder Nitro substituiertes Phenyl oder Biphenyl bedeuten,
R₇, R₈ und R₉ unabhängig voneinander Wasserstoff, C₁-C₂₄-Alkyl oder C₃-C₂₄Alkenyl sind,
R₈₂ Wasserstoff, C₁-C₆-Alkyl oder eine Gruppe der Formel 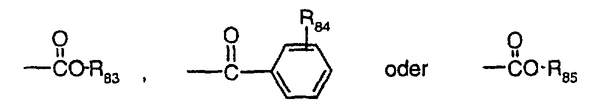 bedeutet,
R₈₃ C₁-C₆-Alkyl,
R₈₄ Wasserstoff oder C₁-C₆-Alkyl und
R₈₅ Wasserstoff, C₁-C₆-Alkyl, unsubstituiertes oder durch C₁-C₆-Alkyl substituiertes Phenyl bedeuten, oder
B eine Gruppe der Formel 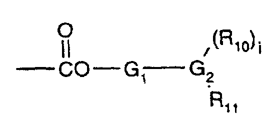 ist, worin
G₁ unsubstituiertes oder einfach oder mehrfach mit C₁-C₁₂Alkyl, C₁-C₁₂Alkoxy, C₁-C₁₂Alkylthio oder C₂-C₂₄Dialkylamino substituiertes p, q-C₂-C₁₂Alkylen ist, wobei p und q unterschiedliche Positionszahlen sind,
G₂ für ein Heteroatom ausgewählt aus der Gruppe bestehend aus N, O oder S, steht, und
worin,
i, wenn G₂ gleich O oder S ist, die Zahl 0 und, wenn G₂ gleich N ist, die Zahl 1 bedeutet, und
R₁₀ und R₁₁ unabhängig voneinander unsubstituiertes oder einfach oder mehrfach mit C₁-C₁₂Alkoxy, C₁-C₁₂Alkylthio, C₂-C₂₄Dialkylamino, C₆-C₁₂Aryloxy, C₆-C₁₂Arylthio, C₇-C₂₄ Alkylarylamino oder C₁₂-C₂₄ Diarylamino substituiertes C₁-C₁₂Alkyl oder [-(p',q'-C₂-C₁₂Alkylen)-R₁₂-]ᵢᵢ-C₁-C₁₂Alkyl sind,
worin
ii eine Zahl von 1 bis 1000 ist, p' und q' unterschiedliche Positionszahlen sind,
R₁₂ unabhängig von den anderen ein Heteroatom O, S oder C₁-C₁₂Alkyl substituiertes N bedeutet, und C₂-C₁₂Alkylen in den sich wiederholenden Einheiten [C₂-C₁₂Alkylen-R₁₂] gleich oder verschieden sein kann, und
R₁₀ und R₁₁ gesättigt oder 1-bis 10-mal ungesättigt sind, ununterbrochen oder an beliebigen Stellen durch 1 bis 10 Gruppen, ausgewählt aus der Gruppe bestehend aus -(C=O)- und -C₆H₄-, unterbrochen sind, und keine oder 1 bis 10 weitere Substituenten wie Halogen, Cyano oder Nitro tragen können, mit der Massgabe, dass, wenn -G₁-gleich -(CH₂)ᵢᵥ- ist, worin
iv eine Zahl von 2 bis 12 bedeutet, und G₂ gleich S ist, R₁₁ nicht unsubstituiertes, gesättigtes und ununterbrochenes C₁-C₄Alkyl ist.

8. Verfahren nach einem der Ansprüche 1 bis 7, **dadurch gekennzeichnet, dass** Latentpigmente folgende Verbindungen der Formel (I) bedeuten können: Perylencarbonsäureimide der Formeln VIa oder Vlb 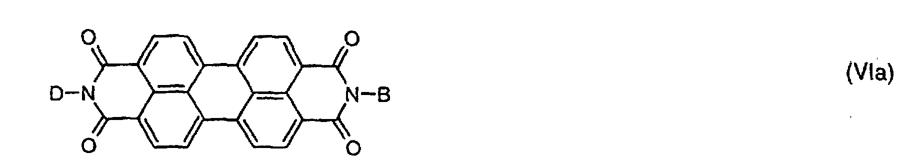 oder 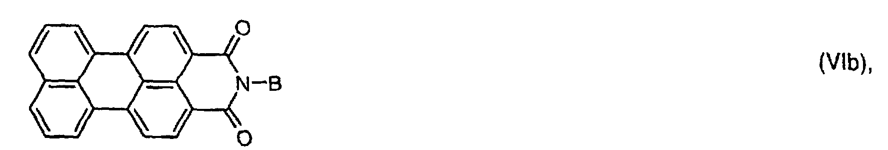 worin D Wasserstoff, C₁-C₆-Alkyl, unsubstituiertes oder durch Halogen oder C₁-C₆-Alkyl substituiertes Phenyl, Benzyl oder Phenethyl oder B bedeutet,
Chinacridone der Formeln VII oder Vlla 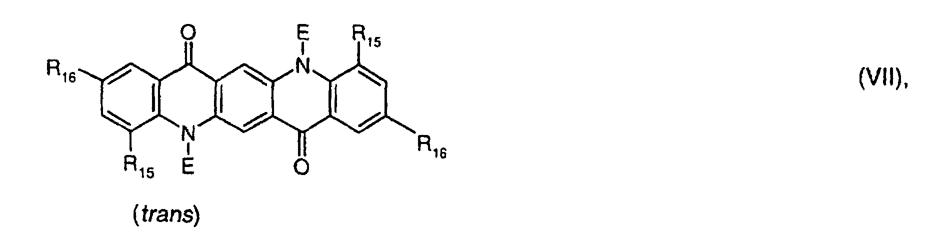 worin R₁₅ und R₁₆ unabhängig voneinander Wasserstoff, Halogen, C₁-C₂₄-Alkyl, C₁-C₆-Alkoxy oder Phenyl ist, oder 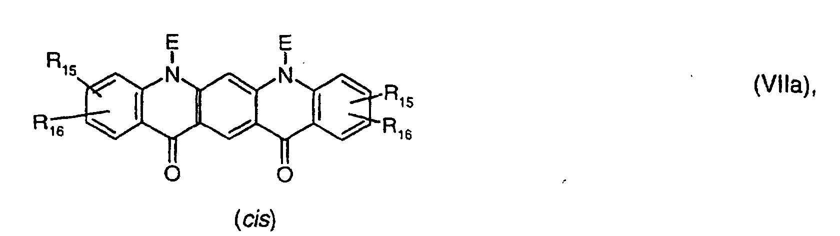 Dihydrochinacridon der Formel VIIb 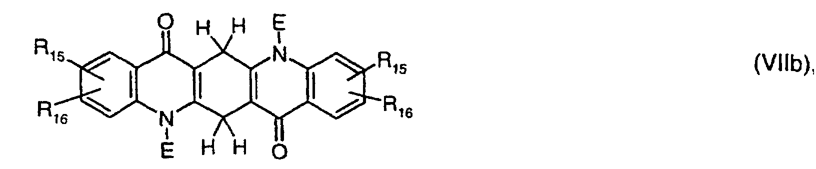 oder Chinacridonchinon der Formel Vllc 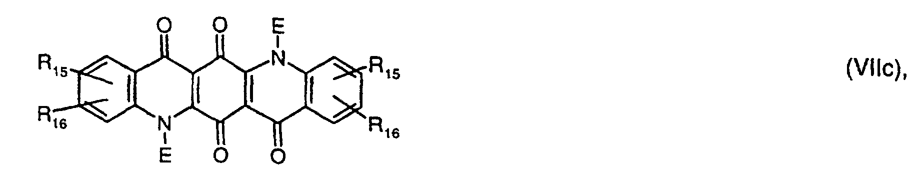 oder Latentpigmente polycyclischer Chromophore bekannter Grundstruktur der Formeln Vlld, VIIe oder Vllf 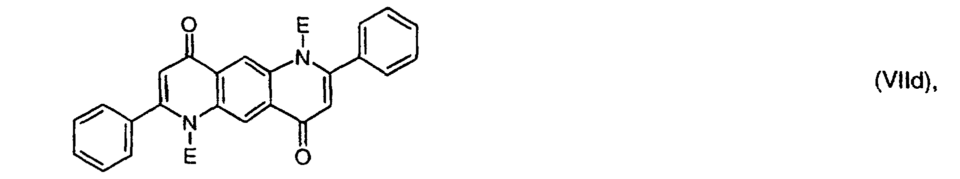 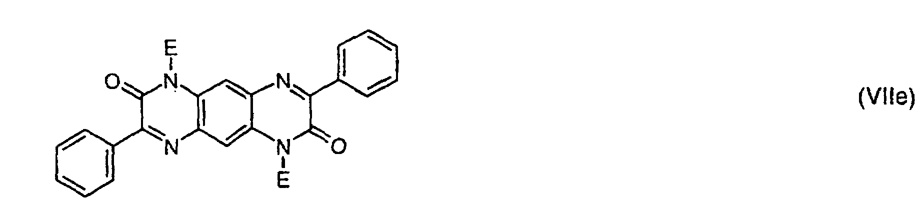 oder 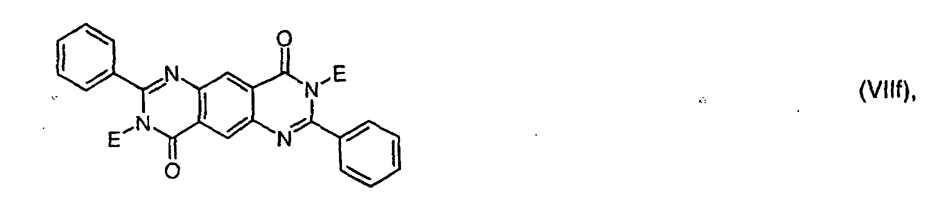 Chinophthalone der Formeln XL oder XLI 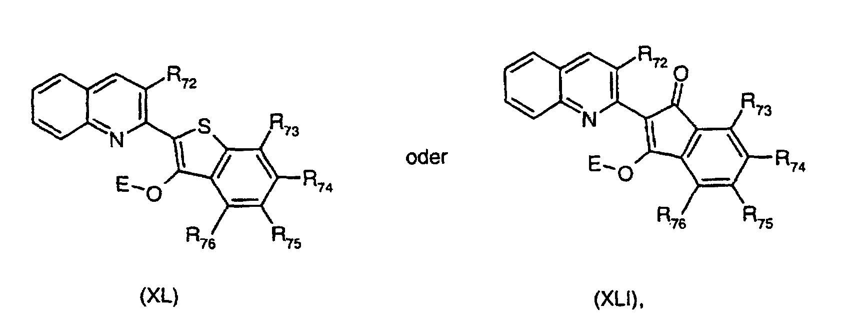 worin R₇₂ für Wasserstoff oder O-E steht,
R₇₃ bis R₇₆ unabhängig voneinander Wasserstoff, Halogen, -COO-C₁-C₅ - Alkyl oder -CONE-C₁-C₆ - Alkyl bedeuten,
Dioxazine der Formeln VIII oder IX 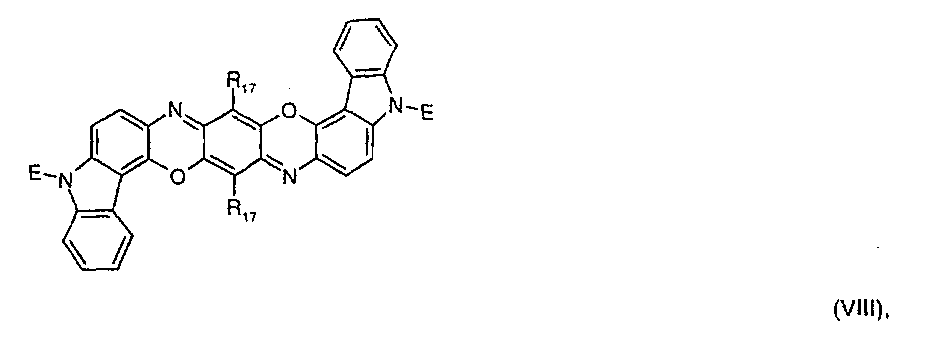 worin R₁₇ Wasserstoff, Halogen oder C₁-C₂₄-Alkyl ist, oder 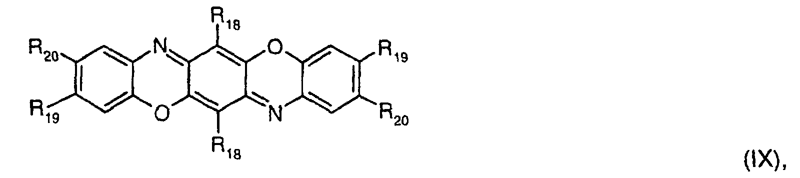 worin R₁₈, R₁₉ und R₂₀ unabhängig voneinander Wasserstoff, Halogen, C₁-C₄-Alkyl, C₁-C₄-Alkoxy, NECOC₁-C₄-Alkyl, NECOPhenyl oder NH-E sind, wobei mindestens einer der Reste R₁₈, R₁₉ oder
R₂₀ NECOC₁-C₄-Alkyl, NECOPhenyl oder NH-E sind,
Isoindoline der Formeln X, XI oder XII 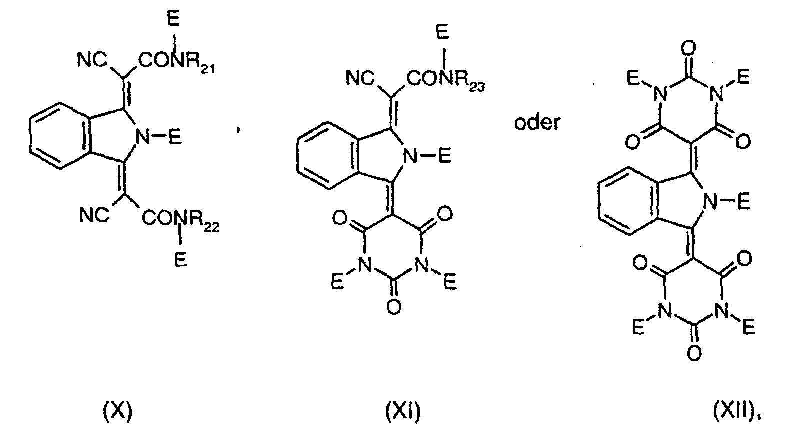 worin R₂₁ eine Gruppe 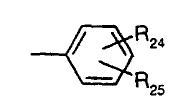 ist,
R₂₂ Wasserstoff, C₁-C₂₄-Alkyl, Benzyl oder eine Gruppe 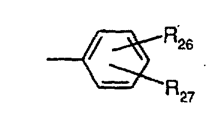 bedeutet und
R₂₃ für Wasserstoff, E oder R ₂₁ steht,
R₂₄, R₂₅, R₂₆ und R₂₇ unabhängig voneinander Wasserstoff, C₁-C₂₄-Alkyl, C₁-C₆-Alkoxy, Halogen oder Trifluormethyl bedeuten,
Isoindolinone der Formeln XIIIa, XIIIb oder XIIIc 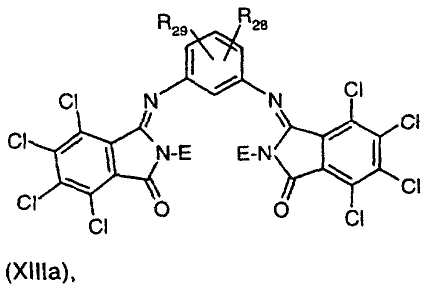 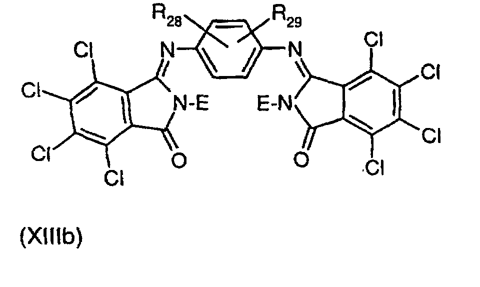 oder 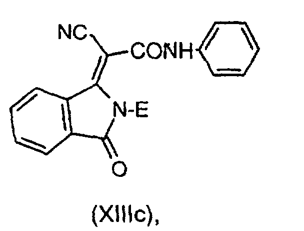 worin
R₂₈ und R₂₉ unabhängig voneinander Wasserstoff, Halogen oder C₁-C₆-Alkyl sind, oder
Benzimidazolon-Azoverbindungen der Formeln XIVa, XIVb oder XIVc 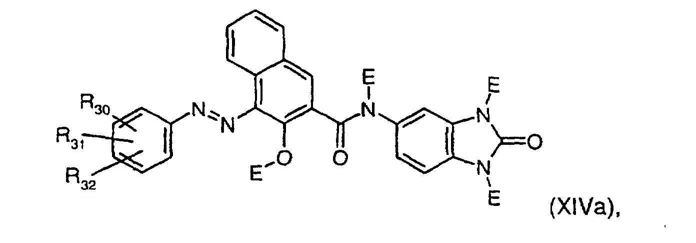 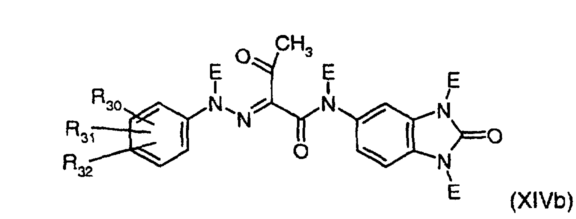 oder 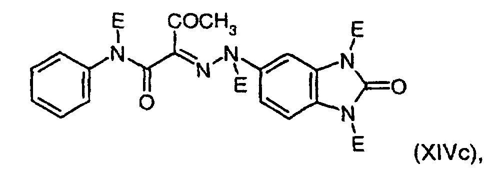 worin
R₃₀, R₃₁ und R₃₂ unabhängig voneinander Wasserstoff, Halogen, C₁-C₆-Alkoxy, C₁-C₆-Alkyl, Trifluormethyl, Nitro, Acetyl, CONR₇R₃₃ oder SO₂NR₇R₃₃ sind, und
R₃₃ für Wasserstoff, Halogen, C₁-C₆-Alkyl oder unsubstituiertes oder mit Wasserstoff oder ein-, zwei- oder dreifach durch Halogen, Nitro, E, CONER₈₅, NECO-R₈₅, Trifluormethyl, C₁-C₆-Alkoxy oder C₁-C₆-Alkyl substituiertes Phenyl steht,
Indigoderivate der Formel XV 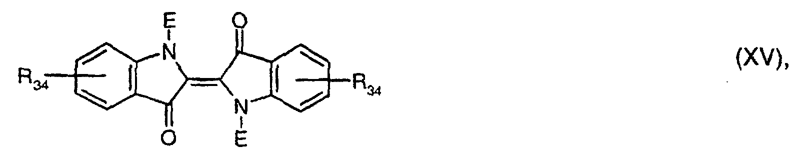 worin
R₃₄ Wasserstoff, CN, C₁-C₆-Alkyl, C₁-C₆-Alkoxy oder Halogen bedeutet,
Mono-Azoverbindungen der Formeln XVIa, XVIb oder XVIc 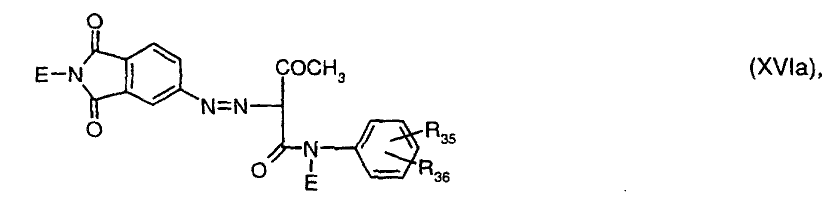 worin
R₃₅ und R₃₆ unabhängig voneinander Wasserstoff, Halogen, C₁-C₆-Alkyl, C₁-C₆-Alkoxy, Nitro, Acetyl oder SO₂NE-C₁-C₆-Alkyl sind, 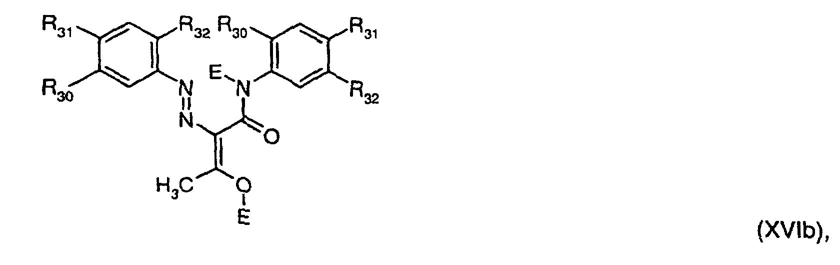 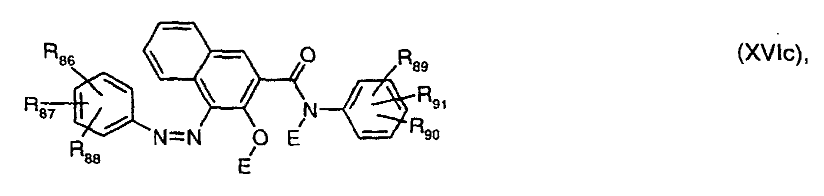 worin
R₈₆ das gleiche wie R₃₀ bedeutet oder für einen Rest, Phenoxy oder einen Ester, COO(C₁-C₆-Alkyl) steht,
R₈₇ das gleiche wie R₃₁ bedeutet oder für einen Rest, NECO-Phenyl, NECO-C₁-C₆-Alkyl oder CONH₂ steht,
R₈₈ das gleiche wie R₃₂ oder R₃₃ bedeutet oder für einen Rest, der Formel, SO₂O-Aryl, SO₂O-Aryl-NO₂, SO₂O-Aryl-CO₂CH₃, SO₂CH₂-Aryl, worin,
Aryl beispielsweise Heteroaryl oder zum Beispiel Phenyl, Phenanthryl oder Naphthyl bedeutet, oder
R₈₈ eine Gruppe 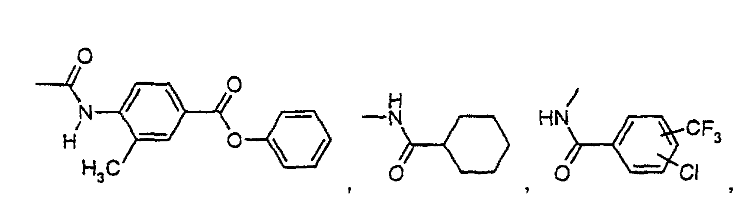 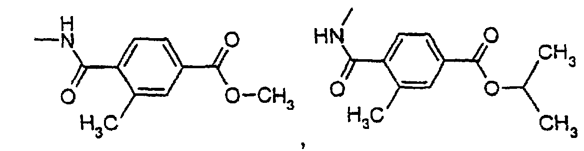 oder 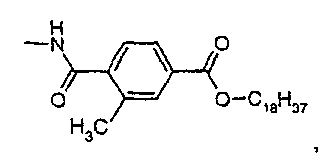 und
R₈₉ Wasserstoff, C₁-C₆-Alkoxy, C₁-C₆-Alkyl oder 1-Naphthyl,
R₉₀ Wasserstoff, C₁-C₆-Alkoxy, C₁-C₆-Alkyl, Halogen, NECO-C₁-C₆-Alkyl bedeutet, oder unsubstituiertes, oder mit C₁-C₆-Alkyl, C₁-C₆-Alkoxy, ein-, zwei-, oder dreifach durch Halogen substituiertes Phenacyl, wobei besonders bevorzugt die ein- oder zweifache Substitution durch Cl ist sowie 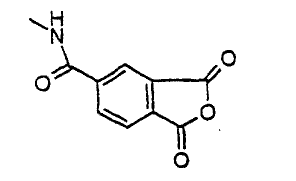
R₉₁ Wasserstoff, Halogen, C₁-C₆-Alkoxy, C₁-C₆-Alkyl, NO₂, oder unabhängig voneinander die gleiche Bedeutung wie R₈₇ und R₈₈, oder
Mono-Azoverbindungen der Formeln XVId oder XVIe 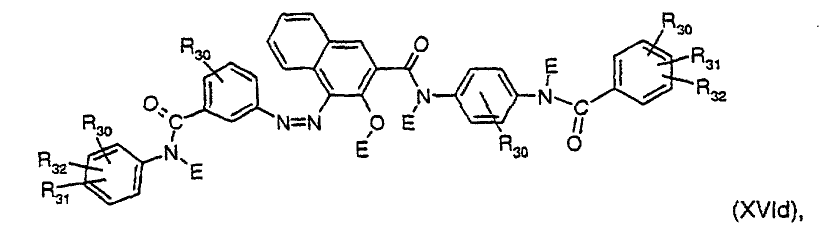 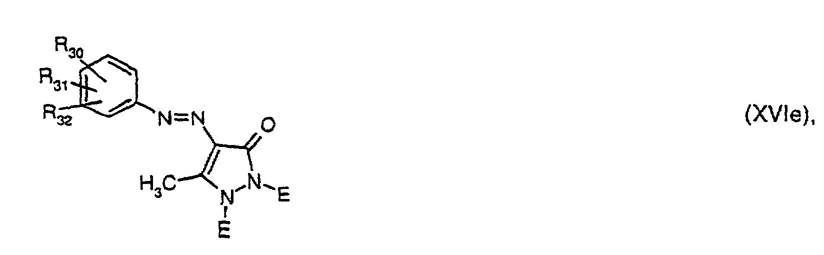 Bis-Azoverbindungen der Formeln XVII, XVIII, XVIIIa, XVIIIb oder XVIIIc 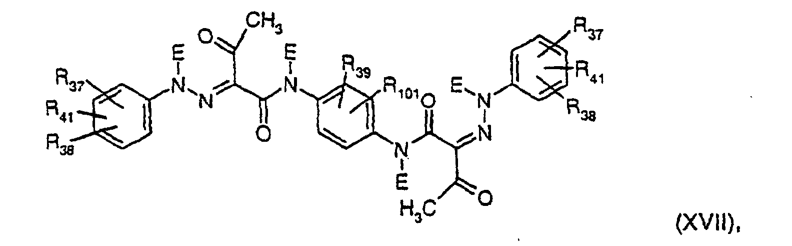 wobei, wenn E Wasserstoff bedeutet, XVII für ein Pigment des Colour Index, P.Y. 93, P.Y. 94, P.Y.95, P.Y. 128 oder P.Y. 166 steht,
oder 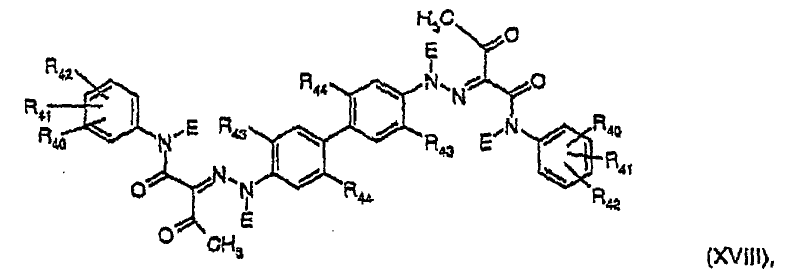 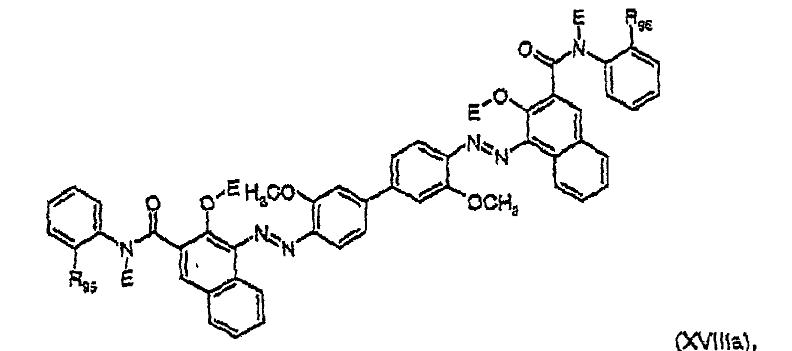 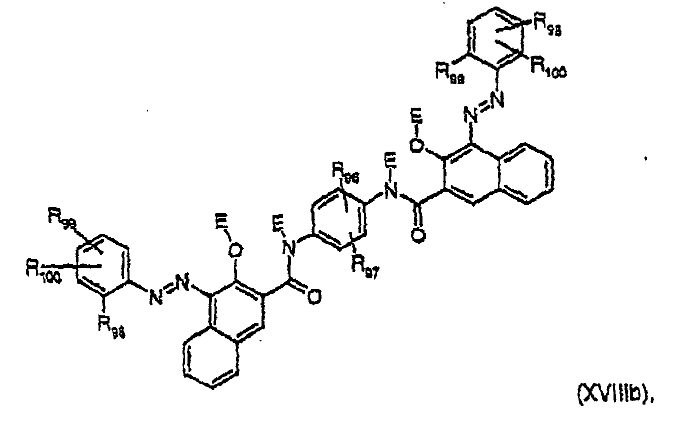 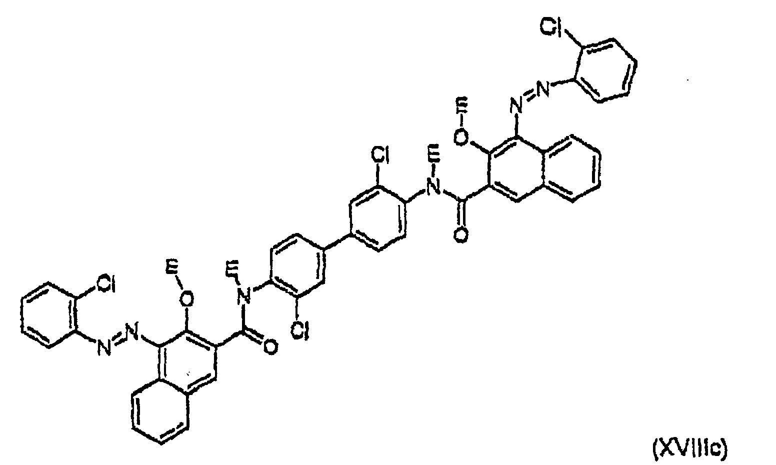 wobei in XVIIIb, wenn E Wasserstoff bedeutet, XVIIIb die Bedeutung von Pigment Colour Index P.R. 144. P.R. 166, P.R. 214, P.R. 220, P.R. 221 oder P.R. 242 hat, und XVIIIc, wenn E Wasserstoff bedeutet, XVIIIc die Bedeutung von Pigment Colour Index P.C. 31,
R₃₇ und R₃₈ unabhängig voneinander Wasserstoff, Halogen, Nitro, C₁-C₆-Alkoxy, C₁-C₆-Alkyl, Trifluormethyl, CONER₄₅ oder SO₂NER₄₅, mindestens jedoch einmal CONER₄₅ oder SO₂NER₄₅sind, und
R₃₉ und R₁₀₁ unabhängig voneinander für Wasserstoff, Halogen, Nitro, C₁-C₆-Alkoxy oder C₁-C₆-Alkyl stehen,
R₄₀, R₄₁ und R₄₂ unabhängig voneinander Wasserstoff, Halogen, Nitro, Acetyl, C₁-C₆-Alkoxy, C₁-C₆-Alkyl, Trifluormethyl, CONER₄₅ oder SO₂NER₄₅, mindestens jedoch einmal CONER₄₅ oder SO₂NER₄₅ sind, und
R₄₃ und R₄₄ unabhängig voneinander Wasserstoff, Halogen, C₁-C₆-Alkoxy oder C₁-C₆-Alkyl sind, und
R₄₅ für Wasserstoff, Halogen, C₁-C₄-Alkyl oder unsubstituiertes oder mit 1 bis 3, bevorzugt 2 Substituenten wie beispielsweise Halogen, Nitro, Trifluormethyl, C₁-C₄-Alkoxy oder C₁-C₄-Alkyl, E, bevorzugt Chlor oder Methyl, substituiertes Phenyl, Naphthyl, Biphenyl oder Oxybisphenyl steht,
R₈₅ Wasserstoff oder OCH₃ bedeutet,
R₈₆ und R₈₇ unabhängig voneinander Chlor oder Methyl,und
R₉₈, R₉₉ oder R₁₀₀ unabhängig voneinander Chlor, Methyl oder COOCH₂CH₂Cl, COOCH(CH₃)₂ bedeuten sowie anthrachinoide Verbindungen der Formeln XIX, XIXa, XIXb, XIXc, XIXd oder XX 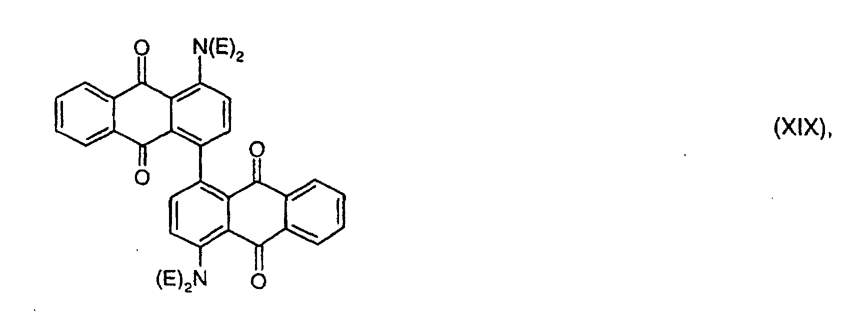 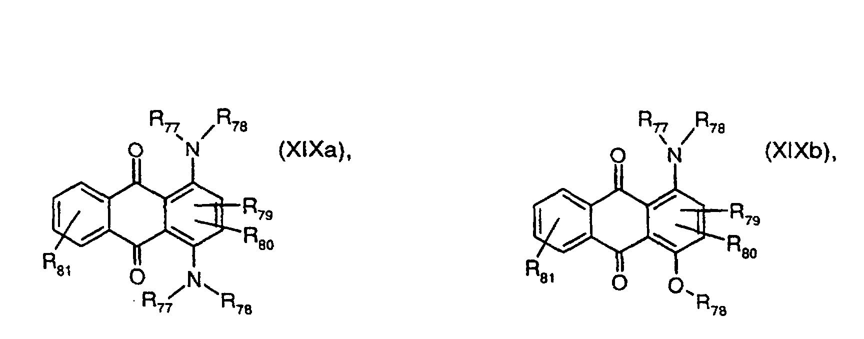 worin
R₇₇ und R₇₈ unabhängig voneinander E, Wasserstoff, C₁-C₁₂-Alkyl oder unsubstituiertes oder mit Halogen, C₁-C₆-Alkyl, C₁-C₆-Alkoxy, Nitro, Acetyl, SO₂NEC₁-C₆-Alkyl oder SO₂NH₂ substituiertes C₆-C₁₂-Aryl,
R₇₉ und R₈₀ unabhängig voneinander Wasserstoff, Halogen, C₁-C₆-Alkyl, C₁-C₆-Alkoxy, Nitro, Cyano, CONH₂, SO₂NEC₁-C₆-Alkyl, SO₂NH₂, SO₃H, SO₃Na oder unsubstituiertes oder mit Halogen, C₁-C₆-Alkyl, C₁-C₆-Alkoxy, Nitro, Acetyl, SO₂NEC₁-C₆-Alkyl oder SO₂NH₂ substituiertes C₆-C₁₂-Aryl, und
R₈₁ Wasserstoff, Halogen, Nitro, Cyan, Hydroxy oder C₁-C₆-Alkoxy bedeuten oder 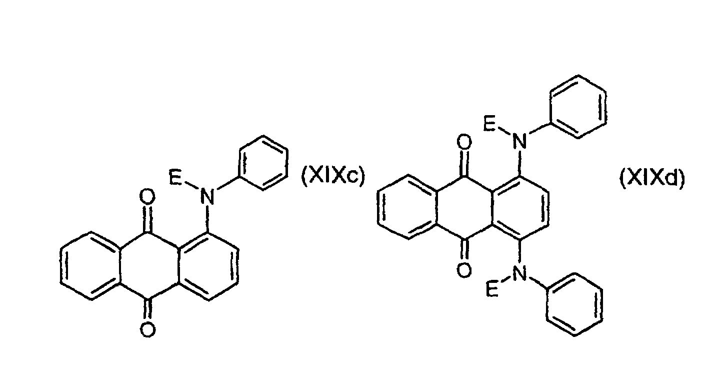 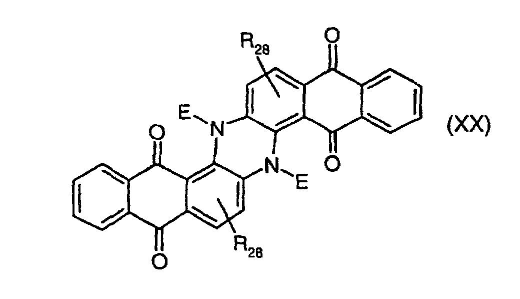 Phthalocyanine der Formel XXI 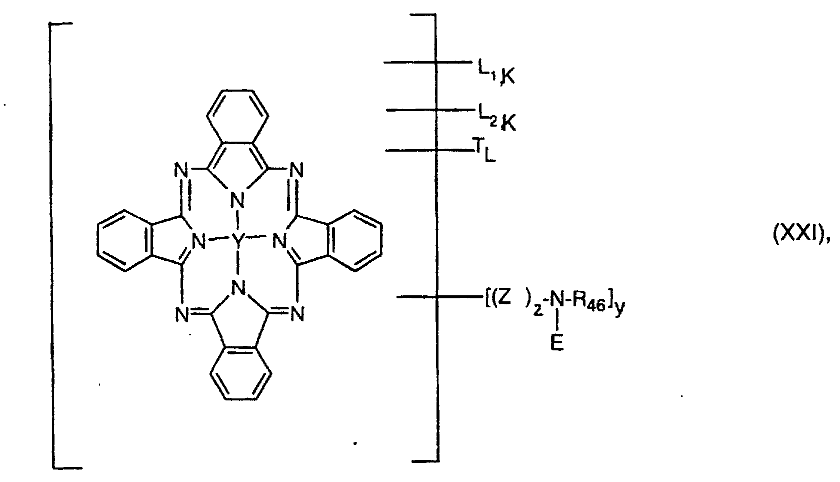 worin
Y H₂, ein zweiwertiges Metall ausgewählt aus der Gruppe Cu(II), Zn(II), Fe(II), Ni(II), Ru(II), Rh(II), Pd(II), Pt(II), Mn(II), Mg(II), Be(II), Ca(II), Ba(II), Cd(II), Hg(II), Sn(II), Co(II) oder Pb(II) bevorzugt Cu(II), Zn(II), Fe(II) Ni(II) oder Pd(II) oder ein- oder zweiwertiges Oxometall ausgewählt aus der Gruppe V(O), Mn(O) oder TiO,
Z -CH(R₄₇)-, -CO- oder -SO₂-,
R₄₆ Wasserstoff, C₁-C₆-Alkyl, -N(E)R₄₇, -NECOR₄₈, -SO₂(NH)₂CO₂C(CH₃)₃, -COR₄₈ oder 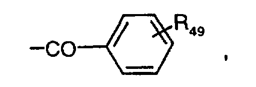 R₄₇ Wasserstoff oder C₁-C₆-Alkyl, R₄₈ C₁-C₆-Alkyl und R₄₉ Wasserstoff, Halogen, C₁-C₆-Alkyl oder C₁-C₆-Alkoxy bedeuten,
z für Null oder 1, y für Null oder für eine Zahl von 1 bis 8, K für Null oder 1, L für Null oder eine Zahl von 1 bis 16 steht, worin,
wenn y eine Zahl von 1 bis 4 bedeutet, K und L Null sind, oder
wenn K und L eine Zahl von 1 bis 16 bedeuten, y Null ist, und
L₁ und L₂, jeweils gebunden an eines der 8, den Phthalocyaninkomplex bildenden Stickstoffatome und/oder an eines der 8 den Phthalocyaninkomplex bildenden Kohlenstoffatome, bedeuten unabhängig voneinander Wasserstoff, Halogen, C₁-C₁₈-Alkoxy, C₁-C₁₈-Alkylthio, C₁-C₁₈-Alkylamino, C₂-C₁₈-Dialkylamino, Morpholin oder für unsubstituiertes oder mit C₁-C₁₂-Alkyl substituiertes Piperidin, sowie
T, für jedes T unabhängig voneinander Halogen, C₁-C₁₈-Alkyl, C₁-C₁₈-Alkoxy, C₁-C₁₈-Alkylthio oder C₂-C₁₈Dialkylamino bedeutet, und
Pyrrolo[3,4-c]pyrrole der Formeln XXIIa oder XXIIb 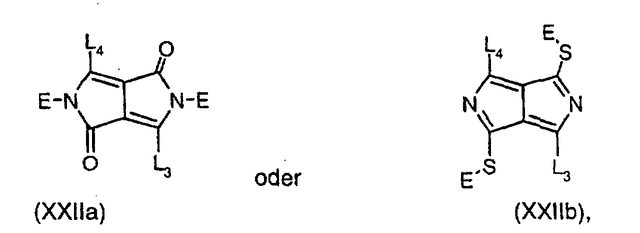 worin L₄ und L₃ unabhängig voneinander für eine Gruppe der Formeln 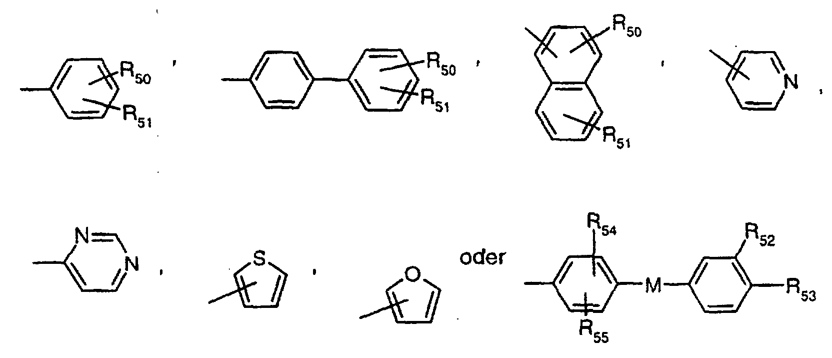 stehen, worin
R₅₀ und R₅₁ unabhängig voneinander Wasserstoff, Halogen, C₁-C₂₄-Alkyl, C₁-C₆-Alkoxy, C₁-C₁₈-Alkylmercapto, C₁-C₁₈-Alkylamino, Carbamoyl, -CN, -NO₂, -Phenyl, Trifluormethyl, C₅-C₆-Cycloalkyl, -C=N-(C₁-C₂₄-Alkyl), 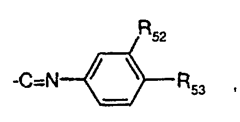 Imidazolyl, Pyrazolyl, Triazolyl, Piperazinyl, Pyrrolyl, Oxazolyl, Benzoxazolyl, Benzthiazolyl, Benzimidazolyl, Morpholinyl, Piperidinyl oder Pyrrolidinyl bedeuten,
M -CH₂-, -CH(CH₃)-, -C(CH₃)₂-, -CH=N-, -N=N-, -O-, -S-, -SO-, -SO₂- oder -NR₅₆- ist, R₅₂ und R₅₃ unabhängig voneinander Wasserstoff, Halogen, C₁-C₆-Alkyl, C₁-C₆-Alkoxy oder -CN sind, R₅₄ und R₅₅ unabhängig voneinander Wasserstoff, Halogen oder C₁-C₆-Alkyl und R₅₆ Wasserstoff oder C₁-C₆-Alkyl bedeuten,
wobei in den oben erwähnten Formeln E jeweils Wasserstoff oder B bedeutet, mit der Massgabe, dass E in jeder Formel mindestens einmal B ist, und B die in Anspruch 7 gegebene Bedeutung besitzt.

9. Pigmentdispersion erhalten durch ein Verfahren nach einem der Ansprüche 1 bis 8.

10. Pigmentdispersion, enthaltend
(a) ein Polymer,
(b) ein organisches Pigment in kolloidaler Form und
(c) ein nicht-wasserhaltiges Lösungsmittel
oder
(d)ein wasserhaltiges Lösungsmittel.

11. Verbindungen der Formeln 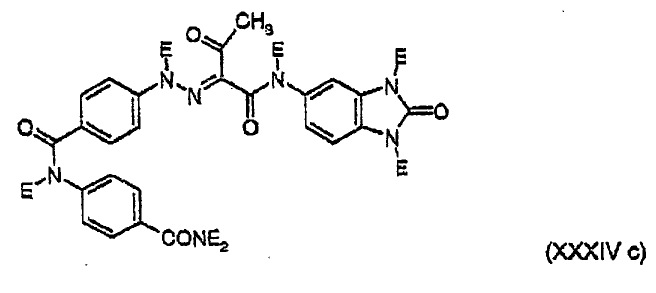 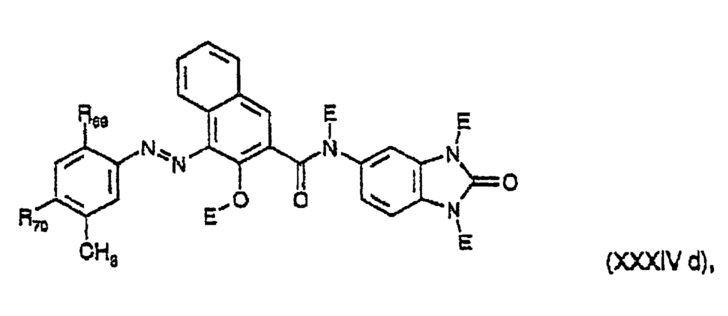 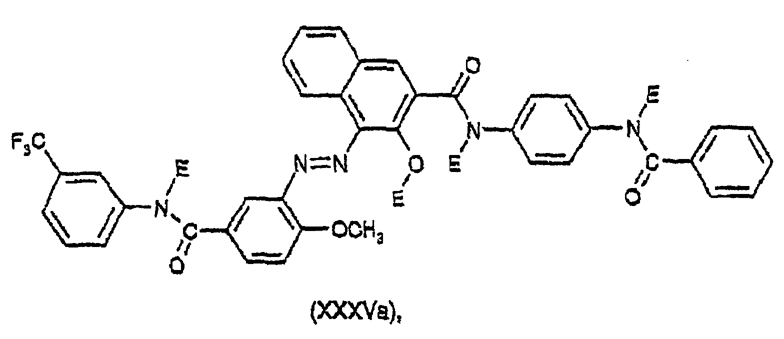 worin
R₈₈ C₁-C₆Alkoxy ist, und
R₇₀ CONHE, SO₂NMeE oder SO₂NHE, insbesondere SO₂NHE oder SO₂NCH₃E ist,
und E in den oben erwähnten Formeln jeweils Wasserstoff oder B bedeutet, mit der Massgabe, dass E in jeder Formel mindestens einmal B ist, und B die in Anspruch 7 gegebene Bedeutung besitzt.

12. Verwendung einer Pigmentdispersion gemäss einem der Ansprüche 9 bis 10 oder einer Verbindung gemäss Anspruch 11 oder der aus Verbindungen gemäss Anspruch 11, erhältlichen Pigmentform zum Färben oder Pigmentieren von hochmolekularem Material.

13. Zusammensetzungen enthaltend hochmolekulares Material und eine färberisch wirksame Menge einer Verbindung gemäss Anspruch 11 oder der aus Verbindungen gemäss Anspruch 11 erhältlichen Pigmentform oder einer Pigmentdispersion gemäss einem der Ansprüche 9 bis 10.

14. Verwendung einer Verbindung gemäss Anspruch 11 oder der aus Verbindungen gemäss Anspruch 11 erhältlichen Pigmentform oder einer Pigmentdispersion gemäss einem der Ansprüche 9 bis 10 oder einer Zusammensetzung gemäss Anspruch 13 für die Herstellung von
Tinten oder Drucktinten in Druckverfahren für den Flexodruck, Siebdruck, Verpackungsdruck, Sicherheitsfarbdruck, Tiefdruck oder Offsetdruck, für Druckvorstufen sowie für Textildruck, für Büro-, Heimanwendungen oder graphische Anwendungen, für Papierwaren, für Kugelschreiber, Filzstifte, Faserstifte, Pappe, Holz, (Holz-)Beizen, Metall, Stempelkissen oder Tinten für Impact-printing Verfahren (mit Stossdruckfarbbänder) oder für die Herstellung von
Farbmitteln für Lacke für den Industrie- oder Gewerbegebrauch, für die Textildekoration und die industrielle Markierung, für Walzlacke oder Pulverlacke oder für Automobillacke, für high-solids (lösungsmittelarme), wasserhaltige oder metallische Lacke oder für wasserhaltige Formulierungen, wasserhaltige Anstrichfarben, oder für die Herstellung von
pigmentierter Kunststoffe für Beschichtungen, Fasern, Platten oder Formträger, oder für non-Impact-printing Material (Nicht-Stossdruckmaterial),
für das digital-printing (Digitale Druckverfahren), für das thermische Wachs-Transfer-Druck-, für das Tintenstrahldruck oder für das thermische Transferdruck-Verfahren, oder für die Herstellung von
Farbfiltern für die Herstellung von Flüssigkristallbildschirmen (Liquid Crystal Display, LCD) oder Charge Combined Device (CCD), oder für
Kosmetik, oder für
Toner, für dry copy toners (Trockenkopier-Farblacke) oder liquid copy toners (Flüssigkopier-Farblacke) oder elektrophotgraphische Toner.

15. Verfahren zur Herstellung von Farbfiltern enthaltend ein transparentes Substrat sowie darauf aufgebracht eine rote, blaue und grüne Schicht in beliebiger Reihenfolge, **dadurch gekennzeichnet, dass** man zur Herstellung der roten, blauen und grünen Schichten je eine entsprechend gelärbte Pigmentdispersion gemäss einem der Ansprüche 9 bis 10 verwendet oder diese Schichten eine entsprechend gefärbte Pigmentdispersion gemäss einem der Ansprüche 9 bis 10 oder eine Verbindung gemäss Anspruch 11 oder aus einer Verbindung gemäss Anspruch 11, erhältliche Pigmentform oder eine Zusammensetzung gemäss Anspruch 13 enthalten.

16. , Farbfilter, enthaltend ein transparentes Substrat sowie darauf aufgebracht eine rote, blaue und grüne Schicht je erhältlich aus einer entsprechend gefärbte Pigmentdispersion gemäss einem der Ansprüche 9 bis 10 oder enthaltend eine Verbindung gemäss Anspruch 11 oder die aus einer Verbindung gemäss Anspruch 11, erhältliche Pigmentform oder einer Zusammensetzung gemäss Anspruch 13.

## Claims

1. Process for preparing pigment dispersions comprising a pigment, a polymer and a solvent, **characterized by**
a1) subjecting a mixture A comprising a latent pigment and a polymer to thermal, chemical or photolytic treatment and
b) then adding a solvent,
or
a2) subjecting a mixture B comprising a latent pigment, a polymer and a solvent to thermal, chemical or photolytic treatment.

2. Process according to claim 1, **characterized in that** the mixture A is thermally treated in an extruder.

3. Process for preparing pigment dispersions comprising a pigment and a polymer, **characterized by**
c1) preparing a mixture comprising a latent pigment, a polymer and a solvent,
c2) subsequently removing the solvent from the resulting mixture, and
c3) then a subjecting the solvent-free mixture A to thermal, chemical or photolytic treatment, and
c4) then adding a solvent to the treated mixture.

4. Process for preparing pigment dispersions comprising a pigment and a polymer, **characterized by**
d1) preparing a mixture B comprising a latent pigment, a polymer and a solvent, and
d2) subsequently removing a part of the solvent from the resulting mixture, and
d3) then subjecting the resulting mixture to thermal, chemical or photolytic treatment.

5. Process according to any of claims 1 to 4, **characterized in that** the mixtures A or B are thermally treated within a temperature range from 100 to 200°C for from one to 36 hours.

6. Process according to any of claims 1 to 5, **characterized by**
a) mixing the thermally, chemically or photolytically treated mixture with an organic solvent, especially a water-miscible organic solvent, and
b) then, by adding a water-containing solution comprising a base, adjusting the pH to ≥ 7.

7. Process according to any of claims 1 to 6, **characterized in that** latent pigments of the formula I
A(B)ₓ (I)
are used in which
x is a number from 1 to 8, and
A is the radical of a chromophore of the anthraquinone, azo, benzimidazolone, quinacridone, quinophthalone, diketopyrrolopyrrole, dioxazine, indanthrone, indigo, isoindoline, isoindolinone, perylene, and phthalocyanine series which is attached to x groups B via one or more heteroatoms from the group consisting of N, O and S, which form part of the radical A,
and
B is a radical selected from the group consisting of the formulae II-IV 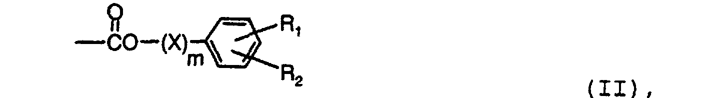 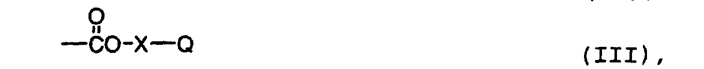 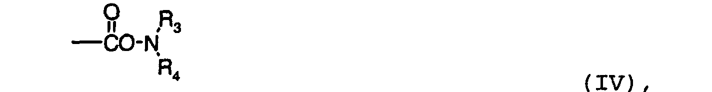 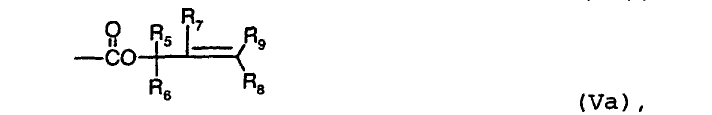 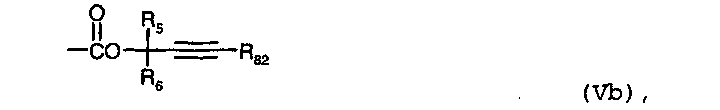 and hydrogen,
with at least one radical B not being hydrogen,
where in the formulae II, III, IV or Va or Vb
m is zero or 1,
X is C₂-C₅alkenylene or C₁-C₆alkylene which is unsubstituted or substituted one or more times by C₁-C₆alkyl or R₅ and R₆,
or
R₁ and R₂ independently of one another are hydrogen, C₁-C₆alkyl, alkoxy, halogen, cyano, nitro, N(C₁-C₆alkyl)₂, unsubstituted or halogen-, cyano-, nitro-, C₁-C₆alkyl- or C₁-C₆alkoxy-substituted phenyl, and
Q is hydrogen, C₁-C₆alkyl, CN, CCl₃, a group 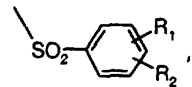 SO₂CH₃ or SCH₃, and
R₃ and R₄ independently of one another are hydrogen, C₁-C₄alkyl or a group 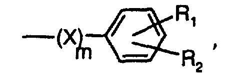 or R₃ and R₄ together form a piperidinyl radical, and R₅ and R₆ independently of one another are hydrogen, C₁-C₂₄alkyl, O-interrupted, S-interrupted or C₁-C₆alkyl-disubstituted and N-interrupted C₁-C₂₄alkyl, C₃-C₂₄alkenyl, C₃-C₂₄alkynyl, C₄-C₁₂cycloalkyl, C₄-C₁₂cycloalkenyl, unsubstituted or C₁-C₆alkyl-, C₁-C₆alkoxy-, halogen-, cyano- or nitro-substituted phenyl or biphenylyl,
R₇, R₈ and R₉ independently of one another are hydrogen, C₁-C₂₄alkyl or C₃-C₂₄alkenyl,
R₈₂ is hydrogen, C₁-C₆alkyl or a group of the formula 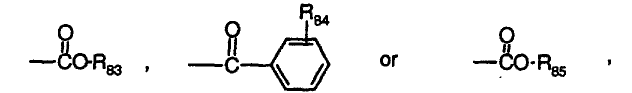 R₈₃ is C₁-C₆alkyl,
R₈₄ is hydrogen or C₁-C₆alkyl and
R₈₅ is hydrogen, C₁-C₆alkyl, unsubstituted or C₁-C₆alkyl-substituted phenyl, or
B is a group of the formula 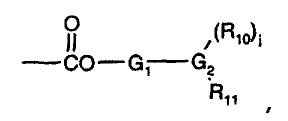 in which
G₁ is p,q-C₂-C₁₂alkylene which is unsubstituted or substituted one or more times by C₁-C₁₂alkyl, C₁-C₁₂alkoxy, C₁-C₁₂alkylthio or C₂-C₂₄dialkylamino, p and q being different positional numbers,
G₂ is a heteroatom selected from the group consisting of N, O and S, and
in which
i, if G₂ is O or S, is the number 0 and, if G₂ is N, is the number 1, and
R₁₀ and R₁₁ independently of one another are [-(p',q'-C₂-C₁₂alkylene)-R₁₂-]ᵢᵢ-C₁-C₁₂alkyl or C₁-C₁₂alkyl which is unsubstituted or substituted one or more times by C₁-C₁₂alkoxy, C₁-C₁₂alkylthio, C₂-C₂₄dialkylamino, C₆-C₁₂aryloxy, C₆-C₁₂arylthio, C₇-C₂₄alkylarylamino or C₁₂-C₂₄diarylamino,
in which
ii is a number from 1 to 1000, p' and q' are different positional numbers,
each R₁₂ independently of the others is a heteroatom O, S or C₁-C₁₂alkyl-substituted N, and C₂-C₁₂alkylene in the repeating units [C₂-C₁₂alkylene-R₁₂] can be identical or different, and R₁₀ and R₁₁ are saturated or mono- to decaunsaturated, are uninterrupted or interrupted at any desired points by from 1 to 10 groups selected from the group consisting of -(C=O)- and -C₆H₄-, and may carry no or from 1 to 10 further substituents such as halogen, cyano or nitro, with the proviso that, if -G₁- is -(CH₂)ᵢᵥ-, in which
iv is a number from 2 to 12, and G₂ is S, R₁₁ is not unsubstituted, saturated and uninterrupted C₁-C₄alkyl.

8. Process according to any of claims 1 to 7, **characterized in that** latent pigments can denote following compounds of the formula (I):
perylenecarboximides of the formula VIa or VIb 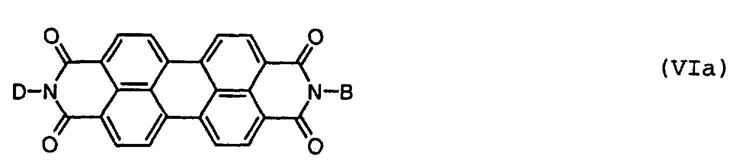 or 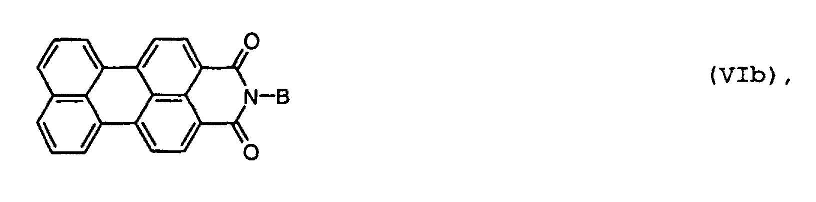 in which D is hydrogen, C₁-C₆alkyl, unsubstituted or halogen- or C₁-C₆alkyl-substituted phenyl, benzyl or phenethyl or is B,
quinacridones of the formula VII or VIIa 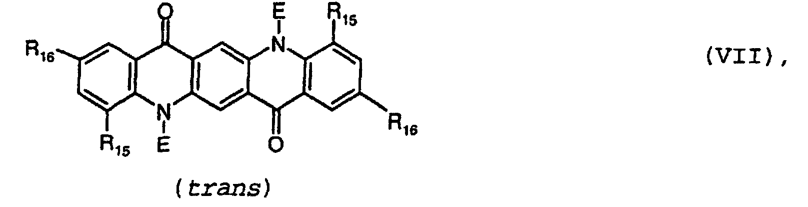 in which R₁₅ and R₁₆ independently of one another are hydrogen, halogen, C₁-C₂₄alkyl, C₁-C₆alkoxy or phenyl, or 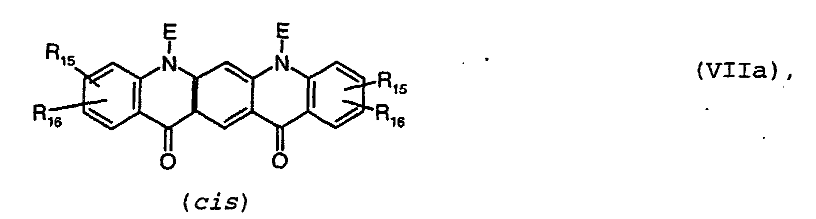 dihydroquinacridone of the formula VIIb 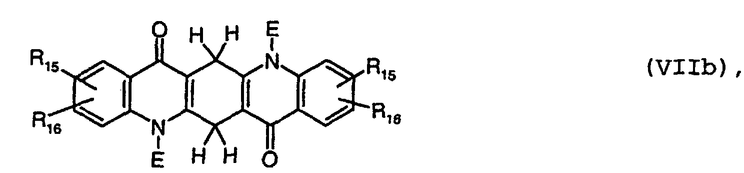 or quinacridonequinone of the formula VIIc 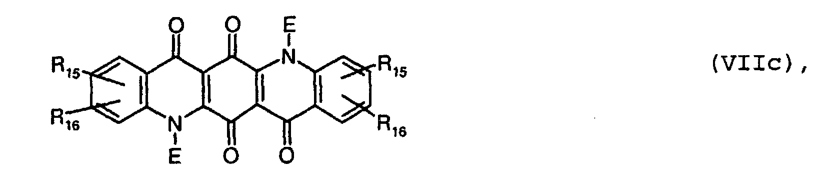 or latent pigments of polycyclic chromophores of known parent structure, of the formula VIId, Vile or VIIf 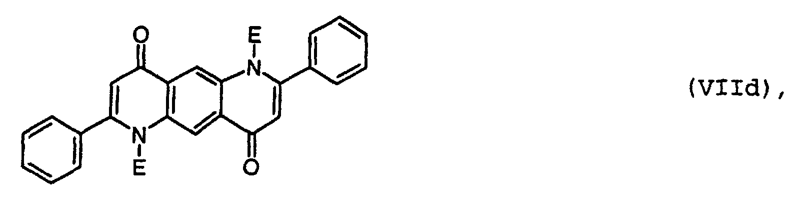 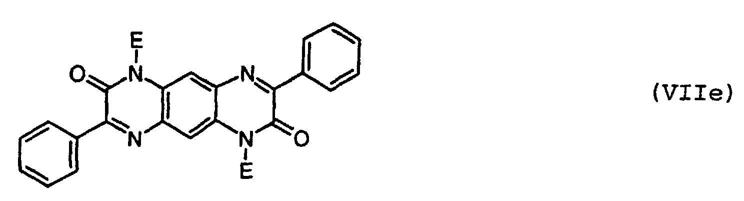 or 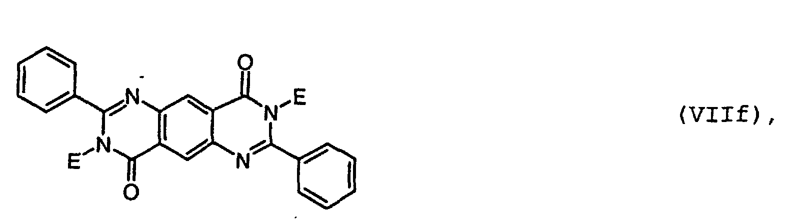 quinophthalones of the formula XL or XLI 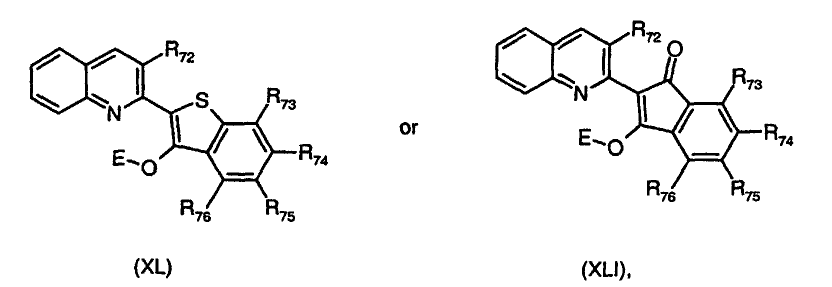 in which R₇₂ is hydrogen or O-E,
R₇₃ to R₇₆ independently of one another are hydrogen, halogen, -COO-C₁-C₅alkyl or -CONE-C₁-C₆alkyl,
dioxazines of the formula VIII or IX 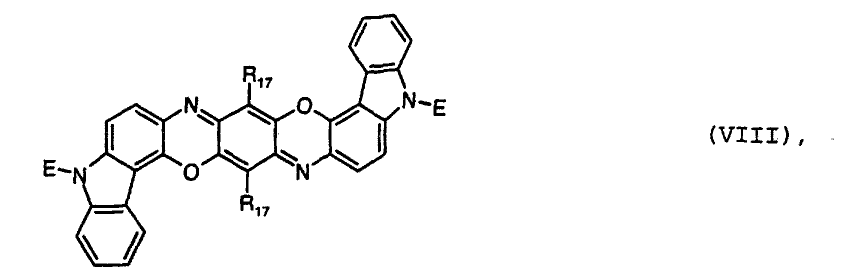 in which R₁₇ is hydrogen, halogen or C₁-C₂₄alkyl,
or 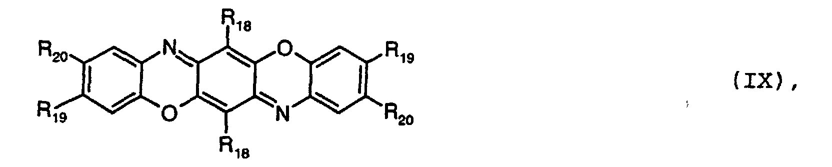 in which R₁₈, R₁₉ and R₂₀ independently of one another are hydrogen, halogen, C₁-C₄alkyl, C₁-C₄alkoxy, NECOC₁-C₄alkyl, NECOphenyl or NH-E, at least one of the radicals R₁₈, R₁₉ and R₂₀ being NECOC₁-C₄alkyl, NECOphenyl or NH-E,
isoindolines of the formula X, XI or XII 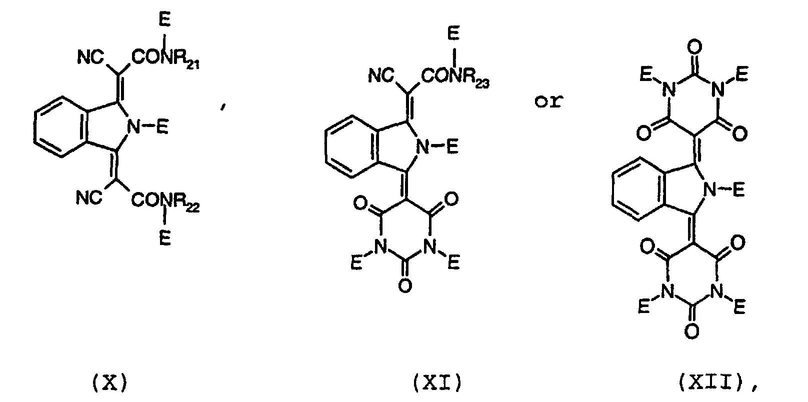 in which R₂₁ is a group 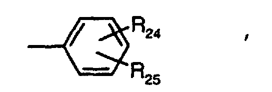 R₂₂ is hydrogen, C₁-C₂₄alkyl, benzyl or a group 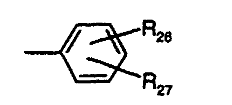 and
R₂₃ is hydrogen, E or R₂₁,
R₂₄, R₂₅, R₂₆ and R₂₇ independently of one another are hydrogen, C₁-C₂₄alkyl, C₁-C₆alkoxy, halogen or trifluoromethyl,
isoindolinones of the formula XIIIa, XIIIb or XIIIc 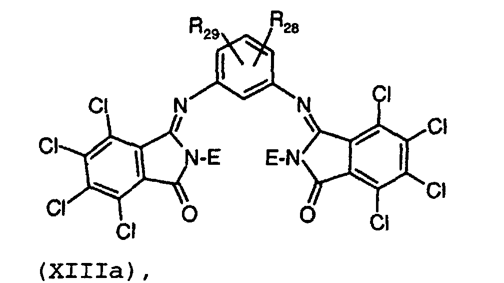 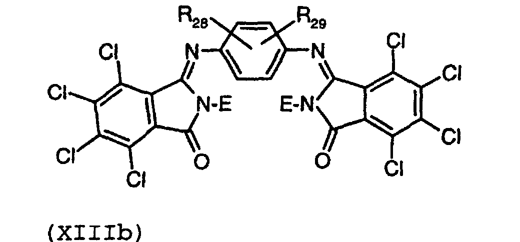 or 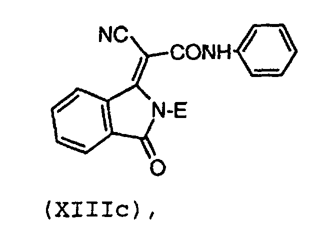 in which
R₂₈ and R₂₉ independently of one another are hydrogen, halogen or C₁-C₆alkyl, or
benzimidazoloneazo compounds of the formula XIVa, XIVb or XIVc 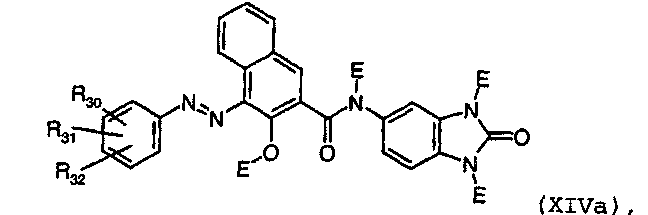 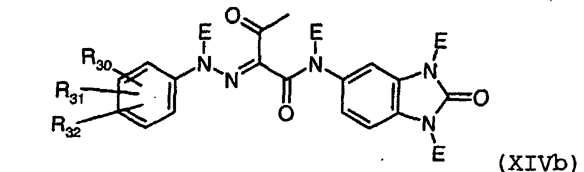 or 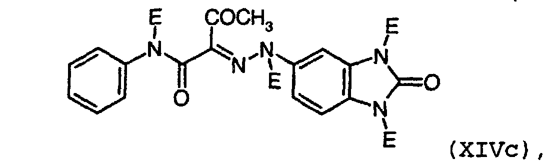 in which
R₃₀, R₃₁ and R₃₂ independently of one another are hydrogen, halogen, C₁-C₆alkoxy, C₁-C₆alkyl, trifluoromethyl, nitro, acetyl, CONR₇R₃₃ or SO₂NR₇R₃₃, and
R₃₃ is hydrogen, halogen or C₁-C₆alkyl or is phenyl which is unsubstituted or substituted by hydrogen or substituted one, two or three times by halogen, nitro, E, CONER₈₅, NECO-R₈₅, trifluoromethyl, C₁-C₆alkoxy or C₁-C₆alkyl,
indigo derivatives of the formula XV 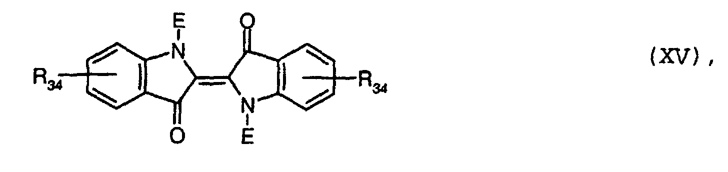 in which
R₃₄ is hydrogen, CN, C₁-C₆alkyl, C₁-C₆alkoxy or halogen, monoazo compounds of the formula XVIa, XVIb or XVIc 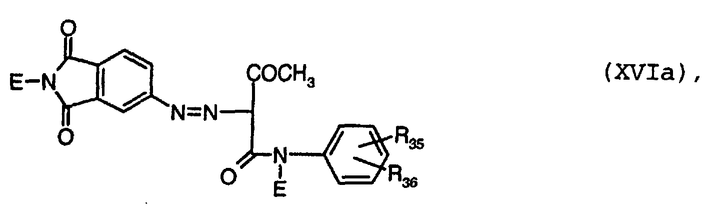 in which
R₃₅ and R₃₆ independently of one another are hydrogen, halogen, C₁-C₆alkyl, C₁-C₆alkoxy, nitro, acetyl or SO₂NE-C₁-C₆alkyl, 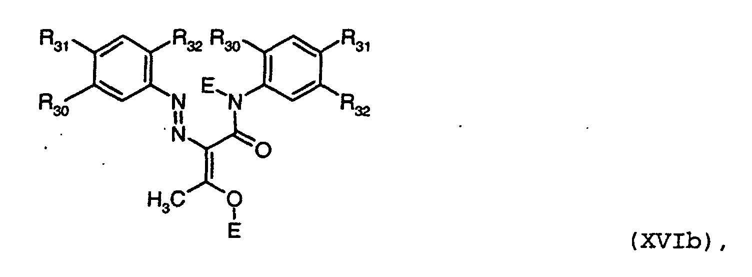 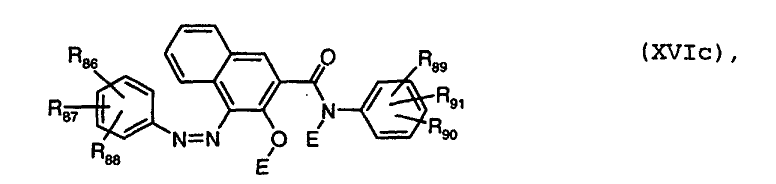 in which
R₈₆ is the same as R₃₀ or is a radical, phenoxy or an ester, COO(C₁-C₆alkyl),
R₈₇ is the same as R₃₁ or is a radical, NECO-phenyl, NECO-C₁-C₆alkyl or CONH₂,
R₈₈ is the same as R₃₂ or R₃₃ or is a radical of the formula SO₂O-aryl, SO₂O-aryl-NO₂,
SO₂O-aryl-CO₂CH₃ or SO₂CH₂-aryl, in which
aryl is for example heteroaryl or for example phenyl, phenanthryl or naphthyl, or
R₈₈ is a group 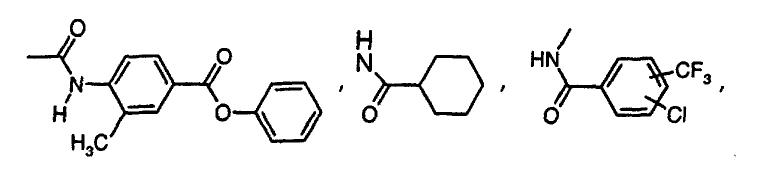 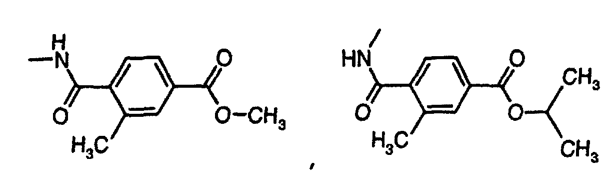 or 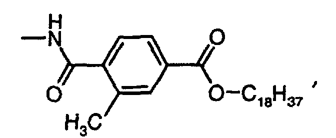 and R₈₉ is hydrogen, C₁-C₆alkoxy, C₁-C₆alkyl or 1-naphthyl,
R₉₀ is hydrogen, C₁-C₆alkoxy, C₁-C₆alkyl, halogen or NECO-C₁-C₆alkyl or is unsubstituted phenacyl or phenacyl which is substituted by C₁-C₆alkyl or C₁-C₆alkoxy or is substituted one, two or three times by halogen, particular preference being given to single or twofold substitution by Cl, and also 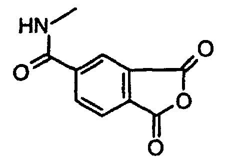 R₉₁ is hydrogen, halogen, C₁-C₆alkoxy, C₁-C₆alkyl, NO₂, or independently at each occurrence is as defined for R₈₇ and R₈₈, or
monoazo compounds of the formula XVId or XVIe 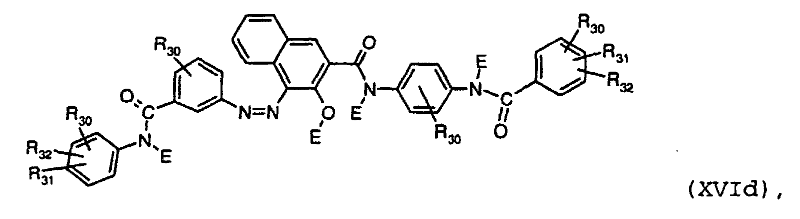 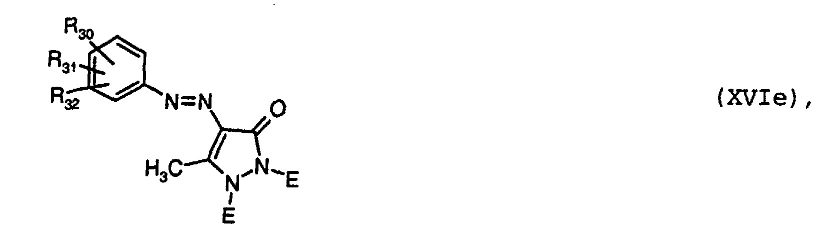 disazo compounds of the formula XVII, XVIII, XVIIIa, XVIIIb or XVIIIc 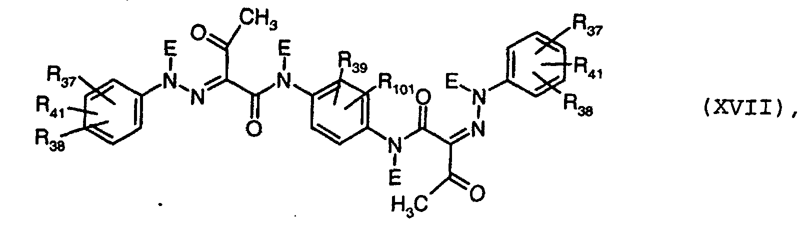 where, if E is hydrogen, XVII is a Colour Index pigment P.Y. 93, P.Y. 94, P.Y. 95, P.Y. 128 or P.Y. 166,
or 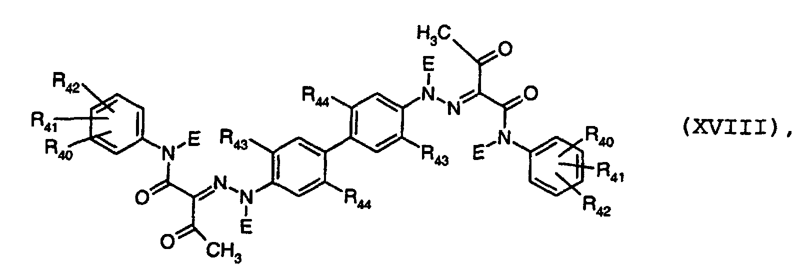 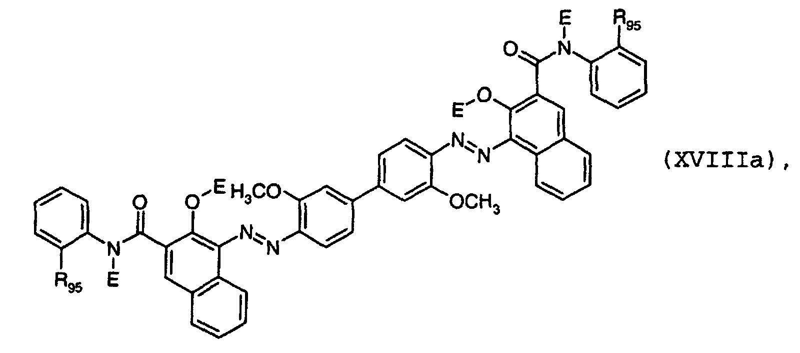 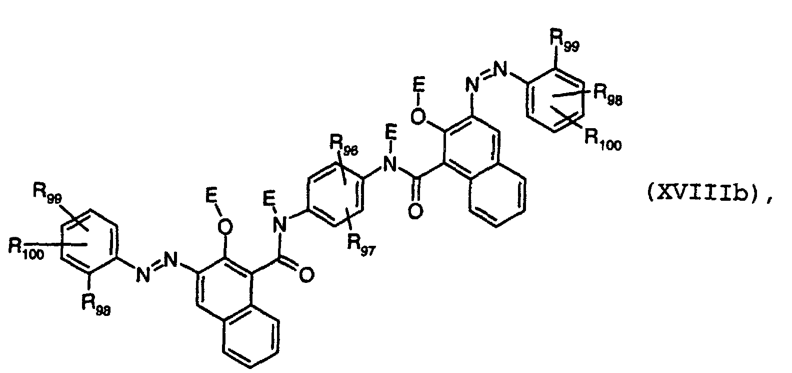 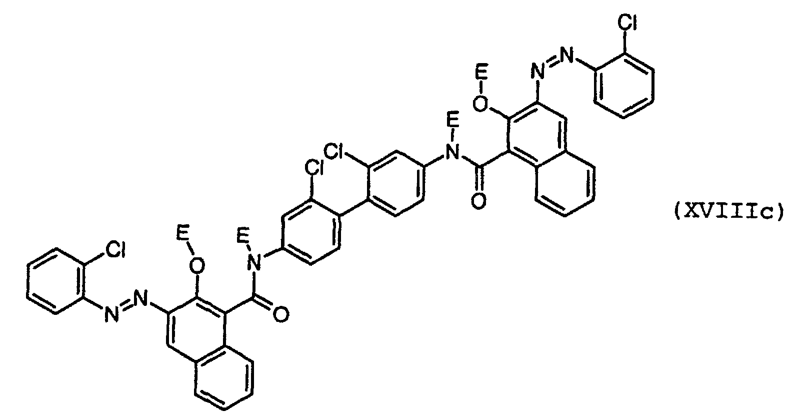 where in XVIIIb, if E is hydrogen, XVIIIb is the Colour Index pigment P.R. 144, P.R. 166, P.R. 214, P.R. 220, P.R. 221 or P.R. 242, and in XVIIIc, if E is hydrogen, XVIIIc is the Colour Index pigment P.O. 31,
R₃₇ and R₃₈ independently of one another are hydrogen, halogen, nitro, C₁-C₆alkoxy, C₁-C₆alkyl, trifluoromethyl, CONER₄₅ or SO₂NER₄₅, but at least on one occasion are CONER₄₅ or SO₂NER₄₅, and
R₃₉ and R₁₀₁ independently of one another are hydrogen, halogen, nitro, C₁-C₆alkoxy or C₁-C₆alkyl, R₄₀, R₄₁ and R₄₂ independently of one another are hydrogen, halogen, nitro, acetyl, C₁-C₆alkoxy, C₁-C₆alkyl, trifluoromethyl, CONER₄₅ or SO₂NER₄₅, but at least on one occasion are CONER₄₅ or SO₂NER₄₅, and
R₄₃ and R₄₄ independently of one another are hydrogen, halogen, C₁-C₆alkoxy or C₁-C₆alkyl, and
R₄₅ is hydrogen, halogen or C₁-C₄alkyl or is oxybisphenyl, biphenylyl, naphthyl or phenyl each of which is unsubstituted or substituted by 1 to 3, preferably 2, substituents, for example halogen, nitro, trifluoromethyl, C₁-C₄alkoxy or C₁-C₄alkyl, or E, preferably chlorine or methyl, R₉₅ is hydrogen or OCH₃,
R₉₆ and R₉₇ independently of one another are chlorine or methyl, and
R₉₈, R₉₉ or R₁₀₀ independently of one another are chlorine, methyl or COOCH₂CH₂Cl, COOCH(CH₃)₂, and also
anthraquinonoid compounds of the formula XIX, XIXa, XIXb, XIXc, XIXd or XX 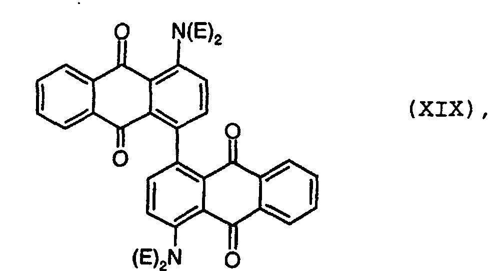 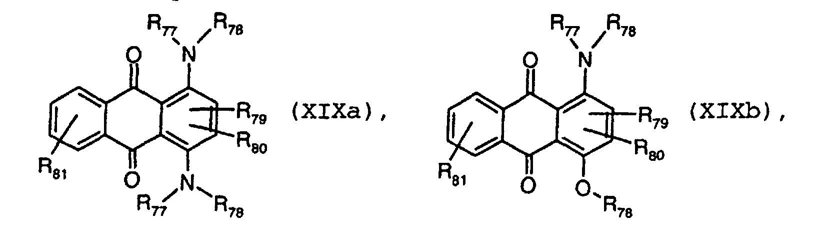 in which
R₇₇ and R₇₈ independently of one another are E, hydrogen or C₁-C₁₂alkyl or are C₆-C₁₂aryl which is unsubstituted or substituted by halogen, C₁-C₆alkyl, C₁-C₆alk-oxy, nitro, ace-tyl, SO₂NE-C₁-C₆alkyl or SO₂NH₂,
R₇₉ and R₈₀ independently of one another are hydrogen, halogen, C₁-C₆alkyl, C₁-C₆alkoxy, nitro, cyano, CONH₂, SO₂NEC₁-C₆alkyl, SO₂NH₂, SO₃H or SO₃Na or are C₆-C₁₂aryl which is unsubstituted or substituted by halogen, C₁-C₆alkyl, C₁-C₆alkoxy, nitro, acetyl, SO₂NEC₁-C₆alkyl or SO₂NH₂ , and
R₈₁ is hydrogen, halogen, nitro, cyano, hydroxyl or C₁-C₆alkoxy, or 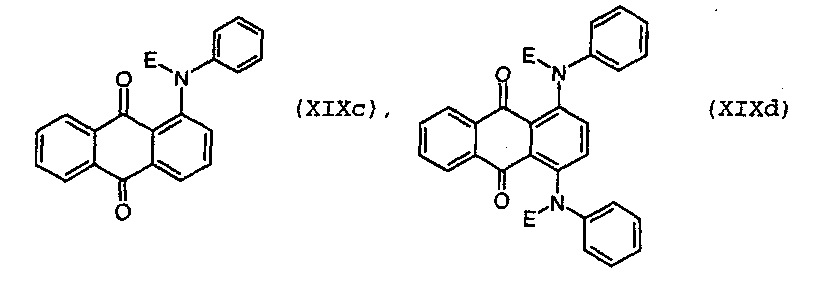 or 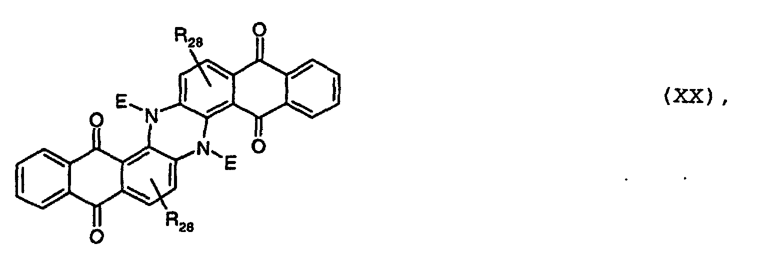 phthalocyanines of the formula XXI 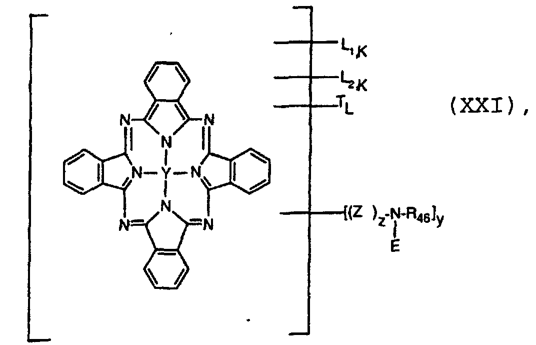 in which
Y is H₂, a divalent metal selected from the group Cu(II), Zn(II), Fe(II), Ni(II), Ru(II), Rh(II), Pd(II), Pt(II), Mn(II), Mg(II), Be(II), Ca(II), Ba(II), Cd(II), Hg(II), Sn(II), Co(II) or Pb(II), preferably Cu(II), Zn(II), Fe(II), Ni(II) or Pd(II), or a mono- or divalent oxo metal selected from the group V(O), Mn(O) or TiO,
Z is -CH(R₄₇)-, -CO- or -SO₂-,
R₄₆ is hydrogen, C₁-C₆alkyl, -N(E)R₄₇, -NECOR₄₈, -SO₂(NH)₂CO₂C(CH₃)₃, -COR₄₈ or 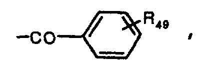 R₄₇ is hydrogen or C₁-C₆alkyl, R₄₈ is C₁-C₆alkyl and R₄₉ is hydrogen, halogen, C₁-C₆alkyl or C₁-C₆alkoxy, z is zero or 1, y is zero or is a number from 1 to 8, K is zero or 1, L is zero or a number from 1 to 16, where,
if y is a number from 1 to 4, K and L are zero, or, if K and L are a number from 1 to 16, y is zero, and
L₁ and L₂, each attached to one of the 8 nitrogen atoms forming the phthalocyanine complex and/or to one of the 8 carbon atoms forming the phthalocyanine complex, are independently of one another hydrogen, halogen, C₁-C₁₈alkoxy, C₁-C₁₈-alkylthio, C₁-C₁₈alkylamino, C₂-C₁₈dialkylamino, morpholine or unsubstituted or C₁-C₁₂alkyl-substituted piperidine, and also
T, for each T independently of the others, is halogen, C₁-C₁₈alkyl, C₁-C₁₈alkoxy, C₁-C₁₈alkylthio or C₂-C₁₈dialkylamino, and
pyrrolo[3,4-c]pyrroles of the formula XXIIa or XXIIb 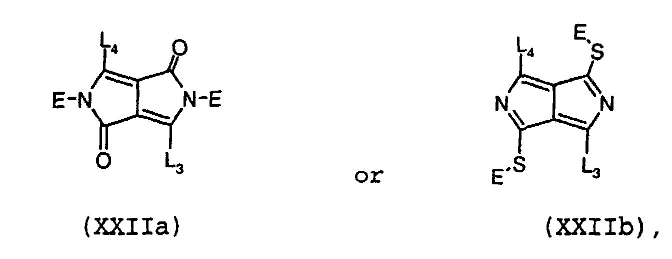 in which L₄ and L₃ independently of one another are a group of the formula 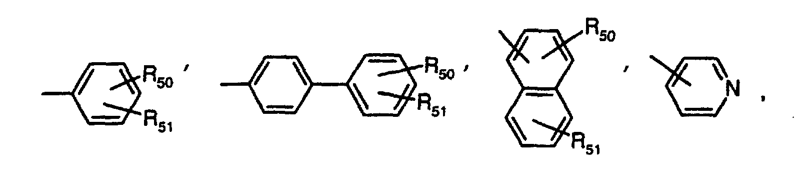 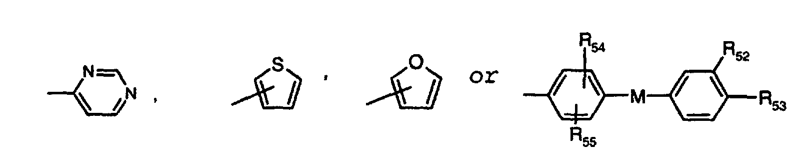 in which
R₅₀ and R₅₁ independently of one another are hydrogen, halogen, C₁-C₂₄alkyl, C₁-C₆alkoxy, C₁-C₁₈alkylmercapto, C₁-C₁₈alkylamino, carbamoyl, -CN, -NO₂, -phenyl, trifluoromethyl, C₅-C₆cycloalkyl, -C=N-(C₁-C₂₄alkyl), 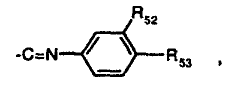 imidazolyl, pyrazolyl, triazolyl, piperazinyl, pyrrolyl, oxazolyl, benzoxazolyl, benzothiazolyl, benzimidazolyl, morpholinyl, piperidinyl or pyrrolidinyl,
M is -CH₂-, -CH(CH₃)-, -C(CH₃)₂-, -CH=N-, -N=N-, -O-, -S-, -SO-, -SO₂- or -NR₅₆-,
R₅₂ and R₅₃ independently of one another are hydrogen, halogen, C₁-C₆alkyl, C₁-C₆alkoxy or -CN, R₅₄ and R₅₅ independently of one another are hydrogen, halogen or C₁-C₆alkyl and R₅₆ is hydrogen or C₁-C₆alkyl,
where in the abovementioned formulae E is in each case hydrogen or B, with the proviso that E is B at least once in every formula, and B is as defined in claim 7.

9. A pigment dispersion obtained by a process according to one of claims 1 to 8.

10. A pigment dispersion comprising
(a) a polymer,
(b) an organic pigment in colloidal form, and
(c) a water-free solvent
or
(d) an aqueous solvent.

11. Compounds of the formulae 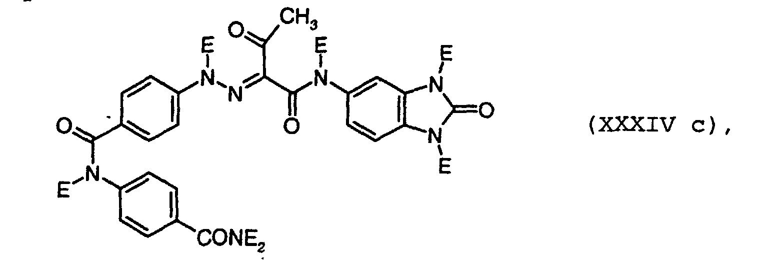 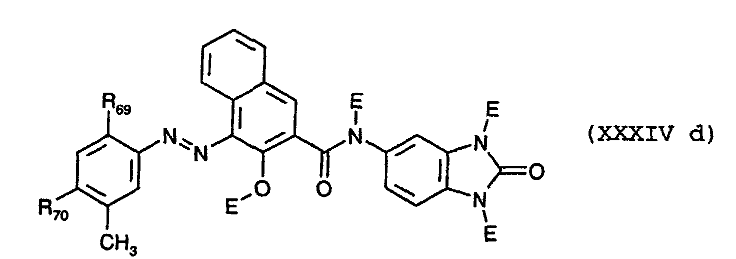 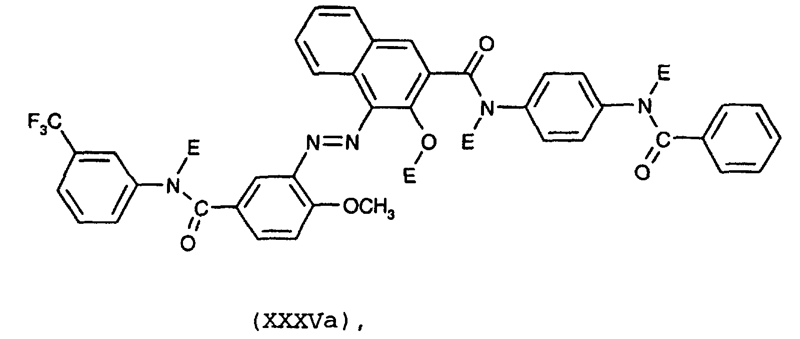 in which
R₆₉ is C₁-C₆alkoxy and
R₇₀ is CONHE, SO₂NMeE or SO₂NHE, especially SO₂NHE or SO₂NCH₃E, and E in the abovementioned formulae is in each case hydrogen or B, with the proviso that E is B at least once in every formula, and B is as defined in claim 7.

12. The use of a pigment dispersion according to one of claims 9 and 10, or of a compound according to claim 11, or of a pigmentary form obtainable from compounds according to claim 11, for dyeing or pigmenting high molecular mass material.

13. Compositions comprising high molecular mass material and a colouristically effective amount of a compound according to claim 11, or of the pigmentary form obtainable from compounds according to claim 11, or of a pigment dispersion according to one of claims 9 and 10.

14. The use of a compound according to claim 11, or of a pigmentary form obtainable from compounds according to claim 11, or of a pigment dispersion according to one of claims 9 and 10, or of a composition according to claim 13 for producing graphics inks or printing inks in printing processes, for flexographic printing, screen printing, packaging printing, security ink printing, gravure printing or offset printing, for pre-press stages and for textile printing, for office, home or graphics applications, for paper goods, for ballpoint pens, felt-tips, fiber-tips, paperboard, wood, (wood)stains, metal, inking pads or inks for impact printing processes (with impact-pressure ink ribbons)or for producing colourants for coating materials, for industrial or commercial use, for textile decoration and industrial marking, for roller coatings or powder coatings or for automotive finishes, for high-solids (low-solvent), water-containing or metallic coating materials or for water-containing formulations or aqueous paints, or for producing pigmented plastics for coatings, fibers, platters or mold carriers, or for non-impact-printing material, for digital printing, for the thermal wax transfer printing process, for the inkjet printing process or for the thermal transfer printing process, or for producing colour filters for liquid-crystal displays (LCDs) or charge combined devices (CCDs), or for cosmetics, or for toners, for dry copy toners or liquid copy toners or electrophotographic toners.

15. A process for producing colour filters comprising a transparent substrate and applied thereon one red, blue and green layer in any desired sequence, **characterized in that** the red, blue and green layers are each prepared using a correspondingly coloured pigment dispersion according to one of claims 9 and 10, or these layers comprise a correspondingly coloured pigment dispersion according to one of claims 9 and 10 or a compound according to claim 11, or a pigmentary form obtainable from a compound according to claim 11, or a composition according to claim 13.

16. Colour filters comprising a transparent substrate and applied thereon one red, blue and green layer each obtainable from a correspondingly coloured pigment dispersion according to one of claims 9 and 10, or comprising a compound according to claim 11, or the pigmentary form obtainable from a compound according to claim 11, or a composition according to claim 13.

## Revendications

1. Procédé pour la préparation de dispersions de pigment à partir d'un pigment, d'un polymère et d'un solvant, **caractérisées en ce que**
a1) on traite un mélange A, renfermant un pigment latent et un polymère, par voies thermique, chimique ou photolytique et
b) on ajoute ultérieurement un solvant,
ou
a2) on traite un mélange B, renfermant un pigment latent, un polymère et un solvant, par voies thermique, chimique ou photolytique.

2. Procédé selon la revendication 1, **caractérisé en ce qu'**on soumet le mélange A à un traitement thermique dans une extrudeuse.

3. Procédé pour la préparation de dispersions de pigments à partir d'un pigment et d'un polymère, **caractérisé en ce que**
c1) on prépare un mélange, renfermant un pigment latent, un polymère et un solvant,
c2) ensuite on élimine le solvant à partir du mélange ainsi obtenu, et
c3) ensuite on traite le mélange A dépourvu de solvant par voies thermique, chimique ou photolytique, et
c4) ensuite on ajoute un solvant au mélange traité.

4. Procédé pour la préparation de dispersions de pigment à partir d'un pigment et d'un polymère, **caractérisé en ce que**
d1) on prépare un mélange B, renfermant un pigment latent, un polymère et un solvant, et
d2) ensuite on élimine une partie du solvant à partir du mélange ainsi obtenu et
d3) ensuite on traite le mélange ainsi obtenu par voies thermique, chimique ou photolytique.

5. Procédé selon l'une des revendications 1 à 4, **caractérisé en ce que** les mélanges A ou B sont soumis à un traitement thermique dans un domaine de températures de 100 à 200°C pendant 1 heure à 36 heures.

6. Procédé selon l'une des revendications 1 à 5, **caractérisé en ce que**
a) on mélange le mélange traité par voies thermique, chimique ou photolytique avec un solvant organique, en particulier avec un solvant organique miscible à l'eau, et
b) ensuite on ajoute un solvant aqueux, renfermant une base, en particulier une base organique, dont le pH est ajusté à ≥7.

7. Procédé selon l'une des revendications 1 à 6, **caractérisé en ce qu'**on prépare des pigments latents de formule I
A(B)ₓ (I)
où
x va de 1 à 8, et
A représente le reste d'un chromophore de la série anthraquinone, azoïque, benzimidazolone, quinacridone, quinophtalone, dicétopyrrolopyrrole, dioxazine, indanthrone, indigo, isoindoline, isoindolinone, pérylène et phtalocyanine, qui est relié par l'intermédiaire d'un hétéroatome ou de plusieurs hétéroatomes à x groupes B, ces hétéroatomes sont pris dans le groupe comprenant des atomes de N, O ou S et forment une partie du reste A,
et
B représente un reste, pris dans le groupe comprenant les formules II-V 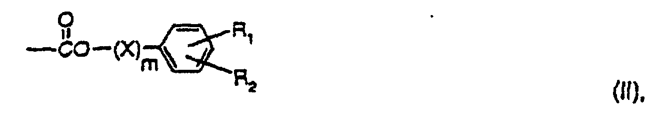 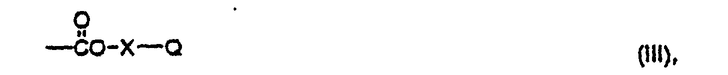 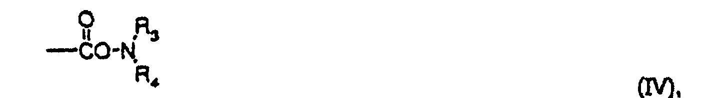 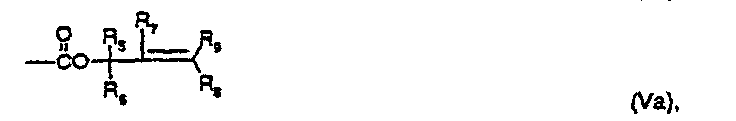 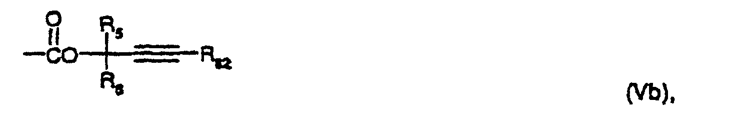 et un atome d'hydrogène, au moins un reste B ne représente pas un atome d'hydrogène,
dans les formules II, III, IV ou Va ou Vb
m vaut 0 ou 1,
X représente un groupe alkylène en C₁-C₆ ou alcénylène en C₂-C₅ non substitué ou substitué une ou plusieurs fois par un substituant alkyle en C₁-C₆ ou R₅ et R₆,
ou
R₁ et R₂ représentent, indépendamment l'un de l'autre, un atome d'hydrogène, des groupes alkyle en C₁-C₆, alkoxy en C₁-C₆, halogène, cyano, nitro, N(alkyle en C₁-C₆)₂, phényle non substitué ou substitué par des substituants halogène, cyano, nitro, alkyle en C₁-C₆ ou alkoxy en C₁-C₆, et
Q représente un atome d'hydrogène, des groupes alkyle en C₁-C₆, CN, CCl₃, un groupe 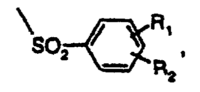 SO₂CH₃ ou SCH₃, et
R₃ et R₄ représentent, indépendamment l'un de l'autre, un atome d'hydrogène, un groupe alkyle en C₁-C₄ ou un groupe 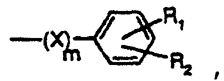
ou R₃ et R₄ forment conjointement un reste pipéridinyle, et
R₅ et R₆ représentent, indépendamment l'un de l'autre, un atome d'hydrogène, des groupes alkyle en C₁-C₂₄, cycloalcényle en C₄-C₁₂, cycloalkyle en C₄-C₁₂, alcynyle en C₃-C₂₄, alcényle en C₃-C₂₄, alkyle en C₁-C₂₄ interrompu par des atomes de O, S, ou interrompu par un atome de N disubstitué par un substituant alkyle en C₁-C₆, des groupes phényle ou biphényle non substitué ou substitué par des substituants alkyle en C₁-C₆, alkoxy en C₁-C₆, halogène, cyano ou nitro,
R₇, R₈ et R₉ représentent, indépendamment les uns des autres, un atome d'hydrogène, un groupe alkyle en C₁-C₂₄ ou alcényle en C₃-C₂₄,
R₈₂ représente un atome d'hydrogène, un groupe alkyle en C₁-C₆ ou un groupe de formule 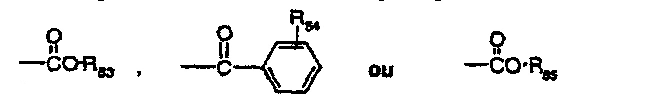
R₈₃ représente un groupe alkyle en C₁-C₆,
R₈₄ représente un atome d'hydrogène ou un groupe alkyle en C₁-C₆,
R₈₅ représente un atome d'hydrogène, un groupe alkyle en C₁-C₆, un groupe phényle non substitué ou substitué par un substituant alkyle en C₁-C₆, ou
B représente un groupe de formule 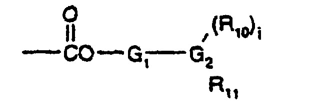 où
G₁ représente un groupe p,q-alkylène en C₂-C₁₂ non substitué ou substitué une ou plusieurs fois par des substituants alkyle en C₁-C₁₂, alkoxy en C₁-C₁₂, (alkyl en C₁-C₁₂)thio di(alkyl en C₂-C₂₄)-amino, p et q étant des indices de position différents,
G₂ représente un hétéroatome pris dans le groupe constitué par des atomes de N, O ou S, et
où
i, lorsque G₂ représente O ou S, vaut 0, et lorsque G₂ représente N, vaut 1, et
R₁₀ et R₁₁ représentent, indépendamment l'un de l'autre, des groupes alkyle en C₁-C₁₂ ou [-(p',q'-alkylène en C₂-C₁₂)-R₁₂-]ᵢᵢ-alkyle en C₁-C₁₂ non substitué ou substitué une ou plusieurs fois par des substituants alkoxy en C₁-C₁₂, (alkyl en C₁-C₁₂)thio, di(alkyl en C₂-C₂₄)amino, aryloxy en C₆-C₁₂, (aryl en C₆-C₁₂)thio, (alkylaryl en C₇-C₂₄)amino ou di(aryl en C₁₂-C₂₄)amino, où
ii va de 1 à 1000, p' et q' sont des indices de position différents,
R₁₂ représente indépendamment des autres un hétéroatome O, S ou un hétéroatome N substitué par un substituant alkyle en C₁-C₁₂, et les groupes alkylène en C₂-C₁₂ dans les unités récurrentes [alkylène en C₂-C₁₂-R₁₂] peuvent être identiques ou différents, et
R₁₀ et R₁₁ sont saturés ou insaturés 1 à 10 fois, non interrompus ou interrompus dans n'importe quelle position par 1 à 10 groupes pris dans le groupe comprenant -(C=O)- et -C₆H₄-, et qui ne portent aucun ou ou peuvent porter 1 à 10 autres substituants tels que halogène, cyano ou nitro, à condition que G₁ représente un groupe -(CH₂)ᵢᵥ-,
où
iv va de 2 à 12, et G₂ représente un atome de S, R₁₁ représente un groupe alkyle en C₁-C₄ non substitué, saturé et non interrompu.

8. Procédé selon l'une des revendications 1 à 7, **caractérisé en ce que** les pigments latents peuvent représenter les composés suivants :
des pérylènecarboximides de formules VIa ou VIb 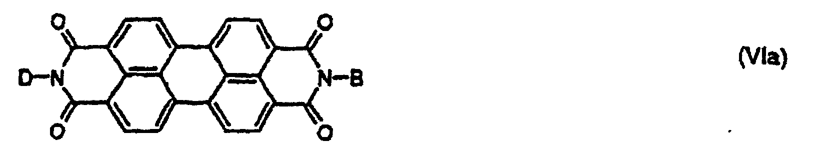 ou 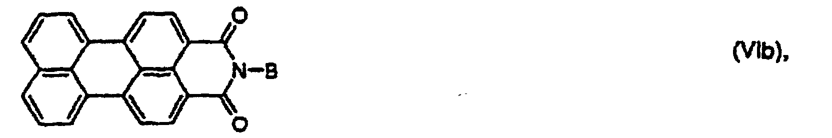 où D représente un atome d'hydrogène, un groupe alkyle en C₁-C₆, un groupe phényle, benzyle ou phénéthyle non substitué ou substitué par un substituant halogène ou alkyle en C₁-C₆, ou représente B
des quinacridones de formules VII ou VIIa 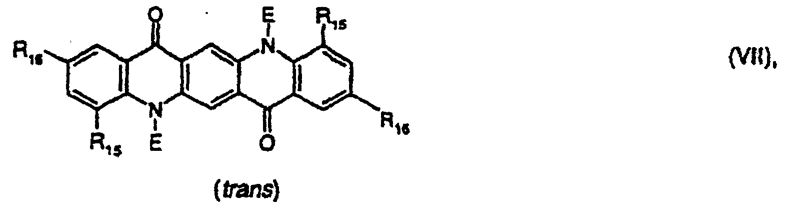 où R₁₅ et R₁₆ représentent, indépendamment l'un de l'autre un atome d'hydrogène, un atome d'halogène, des groupes alkyle en C₁-C₂₄, alkoxy en C₁-C₆ ou phényle, ou 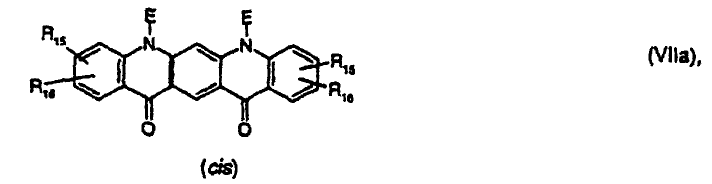 une dihydroquinacridone de formule VIIb 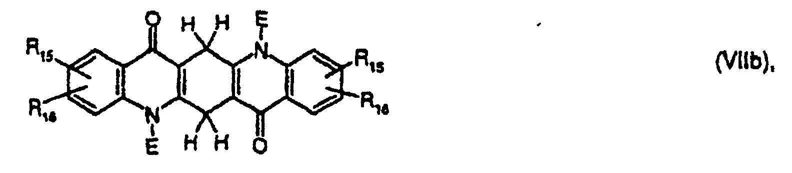 ou
une quinacridonequinone de formule VIIc 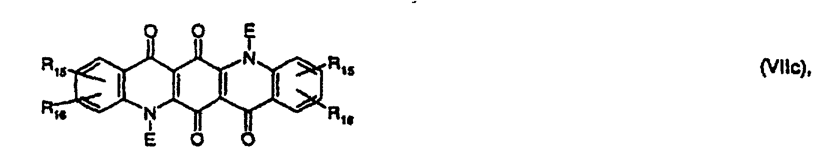 ou des pigments latents de chromophores polycycliques ayant une structure de base connue de formules VIId, VIIe ou VIIf 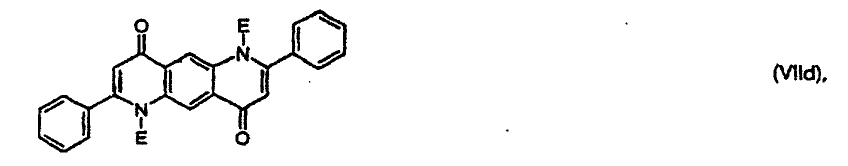 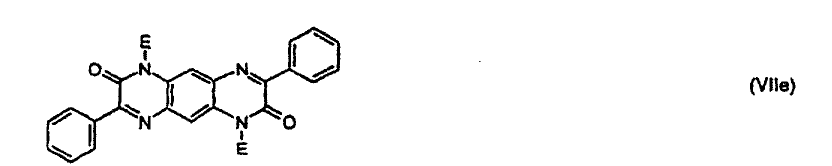 ou 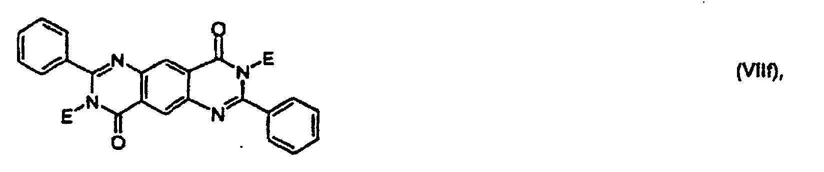 des quinophtalones de formules XL ou XLI 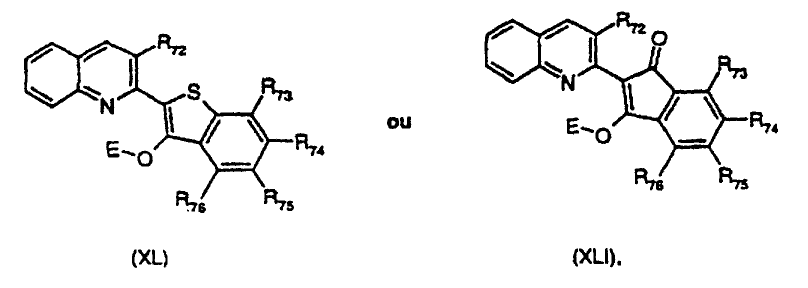 où
R₇₂ représente un atome d'hydrogène ou un groupe O-E,
R₇₃ à R₇₆ représentent, indépendamment l'un de l'autre, un atome d'hydrogène, un atome d'halogène, des groupes -COO-alkyle en C₁-C₅ ou -CONE-alkyle en C₁-C₆,
des dioxazines de formules VIII ou IX 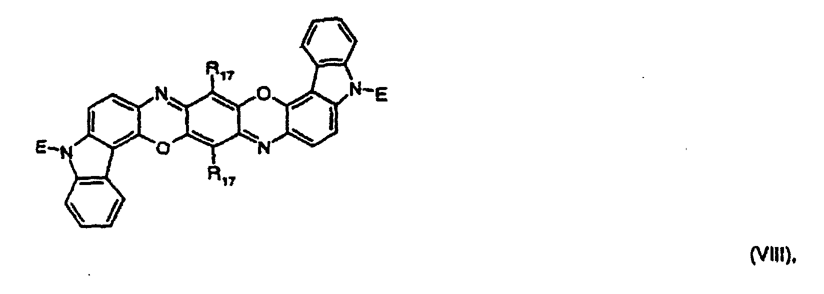 où R₁₇ représente un atome d'hydrogène, un atome d'halogène ou un groupe alkyle en C₁-C₂₄, 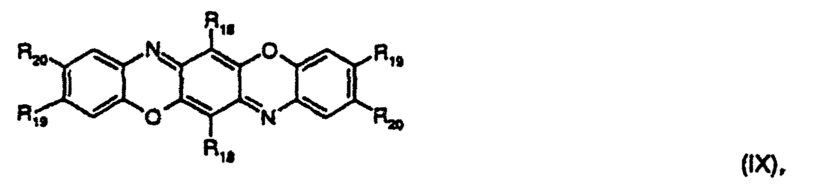 où
R₁₈, R₁₉ et R₂₀ représentent, indépendamment les uns des autres, un atome d'hydrogène, un atome d'halogène, des groupes alkyle en C₁-C₄, alkoxy en C₁-C₄, NECO-alkyle en C₁-C₄, NECO-phényle ou NH-E, au moins un des restes R₁₈, R₁₉ ou R₂₀ représente des groupes NECO-alkyle en C₁-C₄, NECO-phényle ou NH-E,
des isoindolines de formules X, XI ou XII 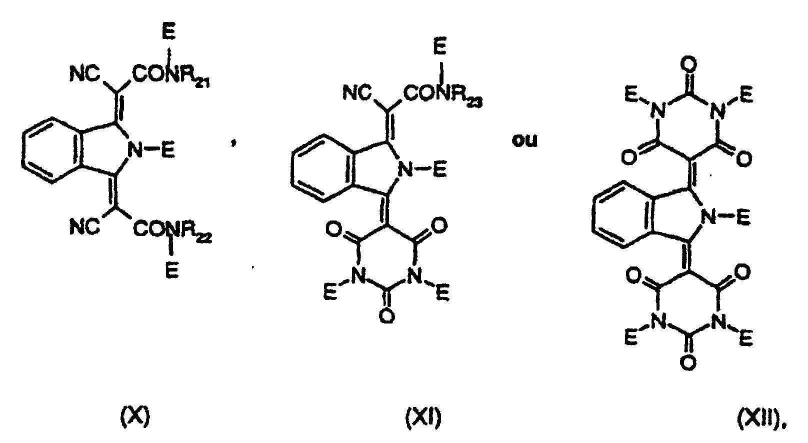 où R₂₁ représente un groupe 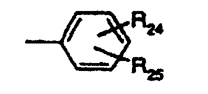
R₂₂ représente un atome d'hydrogène, des groupes alkyle en C₁-C₂₄, benzyle ou un groupe 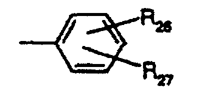
et
R₂₃ représente un atome d'hydrogène, E ou R₂₁,
R₂₄, R₂₅, R₂₆ et R₂₇ représentent, indépendamment les uns des autres, des atomes d'hydrogène, des groupes alkyle en C₁-C₂₄, alkoxy en C₁-C₆, halogène ou trifluorométhyle,
des isoindolinones de formules XIIIa, XIIIb ou XIIIc 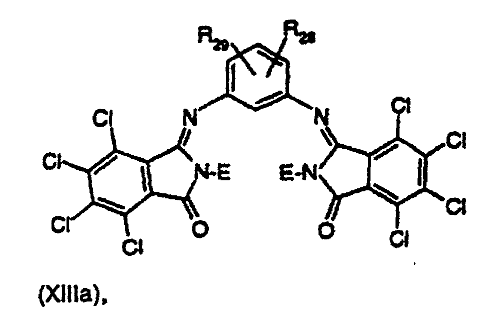 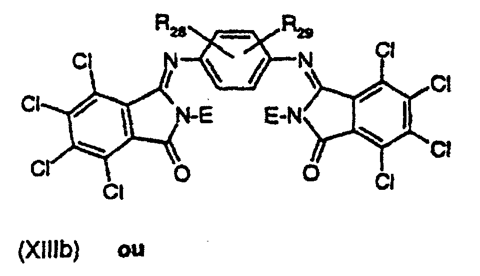 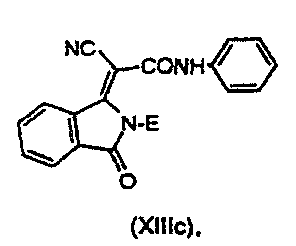 où
R₂₈ et R₂₉ représentent, indépendamment l'un de l'autre, un atome d'hydrogène, un atome d'halogène ou un groupe alkyle en C₁-C₆, ou
des composés benzimidazolone-azoïques de formules XIVa, XIVb ou XIVc 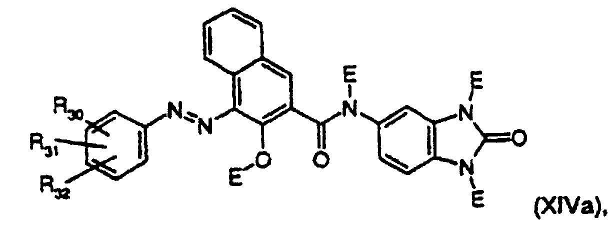 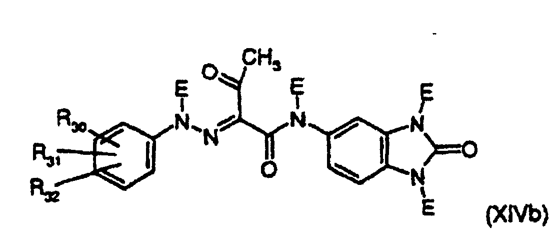 ou 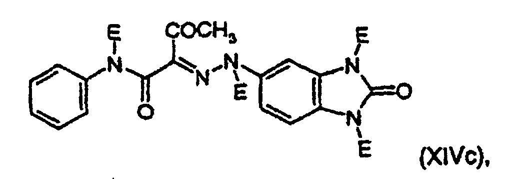 où
R₃₀, R₃₁ et R₃₂ représentent, indépendamment les uns des autres, un atome d'hydrogène, un atome d'halogène, des groupes alkoxy en C₁-C₆, alkyle en C₁-C₆, trifluorométhyle, nitro, acétyle, CONR₇R₃₃ ou SO₂NR₇R₃₃, et
R₃₃ représente un atome d'hydrogène, un atome d'halogène, un groupe alkyle en C₁-C₆ ou un groupe phényle non substitué ou substitué par un atome d'hydrogène ou une, deux ou trois fois par des substituants halogène, nitro, E, CONER₈₅, NECO-R₈₅, trifluorométhyle, alkoxy en C₁-C₆ ou alkyle en C₁-C₆,
des dérivés de l'indigo de formule XV 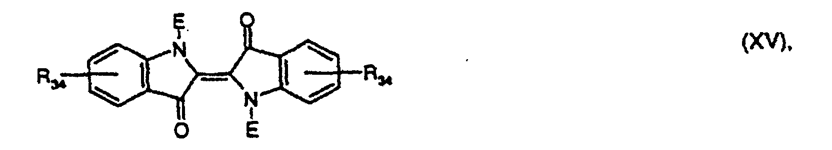 où
R₃₄ représente un atome d'hydrogène, des groupes CN, alkyle en C₁-C₆, alkoxy en C₁-C₆ ou halogène,
des composés mono-azoïques de formules XVIa, XVIb ou XVIc 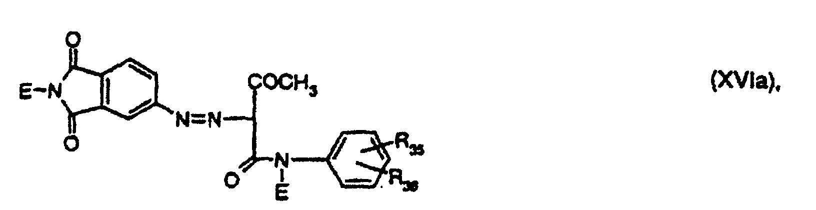 où
R₃₅ et R₃₆ représentent, indépendamment l'un de l'autre, un atome d'hydrogène, un atome d'halogène, des groupes alkyle en C₁-C₆, alkoxy en C₁-C₆, nitro, acétyle ou SO₂NE-alkyle en C₁-C₆, 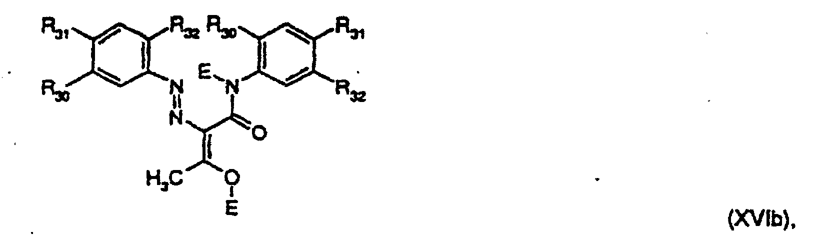 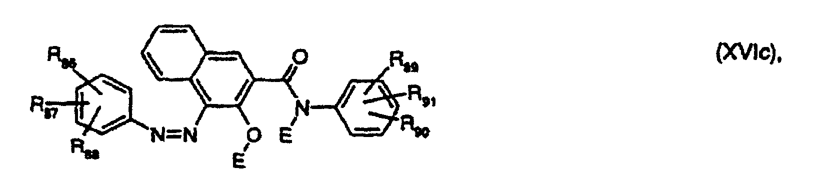
où
R₈₆ possède la même signification que R₃₀ ou représente un reste, phénoxy ou un groupe ester, COO-alkyle en C₁-C₆,
R₈₇ possède la même signification que R₃₁ ou représente un reste, NECO-phényle, NECO-alkyle en C₁-C₆ ou CONH₂,
R₈₈ possède les mêmes significations que R₃₂ ou R₃₃ ou représente un reste, de formule, SO₂O-aryle, SO₂O-aryl-NO₂, SO₂O-aryl-CO₂CH₃, SO₂CH₂-aryle, où
aryle représente, par exemple hétéroaryle ou par exemple phényle, phénanthryle ou naphtyle, ou
R₈₈ représente un groupe 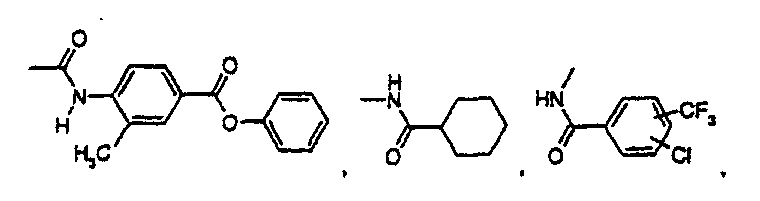 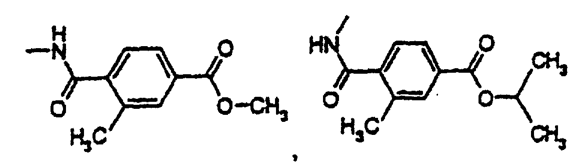 ou 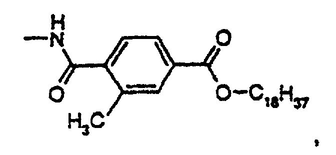 et
R₈₉ représente un atome d'hydrogène, groupes alkoxy en C₁-C₆, alkyle en C₁-C₆ ou 1-naphtyle,
R₉₀ représente un atome d'hydrogène, des groupes alkoxy en C₁-C₆, alkyle en C₁-C₆, halogène, NECO-alkyle en C₁-C₆ ou un groupe phénacyle non substitué ou substitué par des substituants alkyle en C₁-C₆, alkoxy en C₁-C₆, une, deux ou trois fois par un substituant halogène, en préférant en particulier la simple ou la double substitution par Cl, ainsi que 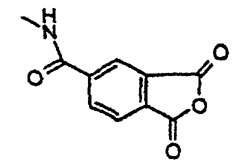
R₉₁ représente un atome d'hydrogène, un atome d'halogène, des groupes alkoxy en C₁-C₆, alkyle en C₁-C₆, NO₂, ou indépendamment l'un de l'autre, possèdent les mêmes significations que R₈₇ et R₈₈, ou
des composés mono-azoïques de formules XVId ou XVIe 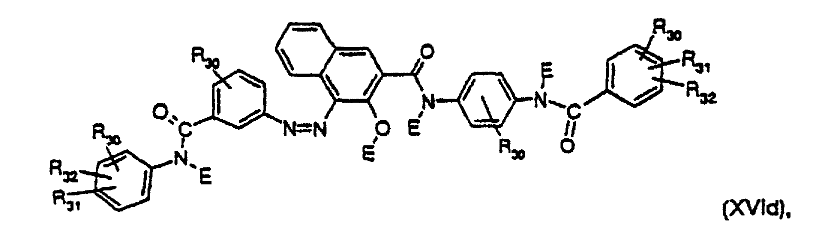 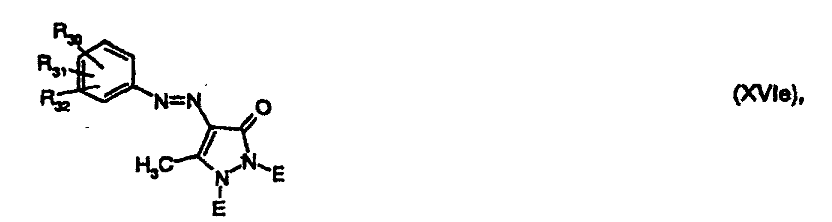 des composés bisazoïques de formules XVII, XVIII, XVIIIa, XVIIIb ou XVIIIc 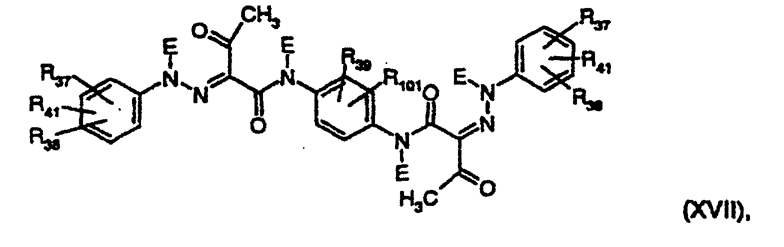 lorsque E représente un atome d'hydrogène, XVII, représente un pigment du Colour Index, P.Y. 93, P.Y. 94, P.Y. 95, P.Y. 128 ou P.Y. 166,
ou 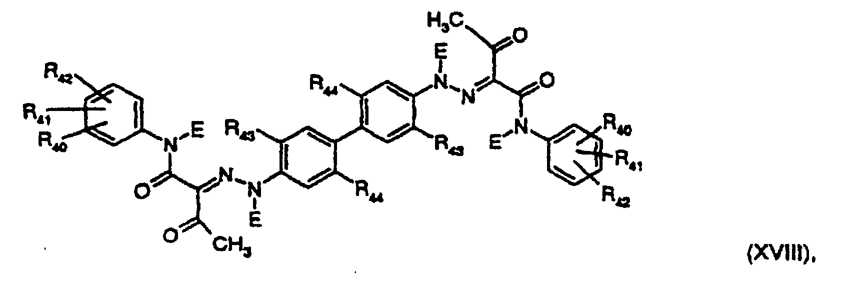 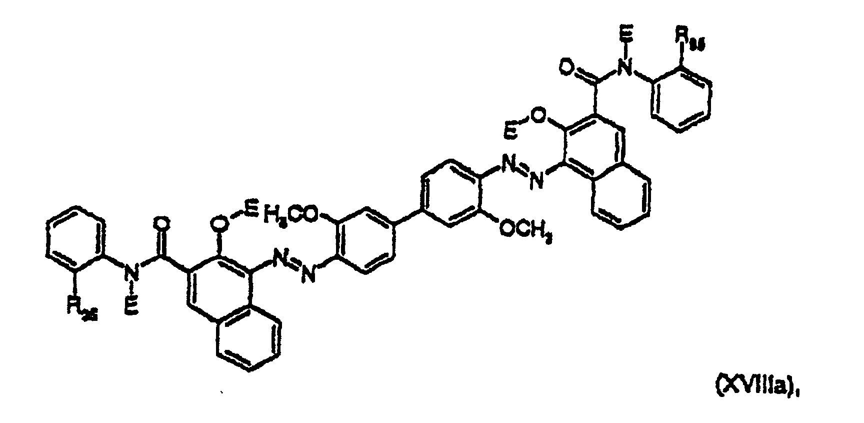 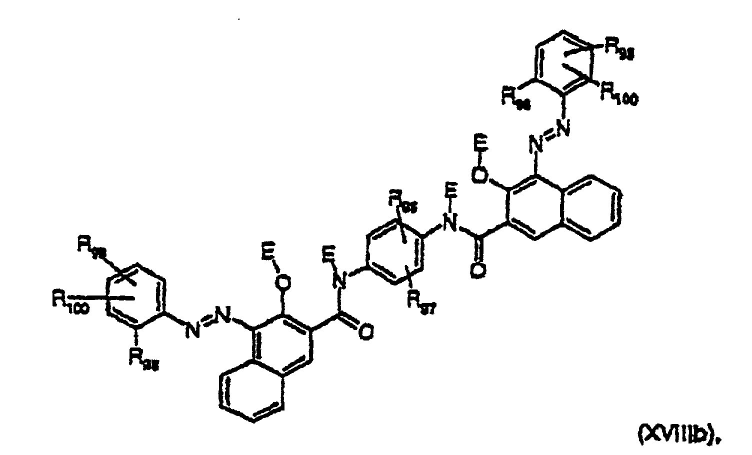 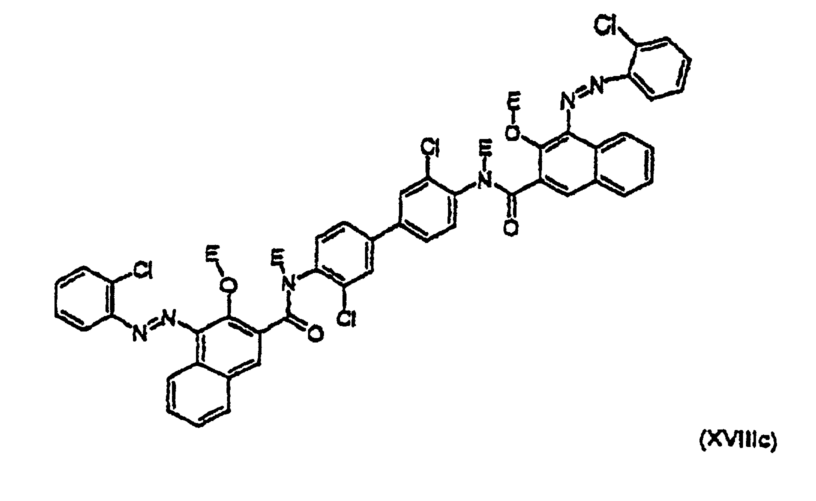 dans la formule XVIIIb, lorsque E représente un atome d'hydrogène, XVIIIb est un pigment du Colour Index P.R. 144, P.R. 166, P.R. 214, P.R. 220, P.R. 221 ou P.R. 242, et XVIIIc, lorsque E représente un atome d'hydrogène, XVIIIc est un Pigment du Colour Index P.O. 31,
R₃₇ et R₃₈ représentent, indépendamment l'un de l'autre, un atome d'hydrogène, un atome d'halogène, des groupes nitro, alkoxy en C₁-C₆, alkyle en C₁-C₆, trifluorométhyle, CONER₄₅ ou SO₂NER₄₅, cependant au moins une fois CONER₄₅ ou SO₂NER₄₅,
R₃₉ et R₁₀₁ représentent, indépendamment l'un de l'autre, un atome d'hydrogène, un atome d'halogène, des groupes alkoxy en C₁-C₆ ou alkyle en C₁-C₆,
R₄₀, R₄₁ et R₄₂ représentent, indépendamment l'un de l'autre, un atome d'hydrogène, un atome d'halogène, des groupes nitro, acétyle, alkoxy en C₁-C₆, alkyle en C₁-C₆, trifluorométhyle, CONER₄₅ ou SO₂NER₄₅, cependant au moins une fois CONER₄₅ ou SO₂NER₄₅,
R₄₃ et R₄₄ représentent, indépendamment l'un de l'autre, un atome d'hydrogène, un atome d'halogène, des groupes alkoxy en C₁-C₆ ou alkyle en C₁-C₆, et
R₄₅ représente un atome d'hydrogène, un atome d'halogène, un groupe alkyle en C₁-C₄ ou des groupes phényle, naphtyle, biphényle ou oxybisphényle non substitué ou substitué par 1 à 3, de préférence 2, substituants, comme par exemple halogène, nitro, trifluorométhyle, alkoxy en C₁-C₄ ou alkyle en C₁-C₄, E, de préférence chlore ou méthyle,
R₉₅ représente un atome d'hydrogène ou un groupe OCH₃,
R₉₆ et R₉₇ représentent, indépendamment l'un de l'autre, un atome de chlore ou un groupe méthyle, et
R₉₆, R₉₉ et R₁₀₀ représentent, indépendamment l'un de l'autre, un atome de chlore, des groupes méthyle ou COOCH₂CH₂Cl, COOCH(CH₃)₂, ainsi que
des composés anthraquinoïdes de formules XIX, XIXa, XIXb, XIXc, XIXd ou XX 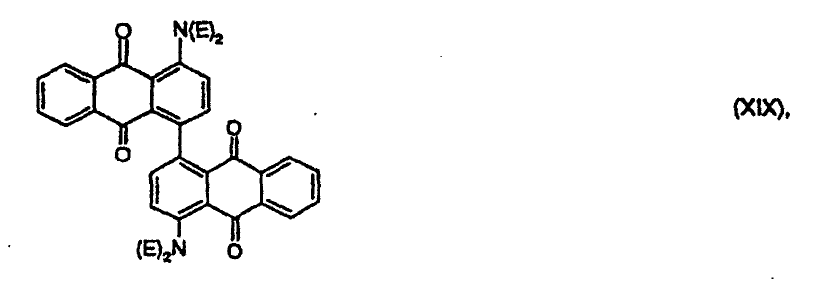 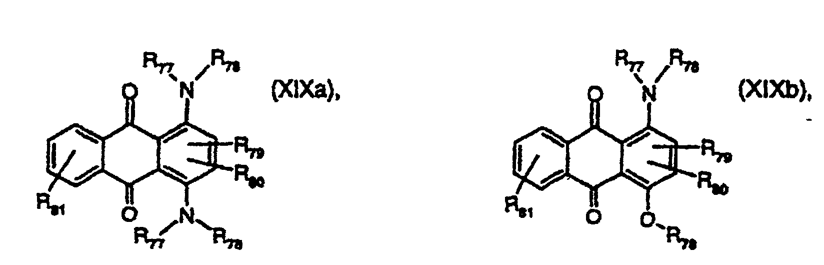 où
R₇₇ et R₇₈ représentent indépendamment l'un de l'autre, E, un atome d'hydrogène, un groupe alkyle en C₁-C₁₂ ou un groupe aryle en C₆-C₁₂ non substitué ou substitué par des substituants halogène, alkyle en C₁-C₆, alkoxy en C₁-C₆, nitro, acétyle, SO₂NEC-alkyle en C₁-C₆ ou SO₂NH₂,
R₇₉ et R₈₀ représentent, indépendamment l'un de l'autre, un atome d'hydrogène, un atome d'halogène, des groupes alkyle en C₁-C₆, alkoxy en C₁-C₆, nitro, cyano, CONH₂, SO₂NE-alkyle en C₁-C₆, SO₂NH₂, SO₃H, SO₃Na ou un groupe aryle en C₆-C₁₂ non substitué ou substitué par des substituants halogène, alkyle en C₁-C₆, alkoxy en C₁-C₆, nitro, acétyle, SO₂NE-alkyle en C₁-C₆ ou SO₂NH₂,
R₈₁ représente un atome d'hydrogène, un atome d'halogène, des groupes nitro, cyano, hydroxy ou alkoxy en C₁-C₆ ou 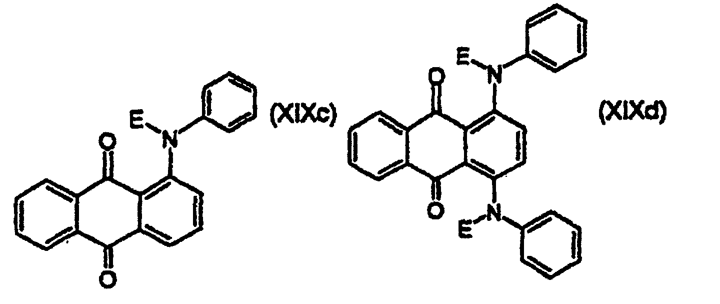 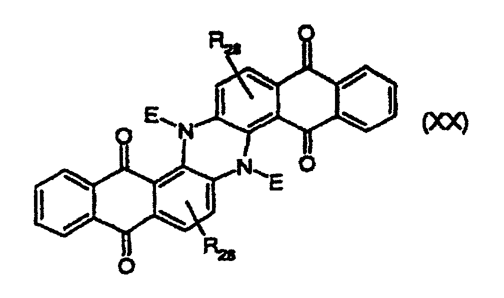
des phtalocyanines de formule XXI 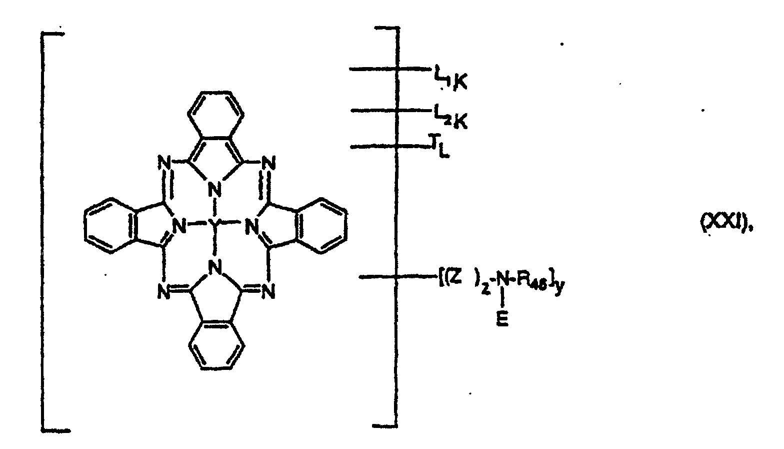
Y représente H₂, un métal bivalent pris dans le groupe comprenant Cu(II), Zn(II), Fe(II), Ni(II), Ru(II), Rh(II), Pd(II), Pt(II), Mn(II), Mg(II), Be(II), Ca(II), Ba(II), Cd(II), Hg(II), Sn(II), Co(II) ou Pb(II), de préférence Cu(II), Zn(II), Fe(II), Ni(II) ou Pd(II) ou un oxométal mono- ou bivalent pris dans le groupe comprenant V(O), Mn(O) ou TiO,
Z représente des groupes -CH(R₄₇)-, -CO- ou -SO₂-,
R₄₆ représente un atome d'hydrogène ou des groupes alkyle en C₁-C₆, -N(E)R₄₇, -NECOR₄₈, -SO₂(NH)₂CO₂C(CH₃)₃, -COR₄₈ ou 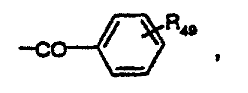
R₄₇ représente un atome d'hydrogène ou un groupe alkyle en C₁-C₆,
R₄₈ représente un groupe alkyle en C₁-C et
R₄₉ représente un atome d'hydrogène, un atome d'halogène, un groupe alkyle en C₁-C₆ ou alkoxy en C₁-C₆,
z vaut zéro ou 1,
y vaut zéro ou va de 1 à 8,
K vaut zéro ou 1,
L vaut zéro ou va de 1 à 16, où
lorsque y va de 1 à 4, K et L valent zéro, ou
lorsque K et L vont de 1 à 16, y vaut zéro, et
L₁ et L₂, chacun liés à un des 8 atomes d'azote formant le complexe de phtalocyanine et/ou à un des 8 atomes de carbone formant le complexe de phtalocyanine, représentent indépendamment l'un de l'autre, un atome d'hydrogène, un atome d'halogène, des groupes alkoxy en C₁-C₁₈, (alkyl en C₁-C₁₈)thio, (alkyl en C₁-C₁₈)amino, di(alkyl en C₂-C₁₈)amino, morpholino ou pipéridine non substituée ou substituée par un substituant alkyle en C₁-C₁₂, ainsi que
T représente, pour chaque T indépendamment l'un de l'autre, un atome d'halogène, des groupes alkyle en C₁-C₁₈, alkoxy en C₁-C₁₈, (alkyl en C₁-C₁₈)thio ou di(alkyl en C₂-C₁₈)amino, et
des pyrrolo[3,4-c]pyrroles de formules XXIIa ou XXIIb 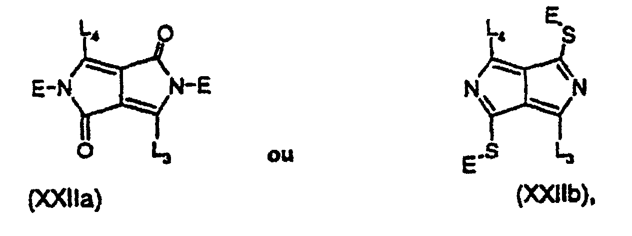 où
L₄ et L₅ représentent, indépendamment l'un de l'autre, un groupe de formules 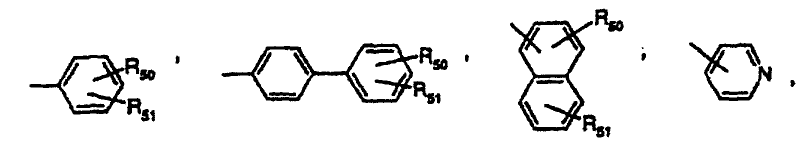 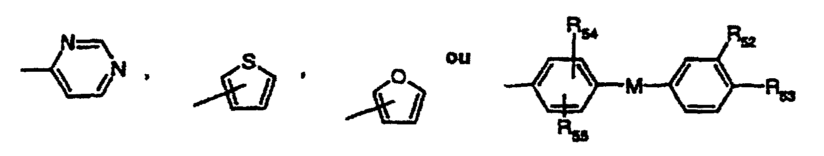
où
R₅₀ et R₅₁ représentent, indépendamment l'un de l'autre, un atome d'hydrogène, un atome d'halogène, des groupes alkyle en C₁-C₂₄, alkoxy en C₁-C₆, (alkyl en C₁-C₁₈)mercapto, (alkyl en C₁-C₁₈)amino, carbamoyle, -CN, -NO₂, -phényle, trifluorométhyle, cycloalkyle en C₅-C₆, -C=N-(alkyl en C₁-C₂₄), 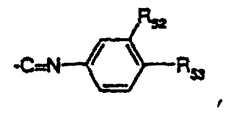 imidazolyle, pyrazolyle, triazolyle, pipérazinyle, pyrrolyle, oxazolyle, benzoxazolyle, benzthiazolyle, benzimidazoyle, morpholinyle, pipéridinyle ou pyrrolidinyle,
M représente des groupes -CH₂-, -CH(CH₃)-, -C(CH₃)₂-, -CH=N-, -N=N-, -O-, -S-, -SO-, -SO₂- ou -NR₅₆-,
R₅₂ et R₅₃ représentent, indépendamment l'un de l'autre, un atome d'hydrogène, un atome d'halogène, des groupes alkyle en C₁-C₆, alkoxy en C₁-C₆ ou CN,
R₅₄ et R₅₅ représentent, indépendamment l'un de l'autre, un atome d'hydrogène, un atome d'halogène ou un groupe alkyle en C₁-C₆, et
R₅₈ représente un atome d'hydrogène ou un groupe alkyle en C₁-C₆,
dans les formules citées ci-dessus, E représente chaque foisun atome d'hydrogène ou B, à condition que E soit dans chacune des formules au moins une fois B, et que B possède les significations à la revendication 7.

9. Dispersion de pigment obtenue à l'aide d'un procédé selon l'une des revendications 1 à 8.

10. Dispersion de pigment contenant
a) un polymère,
b) un pigment organique sous forme colloïdale et
c) un solvant non aqueux
ou
d) un solvant aqueux.

11. Composés de formules 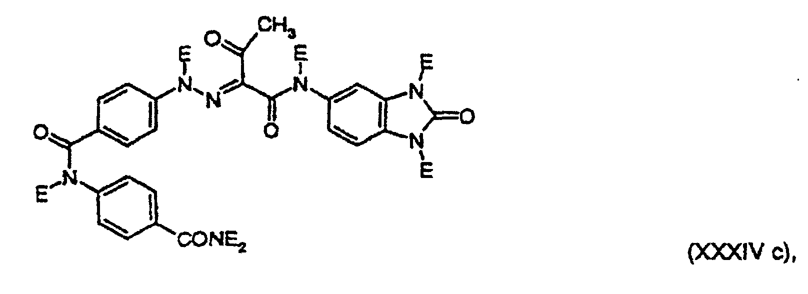 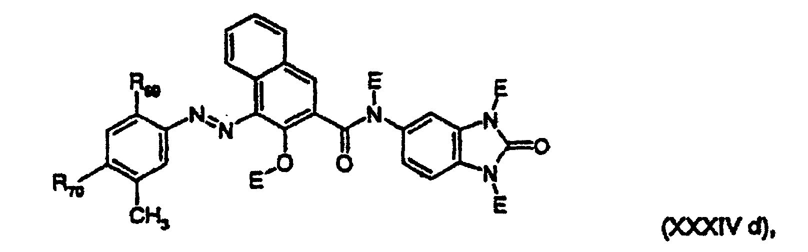 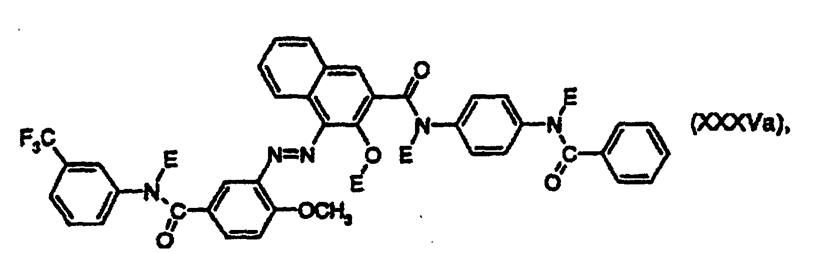
R₆₉ représente un groupe alkoxy en C₁-C₆, et
R₇₀ représente des groupes CONHE, SO₂NMeE ou SO₂NHE, en particulier SO₂NHE ou SO₂NCH₃E,
et E représente dans les formules ci-dessus chaque fois un atome d'hydrogène ou B, à condition que E dans chacune des formules soit au moins une fois B et que B possède la signification donnée à la revendication 7.

12. Utilisation d'une dispersion de pigment selon l'une des revendications 9 à 10 ou d'un composé selon la revendication 11 ou d'une forme pigmentaire que l'on peut obtenir à partir des composés selon la revendication 11, pour la teinture ou la pigmentation de matière de haut poids moléculaire.

13. Compositions contenant une matière de haut poids moléculaire et une quantité tinctoriale efficace d'un composé selon la revendication 11 ou de la forme pigmentaire que l'on peut obtenir à partir des composés selon la revendication 11 ou d'une dispersion de pigment selon l'une des revendication 9 à 10.

14. Utilisation d'un composé selon la revendication 11 ou de la forme pigmentaire que l'on peut obtenir à partir d'un composé selon la revendication 11 ou d'une dispersion de pigment selon l'une des revendications 9 à 10 ou d'une composition selon la revendication 13 pour la fabrication
d'encres ou d'encres d'impression dans des procédés d'impression tels que la flexographie, la sérigraphie, l'impression pour emballages, l'impression de sécurité en couleur, l'héliogravure ou l'impression en offset, pour l'impression préliminaire, ainsi que pour l'impression de matières textiles, pour les applications de bureau, de ménage ou graphiques, pour des articles de papeterie, des stylos-bille, stylos feutres, stylos à fibres, carton pâte, bois pâte, mordançage (de bois), métaux, tampons encreurs ou encres pour impression mécanique (avec des rubans en couleur d'impression mécanique) ou pour la fabrication
de colorants pour vernis, pour l'utilisation industrielle et professionnelle, pour la décoration de textile et le marquage industriel, pour vernis pour application par cylindre ou vernis en poudre ou pour vernis pour automobile "high-solid" (pauvres en solvant), aqueux ou métalliques ou pour formulations aqueuses, peintures à l'eau ou pour la préparation de pigmentation de matières synthétiques pour des revêtements, fibres, plaques ou formes, ou pour matériaux pour l'impression non mécanique (matériaux pour l'impression non mécanique), pour l'impression digitale, pour l'impression par transfert thermique à la cire, l'impression à jet d'encre ou pour le procédé par transfert d'impression thermique, ou pour la fabrication
de filtres colorés pour la fabrication d'afficheur à cristal liquide ("Liquid Crystal Display, LCD") ou "Charge Combined device (CCD)", ou pour la fabrication
de produits cosmétiques ou pour la fabrication
de toners pour copie sèche ainsi que pour copie en liquide ou des toners électro-photographiques.

15. Procédé pour la fabrication de filtres colorés contenant un substrat transparent ainsi qu'une couche rouge, bleue et verte déposée sur celui-ci dans un ordre quelconque, **caractérisé en ce qu'**on utilise pour la fabrication des couches rouge, bleue et verte chaque fois une dispersion de pigment colorée de façon correspondante selon l'une des revendications 9 à 10 ou ces couches contiennent une dispersion de pigment colorée de façon correspondante selon l'une des revendications 9 à 10 ou un composé selon la revendication 11 ou une forme pigmentaire que l'on peut obtenir à partir d'un composé selon la revendication 11 ou une composition selon la revendication 13.

16. Filtre coloré contenant un substrat transparent ainsi qu'une couche rouge, bleue et verte déposée sur celui-ci, chacune pouvant être obtenue à partir d'une dispersion de pigment colorée de façon correspondante selon l'une des revendications 9 à 10 ou contenant un composé selon la revendication 11 ou la forme pigmentaire que l'on peut obtenir à partir d'un composé selon la revendication 11 ou une composition selon la revendication 13.
